# EUROPEAN PATENT SPECIFICATION

(11) **EP 3 226 101 B1**
(45) Date of publication and mention of the grant of the patent: **06.05.2020**
(21) Application number: 17162151.9
(22) Date of filing: 21.03.2017
(51) Int. Cl.: G06F 1/16, H04M 1/02, G02F 1/1333

(54) **ELECTRONIC DEVICE INCLUDING DISPLAY AND CAMERA**
ELEKTRONISCHE VORRICHTUNG EINSCHLIESSLICH ANZEIGE UND KAMERA
DISPOSITIF ÉLECTRONIQUE COMPORTANT UN ÉCRAN D'AFFICHAGE ET UNE CAMÉRA

(30) Priority: 29.03.2016 KR 20160037967
(43) Date of publication of application: 04.10.2017
(73) Proprietor: Samsung Electronics Co., Ltd., Gyeonggi-do 16677 (KR)
(72) Inventor: Kwak, Wongeun, 16677 Gyeonggi-do (KR); Park, Jungsik, 16677 Gyeonggi-do (KR); Byeon, Hyungsup, 16677 Gyeonggi-do (KR); Yoon, Byounguk, 16677 Gyeonggi-do (KR); Hong, Hyunju, 16677 Gyeonggi-do (KR); Kim, Beomju, 16677 Gyeonggi-do (KR)
(74) Representative: Land, Addick Adrianus Gosling

(56) References cited:
- EP-A1- 2 284 646
- EP-A2- 2 448 243
- EP-A2- 2 733 581
- CN-A- 105 094 234
- CN-A- 105 226 201
- CN-U- 205 029 005
- US-A1- 2013 094 126
- US-A1- 2015 187 845
- US-A1- 2015 271 392

## Description

The present disclosure relates generally to an electronic device, and more particularly, to an electronic device that includes a display and a camera.

In conventional portable electronic devices, a display module performs an important function and as more functions are added to the display module its size is gradually increasing.

Further as an area occupied by the display of the portable electronic device has increased, so too has the display.

The display of portable electronic devices includes an active area that displays an image and an inactive area that is located at an edge portion of the active area, but which does not display the image.

At the active area of the display, a touchscreen panel that receives an input of a touch position of a user may be disposed, and at the inactive area thereof, a camera and a sensor may be disposed.

There may be a limitation in extension of the active area because of the inactive area of the display in which the camera and the sensor are disposed.

Examples of prior art electronic devices having displays with openings are known for instance from US 2013/0094126 A1, which discloses mounting an electronic component such as a camera in alignment with an opening in a display, and from EP 2448243 A2, which discloses accommodating a camera in an opening formed in the layers of the display and an insert. Other related prior art systems are disclosed in US 2015/0271392 A1 and US 2015/0187845 A1.

Aspects of the present disclosure have been made to address at least the above-mentioned problems and/or disadvantages and to provide at least the advantages described below.

In accordance with an aspect of the present disclosure, there is provided an electronic device according to the appended claims. All embodiments or parts which are not part of the appended claims are not part of the present invention.

### BRIEF DESCRIPTION OF THE DRAWINGS

The above and other aspects, features, and advantages of certain embodiments of the present disclosure will be more apparent from the following detailed description taken in conjunction with the accompanying drawings, in which:
FIG. 1 is a block diagram illustrating a network environment including an electronic device, according to an embodiment of the present disclosure;
FIG. 2 is a block diagram illustrating a configuration of an electronic device, according to an embodiment of the present disclosure;
FIG. 3 is a block diagram illustrating a configuration of a program module, according to an embodiment of the present disclosure;
FIG. 4 is a perspective view of an electronic device, according to an embodiment of the present disclosure;
FIGs. 5A and 5B are diagrams illustrating an active area of a display that is disposed at a front surface of an electronic device and an active area of a display that is disposed at a front surface and a side surface of an electronic device, according to an embodiment of the present disclosure;
FIG. 6A is a cross-sectional view illustrating an example of an electronic device, according to an embodiment of the present disclosure, and FIG. 6B is a cross-sectional view illustrating another example of an electronic device, according to an embodiment of the present disclosure;
FIG. 7A is a diagram illustrating various examples in which a camera hole and a sensor hole of an electronic device exist in an active area of a display, according to an embodiment of the present disclosure;
FIGs. 7B to 7B is diagram illustrating various examples representing whether a first adhesive layer of an electronic device exists, according to an embodiment of the present disclosure;
FIG. 8 is a diagram illustrating a conductive line of an electronic device, according to an embodiment of the present disclosure;
FIGs. 9A and 9B are diagrams illustrating a touchscreen panel formed at an upper portion of a display panel and an in-touchscreen panel formed at an upper portion of a display panel, according to an embodiment of the present disclosure;
FIG. 10A is a diagram illustrating an example of a display of an electronic device, according to an embodiment of the present disclosure;
FIG. 10B is a cross-sectional view illustrating another example of a display panel of an electronic device, according to an embodiment of the present disclosure;
FIG. 10C is a cross-sectional view illustrating an example of a display panel and a camera hole of an electronic device, according to an embodiment of the present disclosure;
FIG. 10D is a cross-sectional view illustrating another example of a display panel structure and a camera hole of an electronic device, according to an embodiment of the present disclosure;
FIG. 11 is a diagram illustrating a method of forming an opening by punching a display panel, according to an embodiment of the present disclosure;
FIG. 12 is a cross-sectional view illustrating another example of an electronic device, according to an embodiment of the present disclosure;
FIG. 13 is a diagram illustrating another example of an electronic device, according to an embodiment of the present disclosure;
FIGs. 14 and 15 are cross-sectional views illustrating another example of an electronic device, according to an embodiment of the present disclosure;
FIG. 16 is a diagram illustrating a disposition structure of a conductive line of an electronic device, according to an embodiment of the present disclosure;
FIG. 17 is a diagram illustrating a disposition structure of a power drive of an electronic device, according to an embodiment of the present disclosure;
FIG. 18 is a cross-sectional view illustrating another example of an electronic device, according to an embodiment of the present disclosure;
FIG. 19 is a diagram illustrating an example in which a device is mounted at a corner portion of an electronic device, according to an embodiment of the present disclosure;
FIGs. 20A and 20B are diagrams illustrating an example in which a device is mounted at a corner portion of an electronic device and an example in which a display is bent and disposed at a side surface of the electronic device, according to an embodiment of the present disclosure;
FIG. 21 is a diagram illustrating an example in which a camera device is mounted at an opening formed in a central portion of an electronic device, according to an embodiment of the present disclosure;
FIG. 22 is a diagram illustrating a mounting structure of a camera device of an electronic device, according to an embodiment of the present disclosure;
FIG. 23 is a diagram illustrating a state in which a groove is formed by removing a portion of a transparent layer in an electronic device, according to an embodiment of the present disclosure;
FIG. 24 is a diagram illustrating various examples in which a groove is formed by removing a portion of a transparent layer in an electronic device, according to an embodiment of the present disclosure;
FIG. 25 is a diagram illustrating various examples in which a fingerprint sensor is disposed at the inside of an electronic device, according to an embodiment of the present disclosure;
FIG. 26 is a diagram illustrating examples in which a haptic element is disposed at the inside of an electronic device, according to an embodiment of the present disclosure;
FIG. 27 is a diagram illustrating various examples in which a haptic element is disposed at the inside of an electronic device according to an embodiment of the present disclosure;
FIGs. 28 to 30 are diagrams illustrating various examples of securing a mounting space of an electronic device, according to an embodiment of the present disclosure;
FIGs. 31A to 31I are diagrams illustrating an electronic device, according to an embodiment of the present disclosure;
FIG. 32A is a front view illustrating an electronic device, according to an embodiment of the present disclosure, and FIGs. 32B and 32C are cross-sectional views illustrating the electronic device taken along line VI-VI' of FIG. 32A;
FIG. 33A is a front view illustrating an electronic device, according to an embodiment of the present disclosure, and FIGs. 33B and 33C are cross-sectional views illustrating the electronic device taken along line VII-VII' of FIG. 33A;
FIG. 34 is a front view illustrating an electronic device, according to an embodiment of the present disclosure and FIGs. 34B-34C are diagrams illustrating an antenna disposed on a display, according to an embodiment of the present disclosure;
FIG. 35A is a front view illustrating an electronic device, according to an embodiment of the present disclosure, and FIG. 35B is a cross-sectional view illustrating the electronic device taken along line VIII-VIII' of FIG. 35A;
FIG. 36A is a front view illustrating an electronic device, according to an embodiment of the present disclosure, and FIGs. 36B to 36G are cross-sectional views illustrating the electronic device taken along line IX-IX' of FIG. 36A;
FIGS. 37A to 37I are diagrams illustrating an electronic device, according to an embodiment of the present disclosure;
FIG. 38A is a front view illustrating an electronic device, according to an embodiment of the present disclosure, FIG. 38B is a cross-sectional view illustrating the electronic device taken along line i-i' of FIG. 38A, and FIG. 38C is a cross-sectional view illustrating the electronic device taken along line ii - ii ' of FIG. 38A;
FIG. 39A is a front view illustrating an electronic device, according to an embodiment of the present disclosure, and FIGs. 39B-39D are cross-sectional views illustrating the electronic device taken along line iii-iii' of FIG. 39A;
FIG. 40A is a front view illustrating an electronic device, according to an embodiment of the present disclosure, and FIG. 40B is a perspective view illustrating an electronic device, according to an embodiment of the present disclosure;
FIG. 41A is a cross-sectional view illustrating an electronic device, according to an embodiment of the present disclosure, FIG. 41B is a perspective view illustrating an electronic device, according to an embodiment of the present disclosure, and FIG. 41C is a cross-sectional view illustrating an electronic device, according to an embodiment of the present disclosure;
FIGs. 42A and 42B are cross-sectional views illustrating an electronic device, according to an embodiment of the present disclosure;
FIGs. 43A to 43C are enlarged views illustrating a portion B of FIG. 40B; and
FIGs. 44A to 44D are enlarged views illustrating a portion C of FIG. 40B.

### DETAILED DESCRIPTION

Embodiments of the present disclosure will be described herein below with reference to the accompanying drawings.

The terms "have," "may have," "include," and "may include" as used herein indicate the presence of corresponding features (for example, elements such as numerical values, functions, operations, or parts), and do not preclude the presence of additional features.

The terms "A or B," "at least one of A or/and B," or "one or more of A or/and B" as used herein include all possible combinations of items enumerated with them. For example, "A or B," "at least one of A and B," or "at least one of A or B" means (1) including at least one A, (2) including at least one B, or (3) including both at least one A and at least one B.

The terms such as "first" and "second" as used herein may modify various elements regardless of an order and/or importance of the corresponding elements, and do not limit the corresponding elements. These terms may be used for the purpose of distinguishing one element from another element. For example, a first user device and a second user device may indicate different user devices regardless of the order or importance. For example, a first element may be referred to as a second element without departing from the scope the present invention, and similarly, a second element may be referred to as a first element.

It will be understood that, when an element (for example, a first element) is "(operatively or communicatively) coupled with/to" or "connected to" another element (for example, a second element), the element may be directly coupled with/to another element, and there may be an intervening element (for example, a third element) between the element and another element. To the contrary, it will be understood that, when an element (for example, a first element) is "directly coupled with/to" or "directly connected to" another element (for example, a second element), there is no intervening element (for example, a third element) between the element and another element.

The expression "configured to (or set to)" as used herein may be used interchangeably with "suitable for," "having the capacity to," "designed to," " adapted to," "made to," or "capable of' according to a context. The term "configured to (set to)" does not necessarily mean "specifically designed to" in a hardware level. Instead, the expression "apparatus configured to..." may mean that the apparatus is "capable of..." along with other devices or parts in a certain context. For example, "a processor configured to (set to) perform A, B, and C" may mean a dedicated processor (e.g., an embedded processor) for performing a corresponding operation, or a generic-purpose processor (e.g., a CPU or an application processor) capable of performing a corresponding operation by executing one or more software programs stored in a memory device.

The term "module" as used herein may be defined as, for example, a unit including one of hardware, software, and firmware or two or more combinations thereof. The term "module" may be interchangeably used with, for example, the terms "unit", "logic", "logical block", "component", or "circuit", and the like. The "module" may be a minimum unit of an integrated component or a part thereof. The "module" may be a minimum unit performing one or more functions or a part thereof. The "module" may be mechanically or electronically implemented. For example, the "module" may include at least one of an application-specific integrated circuit (ASIC) chip, field-programmable gate arrays (FPGAs), or a programmable-logic device, which is well known or will be developed in the future, for performing certain operations.

The terms used in describing the various embodiments of the present disclosure are for the purpose of describing particular embodiments and are not intended to limit the present disclosure. As used herein, the singular forms are intended to include the plural forms as well, unless the context clearly indicates otherwise. All of the terms used herein including technical or scientific terms have the same meanings as those generally understood by an ordinary skilled person in the related art unless they are defined otherwise. The terms defined in a generally used dictionary should be interpreted as having the same or similar meanings as the contextual meanings of the relevant technology and should not be interpreted as having ideal or exaggerated meanings unless they are clearly defined herein. According to circumstances, even the terms defined in this disclosure should not be interpreted as excluding the embodiments of the present disclosure.

Electronic devices according to the embodiments of the present disclosure may include at least one of, for example, smart phones, tablet personal computers (PCs), mobile phones, video telephones, electronic book readers, desktop PCs, laptop PCs, netbook computers, workstations, servers, personal digital assistants (PDAs), portable multimedia players (PMPs), Motion Picture Experts Group (MPEG-1 or MPEG-2) Audio Layer 3 (MP3) players, mobile medical devices, cameras, or wearable devices. According to an embodiment of the present disclosure, the wearable devices may include at least one of accessory-type wearable devices (e.g., watches, rings, bracelets, anklets, necklaces, glasses, contact lenses, or head-mounted-devices (HMDs)), fabric or clothing integral wearable devices (e.g., electronic clothes), body-mounted wearable devices (e.g., skin pads or tattoos), or implantable wearable devices (e.g., implantable circuits).

The electronic devices may be smart home appliances. The smart home appliances may include at least one of, for example, televisions (TVs), digital versatile disk (DVD) players, audios, refrigerators, air conditioners, cleaners, ovens, microwave ovens, washing machines, air cleaners, set-top boxes, home automation control panels, security control panels, TV boxes (e.g., Samsung HomeSync™, Apple TV™, or Google TV™), game consoles (e.g., Xbox and PlayStation™), electronic dictionaries, electronic keys, camcorders, or electronic picture frames.

The electronic devices may include at least one of various medical devices (e.g., various portable medical measurement devices (such as blood glucose meters, heart rate monitors, blood pressure monitors, or thermometers, and the like), a magnetic resonance angiography (MRA) device, a magnetic resonance imaging (MRI) device, a computed tomography (CT) device, scanners, or ultrasonic devices, and the like), navigation devices, global positioning system (GPS) receivers, event data recorders (EDRs), flight data recorders (FDRs), vehicle infotainment devices, electronic equipment for vessels (e.g., navigation systems, gyrocompasses, and the like), avionics, security devices, head units for vehicles, industrial or home robots, automatic teller machines (ATMs), points of sales (POSs) devices, or Internet of Things (IoT) devices (e.g., light bulbs, various sensors, electric or gas meters, sprinkler devices, fire alarms, thermostats, street lamps, toasters, exercise equipment, hot water tanks, heaters, boilers, and the like).

The electronic devices may further include at least one of parts of furniture or buildings/structures, electronic boards, electronic signature receiving devices, projectors, or various measuring instruments (such as water meters, electricity meters, gas meters, or wave meters, and the like). The electronic devices may be one or more combinations of the above-mentioned devices. The electronic devices may be flexible electronic devices. Also, the electronic devices are not limited to the above-mentioned devices, and may include new electronic devices according to the development of new technologies.

Hereinafter, the electronic devices according to various embodiments of the present disclosure will be described with reference to the accompanying drawings. The term "user" as used herein may refer to a person who uses an electronic device or may refer to a device (e.g., an artificial intelligence electronic device) which uses an electronic device.

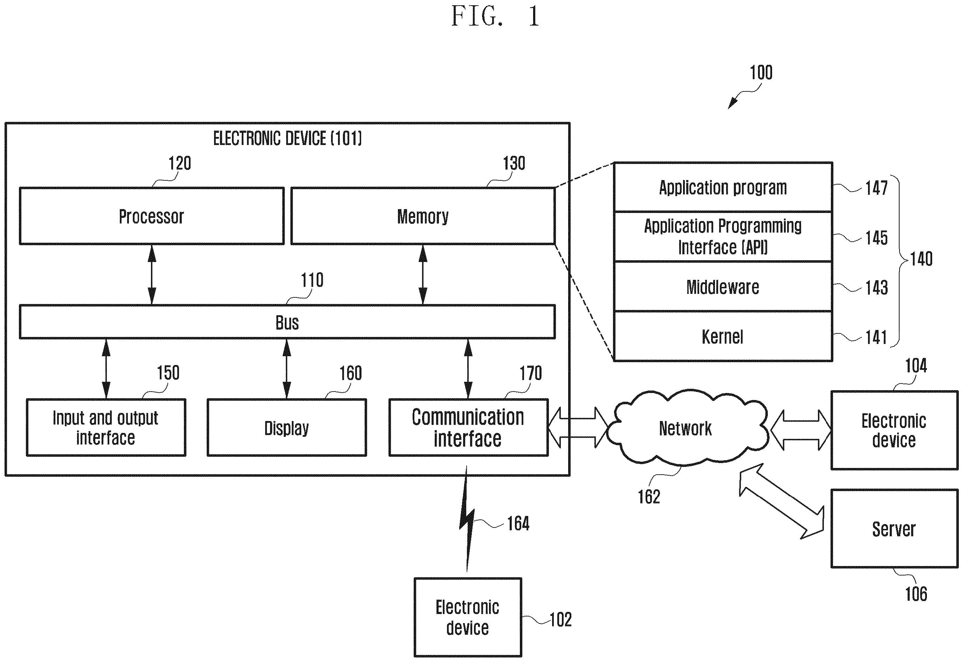

FIG. 1 illustrates a network environment including an electronic device, according to an embodiment of the present disclosure.

Referring to FIG. 1, a network environment 100 includes an electronic device 101 having a bus 110, a processor 120, a memory 130, an input/output interface 150, a display 160, and a communication interface 170. At least one of the above described components may be omitted from the electronic device 101 or another component may be further included in the electronic device 101.

The bus 110 may be a circuit connecting the above described components 120, 130, and 150-170 and transmitting communications (e.g., control messages and/or data) between the above described components.

The processor 120 may include one or more of central processing units (CPUs), an application processor (AP), and a communication processor (CP). The processor 120 is capable of controlling at least one of other components of the electronic device 101 and/or processing data or operations related to communication.

The memory 130 may include volatile memory and/or non-volatile memory. The memory 130 is capable of storing data or commands related to at least one of other components of the electronic device 101. The memory 130 is capable of storing software and/or a program module 140. For example, the program 140 may include a kernel 141, middleware 143, an application programming interface (API) 145, application programs (or applications) 147, etc. The kernel 141, the middleware 143 or at least part of the API 145 may be called an operating system (OS).

The kernel 141 is capable of controlling or managing system resources (e.g., the bus 110, the processor 120, the memory 130, etc.) used to execute operations or functions of other programs (e.g., the middleware 143, the API 145, and the applications 147). The kernel 141 provides an interface capable of allowing the middleware 143, the API 145, and the applications 147 to access and control/manage the individual components of the electronic device 101.

The middleware 143 may be an interface between the API 145 or the applications 147 and the kernel 141 so that the API 145 or the applications 147 can communicate with the kernel 141 and exchange data therewith. The middleware 143 is capable of processing one or more task requests received from the applications 147 according to the priority. For example, the middleware 143 is capable of assigning a priority for use of system resources of the electronic device 101 (e.g., the bus 110, the processor 120, the memory 130, etc.) to at least one of the applications 147. For example, the middleware 143 processes one or more task requests according to a priority assigned to at least one application program, thereby performing scheduling or load balancing for the task requests.

The API 145 may be an interface that is configured to allow the applications 147 to control functions provided by the kernel 141 or the middleware 143. The API 145 may include at least one interface or function (e.g., instructions) for file control, window control, image process, text control, or the like.

The input/output interface 150 is capable of transferring instructions or data, received from the user or external devices, to one or more components of the electronic device 101. The input/output interface 150 is capable of outputting instructions or data, received from one or more components of the electronic device 101, to the user or external devices.

The display 160 may include a liquid crystal display (LCD), a flexible display, a transparent display, a light emitting diode (LED) display, an organic LED (OLED) display, micro-electro-mechanical systems (MEMS) display, an electronic paper display, etc. The display 160 is capable of displaying various types of content (e.g., texts, images, videos, icons, symbols, etc.). The display 160 may also be implemented with a touch screen. In this case, the display 160 is capable of receiving touches, gestures, proximity inputs or hovering inputs, via a stylus pen, or a user's body.

The communication interface 170 is capable of establishing communication between the electronic device 101 and an external device For example, the communication interface 170 is capable of communicating with an external device connected to a network 162 via wired or wireless communication.

Wireless communication may employ, as cellular communication protocol, at least one of long-term evolution (LTE), LTE advance (LTE-A), code division multiple access (CDMA), wideband CDMA (WCDMA), universal mobile telecommunications system (UMTS), wireless broadband (WiBro), and global system for mobile communication (GSM). Wireless communication may also include short-wireless communication 164. Short-wireless communication 164 may include at least one of wireless fidelity (Wi-Fi), bluetooth (BT), near field communication (NFC), magnetic secure transmission (MST), and global navigation satellite system (GNSS). The GNSS may include at least one of GPS, global navigation satellite system (Glonass), Beidou NSS (Beidou), and Galileo, the European global satellite-based navigation system, according to GNSS using areas, bandwidths, etc. In the present disclosure, "GPS" and "GNSS" may be used interchangeably. Wired communication may include at least one of universal serial bus (USB), high definition multimedia interface (HDMI), recommended standard 232 (RS-232), and plain old telephone service (POTS). The network 162 may include at least one of the following: a telecommunications network, e.g., a computer network (e.g., local area network (LAN) or wide area network (WAN)), the Internet, and a telephone network.

A first external electronic device 102 and a second external electronic device 104 are each identical to or different from the electronic device 101, in terms of type. A server 106 is capable of including a group of one or more servers. Part or all of the operations executed on the electronic device 101 may be executed on another electronic device or a plurality of other electronic devices (e.g., electronic devices 102 and 104 or the server 106). When the electronic device needs to perform a function or service automatically or according to a request, it does not perform the function or service, but is capable of additionally requesting at least part of the function related to the function or service from the electronic devices 102 and 104 or the server 106. The electronic devices 102 and 104 or the server 106 is capable of executing the requested function or additional functions, and transmitting the result to the electronic device 101. The electronic device 101 processes the received result, or further proceeds with additional processes, to provide the requested function or service. To this end, the electronic device 101 may employ cloud computing, distributed computing, or client-server computing technology.

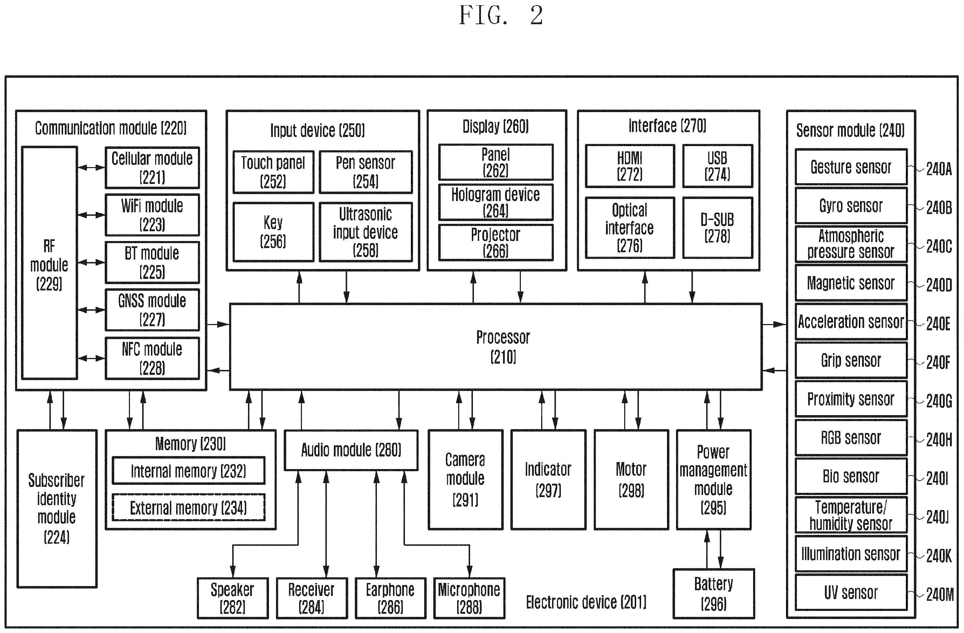

FIG. 2 is a block diagram showing a configuration of an electronic device, according to an embodiment of the present disclosure.

Referring to FIG. 2, an electronic device 201 may include a part or all of the components in the electronic device 101 shown in FIG. 1. The electronic device 201 may include one or more processors 210 (e.g., APs), a communication module 220, a subscriber identification module (SIM) 224, a memory 230, a sensor module 240, an input device 250, a display 260, an interface 270, an audio module 280, a camera module 291, a power management module 295, a battery 296, an indicator 297, and a motor 298.

The processor 210 drives, for example, an OS or an application program to control a plurality of hardware or software components connected to the processor 210, processing various data, and performing operations. The processor 210 may be implemented as, for example, a system on chip (SoC). The processor 210 may further include a graphic processing unit (GPU) and/or an image signal processor. The processor 210 may also include at least part of the components shown in FIG. 2, e.g., a cellular module 221. The processor 210 loads commands or data received from at least one of other components (e.g., a non-volatile memory) on a volatile memory, processing the loaded commands or data. The processor 210 stores various data in a non-volatile memory.

The communication module 220 may include the same or similar configurations as the communication interface 170 shown in FIG. 1. For example, the communication module 170 includes the cellular module 221, a Wi-Fi module 223, a BT module 225, a GNSS module 227 (e.g., a GPS module, Glonass module, Beidou module or Galileo module), an NFC module 228, and a radio frequency (RF) module 229.

The cellular module 221 provides a voice call, a video call, an SMS service, an Internet service, etc., through a communication network, for example. The cellular module 221 identifies and authenticating an electronic device 201 in a communication network by using the SIM 224. The cellular module 221 performs at least a part of the functions provided by the processor 210. The cellular module 221 may include a CP.

Each of the Wi-Fi module 223, the BT module 225, the GNSS module 227, and the NFC module 228 may include a processor for processing data transmitted or received through the corresponding module. At least part of the cellular module 221, Wi-Fi module 223, BT module 225, GNSS module 227, and NFC module 228 (e.g., two or more modules) may be included in one integrated chip (IC) or one IC package.

The RF module 229 transmits/receives of communication signals, e.g., RF signals. The RF module 229 includes a transceiver, a power amplifier module (PAM), a frequency filter, a low noise amplifier (LNA), an antenna, etc. At least one of the cellular module 221, the Wi-Fi module 223, the BT module 225, the GNSS module 227, and the NFC module 228 transmits/receives of RF signals through a separate RF module.

The memory 230 may include a built-in memory 232 or an external memory 234. The built-in memory 232 includes at least one of a volatile memory, e.g., a dynamic random access memory (DRAM), a static RAM (SRAM), a synchronous dynamic RAM (SDRAM), etc. and a non-volatile memory, e.g., a one-time programmable read only memory (OTPROM), a programmable ROM (PROM), an erasable and programmable ROM (EPROM), an electrically erasable and programmable ROM (EEPROM), a mask ROM, a flash ROM, a flash memory (e.g., a NAND flash memory, an NOR flash memory, etc.), a hard drive, a solid state drive (SSD), etc.

The external memory 234 may include a flash drive, e.g., a compact flash (CF), a secure digital (SD), a micro secure digital (Micro-SD), a mini secure digital (Mini-SD), an extreme digital (xD), a multi-media card (MMC), a memory stick, etc. The external memory 234 may be connected to the electronic device 201, functionally and/or physically, through various interfaces.

The sensor module 240 measures/detects a physical quantity or an operation state of the electronic device 201, and converts the measured or detected information into an electronic signal. The sensor module 240 may include at least one of a gesture sensor 240A, a gyro sensor 240B, an atmospheric pressure sensor 240C, a magnetic sensor 240D, an acceleration sensor 240E, a grip sensor 240F, a proximity sensor 240G, a color sensor 240H (e.g., a red, green and blue (RGB) sensor), a biometric sensor 2401, a temperature/humidity sensor 240J, an illuminance sensor 240K, and a ultraviolet (UV) sensor 240M. Additionally or alternatively, the sensor module 240 may also include an e-nose sensor, an electromyography (EMG) sensor, an electroencephalogram (EEG) sensor, an electrocardiogram (ECG) sensor, an infrared (IR) sensor, an iris sensor and/or a fingerprint sensor. The sensor module 240 may further include a control circuit for controlling one or more sensors included therein. The electronic device 201 may include a processor, configured as part of the processor 210 or a separate component, for controlling the sensor module 240. In this case, while the processor 210 is operating in sleep mode, the processor is capable of controlling the sensor module 240.

The input device 250 may include a touch panel 252, a (digital) pen sensor 254, a key 256, or an ultrasonic input unit 258. The touch panel 252 may be implemented with at least one of a capacitive touch system, a resistive touch system, an infrared touch system, and an ultrasonic touch system.

The touch panel 252 may further include a control circuit, and the touch panel 252 may include a tactile layer to provide a tactile response to the user. The (digital) pen sensor 254 may be implemented with a part of the touch panel or with a separate recognition sheet. The key 256 may include a physical button, an optical key, or a keypad. The ultrasonic input unit 258 detects ultrasonic waves, created in an input tool, through a microphone 288, and identifies data corresponding to the detected ultrasonic waves.

The display 260 may include a panel 262, a hologram unit 264, or a projector 266. The panel 262 may include the same or similar components as the display 160 shown in FIG. 1. The panel 262 may be implemented to be flexible, transparent, or wearable. The panel 262 may also be incorporated into one module together with the touch panel 252. The hologram unit 264 shows a stereoscopic image in the air by using light interference. The projector 266 displays an image by projecting light onto a screen. The screen may be located inside or outside of the electronic device 201. The display 260 may further include a control circuit for controlling the panel 262, the hologram unit 264, or the projector 266.

The interface 270 may include an HDMI 272, a USB 274, an optical interface 276, or a d-subminiature (D-sub) 278.

The interface 270 may be included in the communication interface 170 shown in FIG. 1. Additionally or alternatively, the interface 270 may include a mobile high-definition link (MHL) interface, a SD card/ MMC interface, or an infrared data association (IrDA) standard interface.

The audio module 280 provides bidirectional conversion between a sound and an electronic signal. At least part of the components in the audio module 280 may be included in the input/output interface 150 shown in FIG. 1. The audio module 280 processes sound information input or output through a speaker 282, a receiver 284, earphones 286, the microphone 288, etc.

The camera module 291 is a device capable of taking both still and moving images. The camera module 291 may include one or more image sensors (e.g., a front image sensor or a rear image sensor), a lens, an image signal processor (ISP), a flash (e.g., an LED or xenon lamp), etc.

The power management module 295 manages power of the electronic device 201. The power management module 295 may include a power management integrated circuit (PMIC), a charger IC, or a battery gauge. The PMIC may employ wired charging and/or wireless charging methods. Examples of the wireless charging method are magnetic resonance charging, magnetic induction charging, and electromagnetic charging. To this end, the PMIC may further include an additional circuit for wireless charging, such as a coil loop, a resonance circuit, a rectifier, etc. The battery gauge measures the residual capacity, charge in voltage, current, or temperature of the battery 296.

The battery 296 may be either a rechargeable battery or a solar battery.

The indicator 297 displays a specific status of the electronic device 201 or a part thereof (e.g., the processor 210), e.g., a boot-up status, a message status, a charging status, etc. The motor 298 converts an electrical signal into mechanical vibrations, such as, a vibration effect, a haptic effect, etc. The electronic device 201 may also include a processing unit (e.g., GPU) for supporting a mobile TV. The processing unit for supporting a mobile TV is capable of processing media data pursuant to standards, e.g., digital multimedia broadcasting (DMB), digital video broadcasting (DVB), or mediaFlo™, etc.

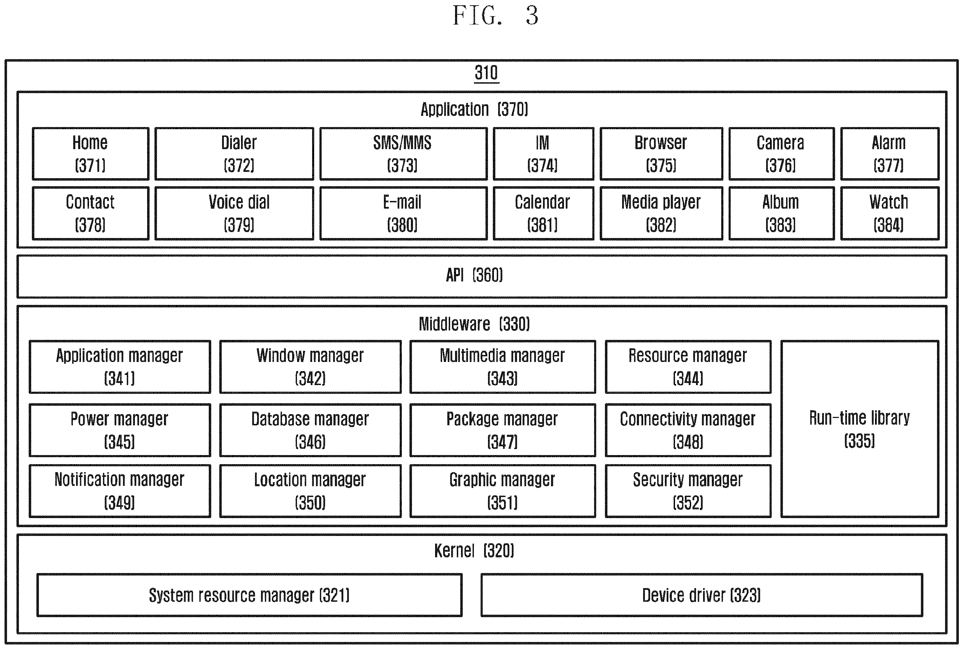

FIG. 3 is a block diagram of a programming module, according to an embodiment of the present disclosure.

Referring to FIG. 3, a program module 310 includes an OS for controlling resources related to the electronic device 101 and/or various applications (e.g., applications 147 shown in FIG. 1) running on the OS. The OS may be Android™, iOS™, Windows™, Symbian™, Tizen™, Bada™, etc.

The program module 310 includes a kernel 320, middleware 330, an API 360 and/or applications 370. At least part of the program module 310 may be preloaded on the electronic device or downloaded from the electronic device 102 or 104, the server 106, etc.

The kernel 320 may include a system resource manager 321 and/or a device driver 323. The system resource manager 321 may include a process manager, a memory manager, and a file system manager. The system resource manager 321 may perform a system resource control, allocation, and recall. The device driver 323 may include a display driver, a camera driver, a BT driver, a shared memory driver, a USB driver, a keypad driver, a Wi-Fi driver, and an audio driver. Further, the device driver 323 may include an inter-process communication (IPC) driver.

The middleware 330 may provide a function required in common by the applications 370. Further, the middleware 330 may provide a function through the API 360 to allow the applications 370 to efficiently use limited system resources within the electronic device. The middleware 330 may include at least one of a runtime library 335, an application manager 341, a window manager 342, a multimedia manager 343, a resource manager 344, a power manager 345, a database manager 346, a package manager 347, a connection manager 348, a notification manager 349, a location manager 350, a graphic manager 351, and a security manager 352. Furthermore, although not shown, the middleware 330 may also include a payment manager.

The runtime library 335 may include a library module used by a complier to add a new function through a programming language while the applications 370 are executed. The runtime library 335 executes input and output, management of a memory, a function associated with an arithmetic function and the like.

The application manager 341 may manage a life cycle of at least one of the applications 370. The window manager 342 may manage GUI resources used on the screen. The multimedia manager 343 may detect a format required for reproducing various media files and perform an encoding or a decoding of a media file by using a codec suitable for the corresponding format. The resource manager 344 manages resources such as a source code, a memory, or a storage space of at least one of the applications 370.

The power manager 345 may operate together with a basic input/output system (BIOS) to manage a battery or power and provides power information required for the operation. The database manager 346 may manage generation, search, and change of a database to be used by at least one of the applications 370. The package manager 347 may manage an installation or an update of an application distributed in a form of a package file.

The connection manager 348 may manage, for example, a wireless connection such as Wi-Fi or BT. The notification manager 349 may display or notify a user of an event such as an arrival message, an appointment, a proximity alarm or the like, in a manner that does not disturb the user. The location manager 350 may manage location information of the electronic device. The graphic manager 351 may manage a graphic effect provided to the user or a user interface related to the graphic effect. The security manager 352 provides a general security function required for a system security or a user authentication. When the electronic device has a call function, the middleware 330 may further include a telephony manager for managing a voice of the electronic device or a video call function.

The middleware 330 includes modules configuring various combinations of functions of the above described components. The middleware 330 provides modules specialized according to types of operation systems to provide distinct functions. The middleware 330 may be adaptively configured in such a way as to remove part of the existing components or to include new components.

The API 360 may be a set of API programming functions, and may be provided with a different configuration according to an operating system. For example, in Android™ or iOS™, a single API set may be provided for each platform. In Tizen™, two or more API sets may be provided.

The applications 370 may include one or more applications for performing various functions, e.g., home application 371, dialer application 372, short message service (SMS)/multi-media message service (MMS) application 373, instant message (IM) application 374, browser application 375, camera application 376, alarm application 377, contact application 378, voice dial application 379, email application 380, calendar application 381, media player application 382, album application 383, and clock application 384. Furthermore, although not shown, the applications 370 may also include health care application (e.g., an application for measuring amount of exercise, blood sugar level, etc.), and environment information (e.g., an application for providing atmospheric pressure, humidity, temperature, etc.).

The applications 370 include an information exchange application between the electronic device 101 and the electronic devices 102 and 104, which is hereafter called 'information exchange application'. The information exchange application includes a notification relay application for relaying specific information to external devices or a device management application for managing external devices.

The applications 370 include an application (e.g., a health care application of a mobile medical device, etc.) having specified attributes of the electronic devices 102 and 104. The applications 370 include applications received from the server 106 and/or the electronic devices 102 and 104. The applications 370 include a preloaded application or third party applications that can be downloaded from a server. It should be understood that the components of the program module 310 may be called different names according to types of operating systems.

The devices (e.g. modules or their functions) or methods described herein may be implemented by computer program instructions stored in a non-transitory computer-readable storage medium. In the case that the instructions are executed by the processor 120, and the processor 120 may execute the functions corresponding to the instructions. The non-transitory computer-readable storage medium may be the memory 130. At least a part of the programing module may be implemented (e.g. executed) by the processor 120. At least a part of the programing module may include modules, programs, routines, sets of instructions, and processes for executing the at least one function.

The non-transitory computer-readable storage medium includes magnetic media such as a floppy disk and a magnetic tape, optical media including a compact disc (CD) ROM and a DVD ROM, a magneto-optical media such as a floptical disk, and the hardware device designed for storing and executing program commands such as ROM, RAM, and flash memory. The program commands include the language code executable by computers using the interpreter as well as the machine language codes created by a compiler. The aforementioned hardware device can be implemented with one or more software modules for executing the operations of the various embodiments of the present disclosure.

The module or programming module of the present disclosure may include at least one of the aforementioned components with omission of some components or addition of other components. The operations of the modules, programming modules, or other components may be executed in series, in parallel, recursively, or heuristically. Also, some operations may be executed in different order, omitted, or extended with other operations.

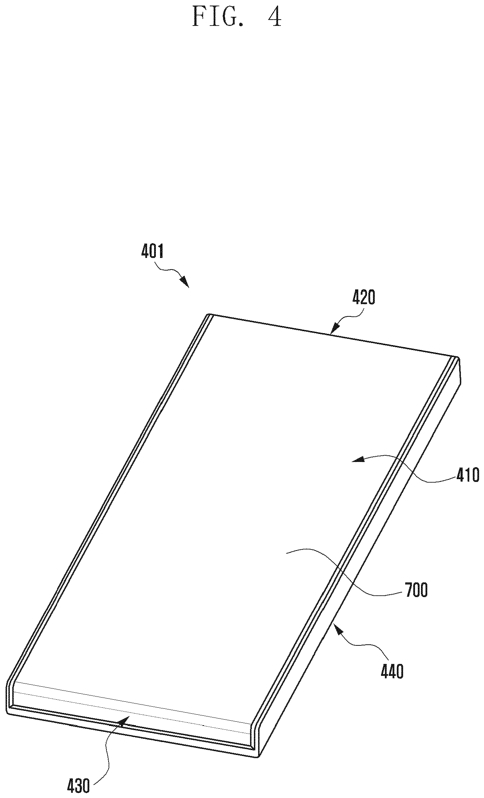

FIG. 4 is a perspective view illustrating of an electronic device, according to an embodiment of the present disclosure.

An electronic device 401 may include a first surface 410, second surface 420, third surface 430, and fourth surface 440. The first surface 410 may be a front surface of an electronic device 401. The second surface 420 and the third surface 430 may be side surfaces of the electronic device 401. The second surface 420 and the third surface 430 may be any one surface formed between the first surface 410 and the fourth surface 440. FIG. 4 illustrates that the second surface 420 and the third surface 430 are side surfaces having a length that is shorter in the electronic device 401, but the second surface 420 and the third surface 430 may be side surfaces having a length that is longer in the electronic device 401. The fourth surface 440 may be a rear surface of the electronic device 401. The entire of the first surface 410, which is a front surface of the electronic device 401, may be configured with a display 700 (e.g., a flexible display). The display 700 may be disposed in at least one surface of the first surface 410, the second surface 420, the third surface 430, and the fourth surface 440. The display 700 may be disposed at the first surface 410, the second surface 420, and the third surface 430. The display 700 may be entirely disposed at the first surface 410. At the first surface 410, a hole or a physical button for a device is omitted, and the display 700 may be disposed at the front surface 410. The display 700 may extend from the first surface 410 to the second surface 420 and the third surface 430.

The display 700 may be bent at the second surface 420 and the third surface 430. The electronic device 401 may include a black masking (BM) area in which a width of a portion of an area that does not display a screen is 0.1 to 1 mm and in which a width of at least another portion is 1 mm to 5 mm.

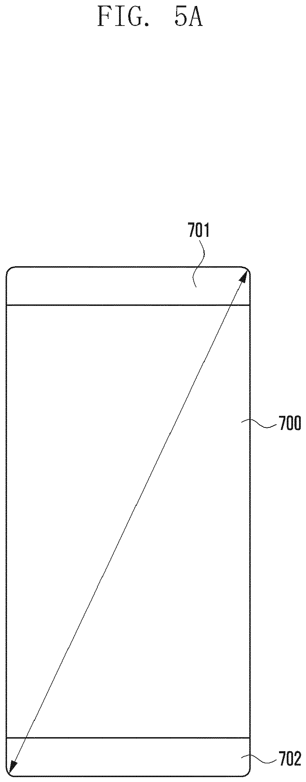

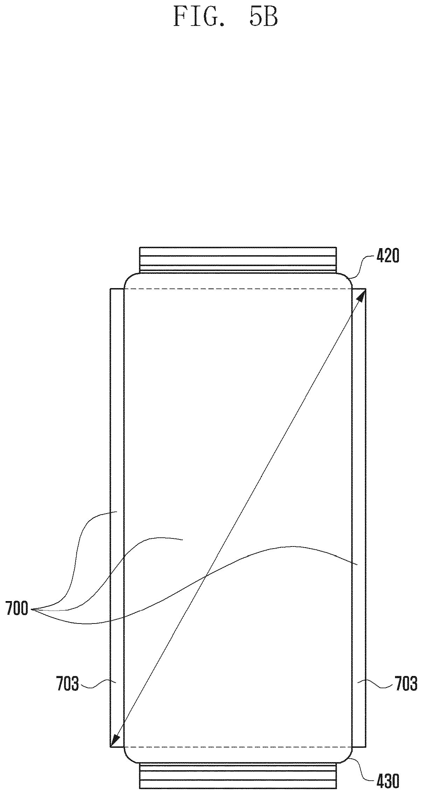

FIGs. 5A and 5B are diagrams illustrating an active area of a display that is disposed at a front surface of an electronic device and an active area of a display that is disposed at a front surface and a side surface of an electronic device, according to an embodiment of the present disclosure.

As shown in FIG. 5A, an active area of the display 700 including a touchscreen panel includes a main display area disposed at an intermediate area of the display 700 and a sub-display area disposed at an area of an upper portion 701 and a lower portion 702 of the display 700 disposed at only a front surface of the electronic device.

As shown in FIG. 5B, the display 700 may be bent to the inside of a lower portion at the second surface 420 and the third surface 430. An active area of the flexible display 700 may be disposed at a front surface and both side surfaces 703 of the electronic device, and the both side surfaces 703 may be bent to the inside of a lower portion. In this case, in a partial area of a corner portion of the electronic device, an active area of the display 700 may not be disposed.

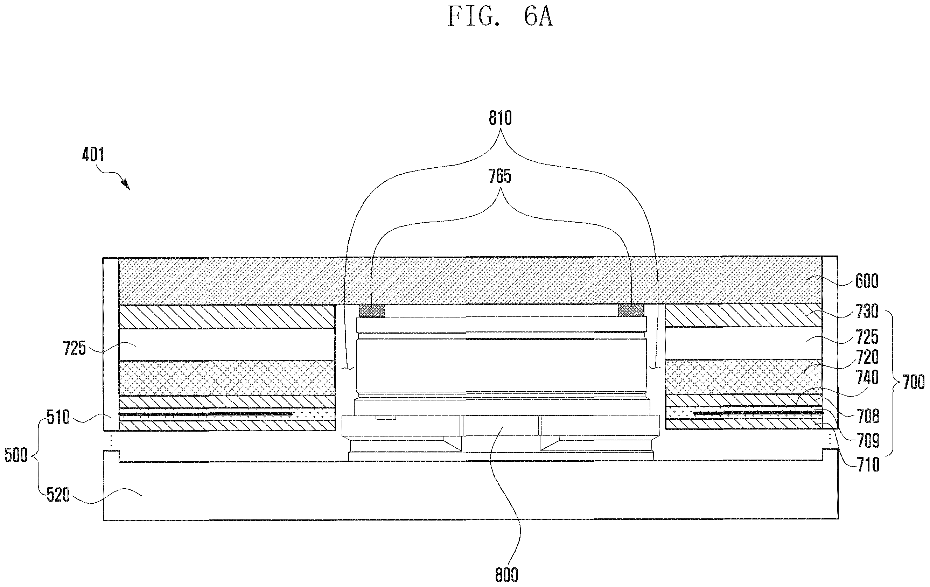

FIG. 6A is a cross-sectional view of an electronic device, according to an embodiment of the present disclosure.

As shown in FIG. 6A, the electronic device 401 may include a housing 500, transparent layer 600, display 700, and camera device 800. The electronic device of FIG. 6A may have a configuration in which a touchscreen panel 720 is physically separated from a display panel 709 disposed at a lower portion by a third adhesive layer 708.

For example, a first direction, which is a front direction, is opened, and the housing 500 includes a first surface 510 forming a side surface and a second surface 520 forming a rear surface, thereby having a receiving space therein. The first surface 510 and the second surface 520 may be integrally connected, and the first surface 510 may face a first direction, which is a vertical direction, and the second surface 520 opposite to the first surface 510 may face a second direction, which is a horizontal direction.

At the inside of the housing 500, the transparent layer 600, the display 700, and the camera device 800 may be sequentially disposed in the first direction. For example, the display 700 and the camera device 800 may be disposed between the transparent layer 600 and the second surface 520 of the housing 500.

The transparent layer 600 protects the touchscreen panel 720 within the display 700 from an external impact and may be made of a transparent material. For example, the transparent layer 600 may transmit light occurring at the inside of the electronic device 401 to the outside. Further, the transparent layer 600 may transmit external light of the electronic device 401 to the inside of the electronic device. The transparent layer 600 may be made of a material having excellent light transmittance, thermal resistance, chemical resistance, and mechanical strength. For example, the transparent layer 600 may be a transparent film or a glass substrate made of polyehyleneterephthalate and may be a plastic substrate made of polymethylmethacrylate, polyamide, polyimide, polypropylene, or polyurethane.

As shown in FIG. 6A, the display 700 includes a first adhesive layer 710, the display panel 709, the third adhesive layer 708, the touchscreen panel 720, and a second adhesive layer 730 from a lower portion toward a first direction, which is an upper portion, thereby configuring an active area. The active area may include pixels forming the touchscreen panel 720. The display 700 may be exposed through the transparent layer 600.

The display 700 may include, for example an LCD, an LED display, an OLED display, MEMS display, or electronic paper display.

The first adhesive layer 710 may be disposed between the transparent layer 600 and the second surface 520 of the housing 500. The first adhesive layer 710 may be at least partially opaque double-sided tape. The first adhesive layer 710 may bond a flexible printed circuit board (FPCB) and the display panel 709 that may be disposed on the second surface 520 of the housing 500. The first adhesive layer 710 may be an optical clear adhesive (OCA). The first adhesive layer 710 may be a thin adhesive film corresponding to a shape of the display panel 709.

The display panel 709 may be disposed between the first adhesive layer 710 and the third adhesive layer 708 disposed at a lower portion of the touchscreen panel 720. The touchscreen panel 720 may be disposed between the third adhesive layer 708 and the second adhesive layer 730 disposed at a lower portion of the transparent layer 600. The touchscreen panel 720 may be coupled to the transparent layer 600 to sense a user touch position occurring at the transparent layer 600. The touchscreen panel 720 may be configured with a touch detection sensor such as capacitive overlay, resistive overlay, and infrared beam or may include at least one of a pressure sensor and a fingerprint sensor. In addition to the sensors, various sensors that can detect a contact or a pressure of an object may be included in the touchscreen panel 720.

The second adhesive layer 730 may be disposed between the touchscreen panel 720 and the transparent layer 600 to bond the touchscreen panel 720 and the transparent layer 600. The second adhesive layer 730 may be a substantially transparent OCA. The second adhesive layer 730 may include an optically transparent polymer material.

A polarization layer (PCL) 725 may be further included between the second adhesive layer 730 and the touchscreen panel 720. The polarization layer 725 may polarize incident light applied to the touchscreen panel 720 side and reflected light in which the incident light is reflected by the touchscreen panel 720. The polarization layer 725 may be attached to the transparent layer 600 through the second adhesive layer 730 to perform a function of preventing the transparent layer 600 from being scattered when the transparent layer 600 is damaged.

An opening 810 may be formed by penetration of at least a partial layer or the entire layer of the first adhesive layer 710, the display panel 709, the third adhesive layer 708, the touchscreen panel 720, the polarization layer 725, and the second adhesive layer 730. The opening 810 may be positioned within a range of 1 mm to 20 mm from a peripheral portion of the first surface 510 of the housing 500.

At the inside of the display panel 709 of the display 700, a TFE layer may be formed. When the opening 810 is formed in the display 700, in order to prevent moisture from penetrating into the display panel 709, the TFE layer may block the display panel 709 from contact with an external environment. For planarization of the TFE layer, a buffer layer made of the same material as that of the TFE layer may be additionally provided on the TFE layer.

The camera device 800 may be at least partially disposed within the opening 810. The camera device 800 may include at least one image sensor (e.g., a front sensor or a rear sensor) that penetrates/extends at least a portion of the opening 810 to face toward the transparent layer 600. The camera device 800 may photograph a still picture and a moving picture, and may include a lens, an image signal processor (ISP), or flash (e.g., LED or xenon lamp).

At least one sponge 765 is mounted between the transparent layer 600 and the camera device 800 disposed at a lower portion of the transparent layer 600 to prevent dust from entering into a lens of the camera device 800 and to mitigate an impact applied from the outside to the camera device 800.

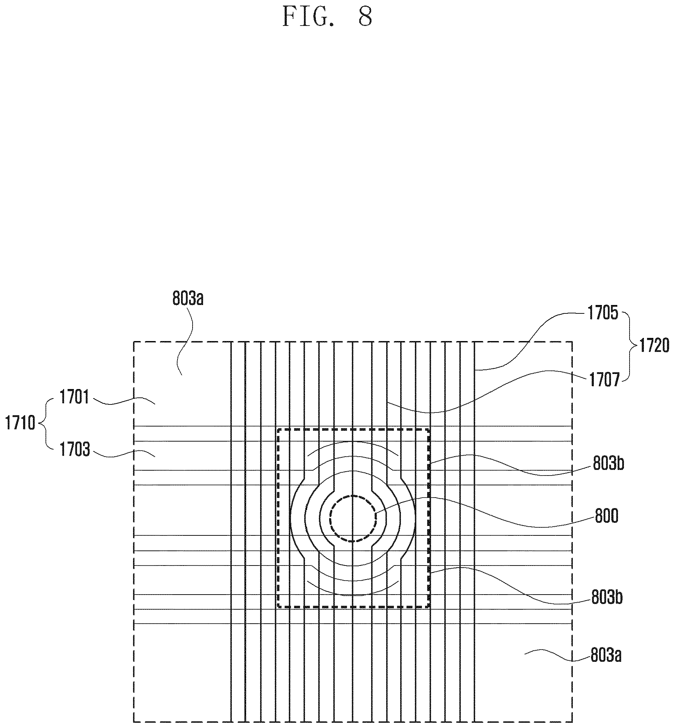

In order not to optically block the opening 810, when viewed from the transparent layer 600, a plurality of conductive lines 740 may be disposed extended around a peripheral portion of the opening 810. The conductive lines 740 may include a gate wiring 1710 and a data wiring 1720, as will be described with reference to FIG. 8. In the display panel 709, bonding pads may be disposed to be electrically connected corresponding one-to-one to a plurality of conductive lines 740.

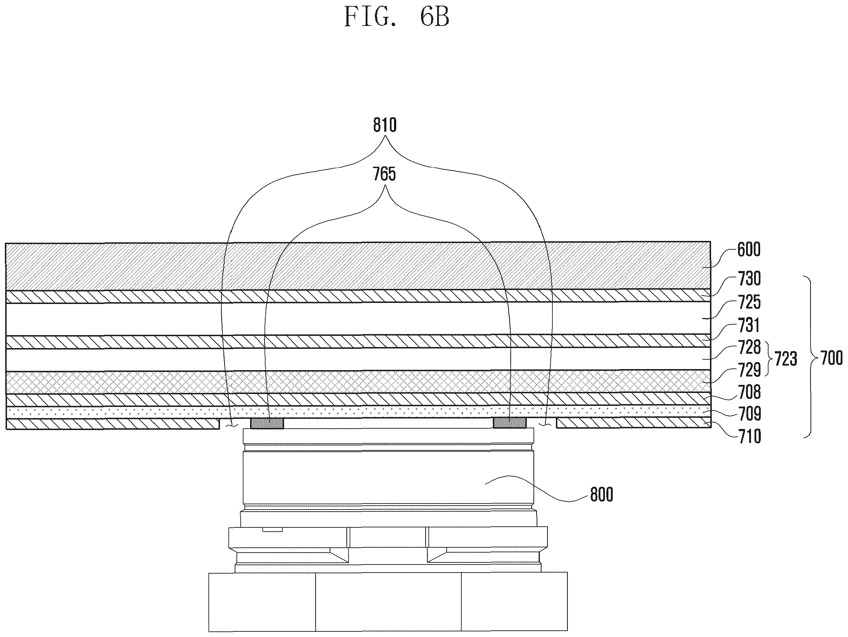

FIG. 6B is a cross-sectional view of another example of an electronic device, according to an embodiment of the present disclosure.

As shown in FIG. 6B, the electronic device 401 may include the housing 500, the transparent layer 600, the display 700, and the camera device 800 of FIG. 6A.

The electronic device of FIG. 6B has the same configuration as that of the electronic device of FIG. 6A except that the touchscreen panel 720 of the electronic device of FIG. 6A may be replaced with an in-touchscreen panel 723 configured with a TFE layer 728 and a touch pattern 729.

The transparent layer 600, the display 700, and the camera device 800 may be sequentially disposed in the first direction.

The transparent layer 600 protects the in-touchscreen panel 723 within the display 700 from an external impact and may be made of a transparent material. The in-touchscreen panel 723 is configured with the TFE layer 728 and the touch pattern 729 to perform the same function as that of the touchscreen panel 720 of FIG. 6A.

As shown in FIG. 6B, the display 700 may include the first adhesive layer 710, the display panel 709, the third adhesive layer 708, the in-touchscreen panel 723, a fourth adhesive layer 731, the polarization layer 725, and the second adhesive layer 730 from a lower portion toward a first direction, which is an upper portion, thereby configuring an active area. The display 700 may be exposed through the transparent layer 600.

The first adhesive layer 710 may be disposed between the transparent layer 600 and the second surface 520 of the housing 500 of FIG. 6A. The first adhesive layer 710 may bond the display panel 709 and an FPCB that may be disposed on the second surface 520 of the housing 500.

The display panel 709 may be disposed between the first adhesive layer 710 and the third adhesive layer 708 disposed at a lower portion of the in-touchscreen panel 723. The in-touchscreen panel 723 may be disposed between the third adhesive layer 708 and the fourth adhesive layer 731 disposed at a lower portion of the transparent layer 600. The in-touchscreen panel 723 may be coupled to the transparent layer 600 to sense a user touch position occurring at the transparent layer 600. The in-touchscreen panel 723 may be configured with a touch detection sensor such as capacitive overlay, resistive overlay, and infrared beam or may include at least one of a pressure sensor and a fingerprint sensor. In addition to the sensors, various sensors that may detect a contact or a pressure of an object may be included in the in-touchscreen panel 723.

The fourth adhesive layer 731 may be disposed between the in-touchscreen panel 723 and the polarization layer 725 to bond the in-touchscreen panel 723 and the polarization layer 725.

The second adhesive layer 730 may be disposed between the polarization layer 725 and the transparent layer 600 to bond the polarization layer 725 and the transparent layer 600.

The opening 810 may be formed by penetration of at least a partial layer or an entire layer of the first adhesive layer 710, the display panel 709, the third adhesive layer 708, the in-touchscreen panel 723, the fourth adhesive layer 731, the polarization layer 725, and the second adhesive layer 730. Selectively, the third adhesive layer 708 may not be used, and the touch pattern 729 of the in-touchscreen panel 723 may be directly disposed on the display panel 709.

The camera device 800 may be disposed at least partially within the opening 810. The camera device 800 may include at least one image sensor (e.g., a front sensor or a rear sensor) facing the transparent layer 600 through at least a portion of the opening 810. For example, the camera device 800 may be mounted in the opening 810 in which only the first adhesive layer 710 is punched or cut and may come in close contact with the display panel 709.

The at least one sponge 765 is mounted between the display panel 709 and the camera device 800 disposed at a lower portion of the display panel 709 to prevent dust from entering into a lens of the camera device 800 and to mitigate an impact applied from the outside to the camera device 800.

The first adhesive layer 710 of FIGs. 6A and 6B may include at least one of a double-sided adhesive tape that fixes a device disposed at an upper portion and a lower portion, copper that blocks noise of the display panel 709, graphite that assists heat emission of the display panel 709, and a cushion that mitigates an impact from a device of an upper portion and a lower portion.

By removing a partial area of the display 700 disposed at a lower portion of the transparent layer 600, e.g., by punching or cutting, the opening 810 is formed, but a partial area of the transparent layer 600 together with a partial area of the display 700 may be removed by punching or cutting.

By removing a portion of the transparent layer 600 by punching or cutting, when a hole is formed, and at a position corresponding to the hole, at least one of a receiver, speaker, and physical key may be mounted instead of the camera device 800. That is, at a position corresponding to the hole formed in the transparent layer 600, an audio device that emits sound to the outside of the electronic device, as in the receiver or the speaker or an electric material that receives an input by an external force of the user of the electronic device, as in the physical key, may be mounted.

For example, when a hole is formed in the display 700 and the transparent layer 600, a speaker may be disposed at a lower portion of the display 700. Further, in a state in which any one side surface of the left side or the right side of the display 700 is removed, the speaker may be disposed at the inside of the display 700 about the opening 810. Further, the physical key may be disposed within the hole formed in the display 700 and the transparent layer 600.

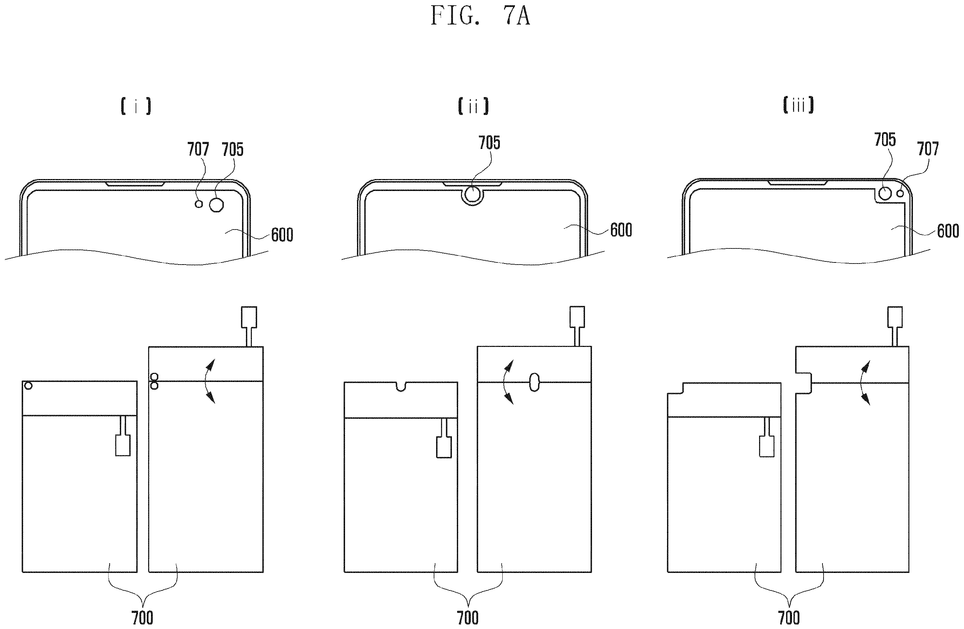

FIG. 7A is a diagram illustrating various examples in which a camera hole and a sensor hole of an electronic device exist in an active area of a display, according to an embodiment of the present disclosure.

As shown in FIG. 7A, a portion of the display 700, except for the transparent layer 600 of FIGS. 6A and 6B, may be removed.

FIG. 7A (at (i)) illustrates an example in which a camera hole 705 and a sensor hole 707 are exposed at a lower portion of the transparent layer 600 by removing a portion of the display 700. FIG. 7A (at (ii)) illustrates an example in which the camera hole 705 is exposed on the transparent layer 600 through a U-cut. FIG. 7A (at (iii)) illustrates an example in which the camera hole 705 and the sensor hole 707 are exposed in an inactive area through an L-cut.

In the display 700 disposed at a lower portion of the transparent layer 600, a partial area thereof removed by punching or cutting may include an entire area or at least a partial area that displays a signal. As shown in a low portion of each of FIG7A, the camera hole 705 and the sensor hole 707 are formed within an active area of the display 700, and in order to connect the display 700 to the circuit board within the electronic device 401, a portion of the display 700 may be folded. Therefore, even in an active area of the display 700 and a portion in which at least a portion thereof is overlapped, an electric material may be together mounted or a penetrating hole may be formed.

By removing a portion of an upper portion of the display 700, the camera hole 705 and the sensor hole 707 may be exposed at a lower portion of the transparent layer 600, by removing a portion of an upper portion of the display 700 through a U-cut, the camera hole 705 may be exposed at a lower portion of the transparent layer 600, and by removing a portion of an upper portion of the display 700 through an L-cut, the camera hole 705 and the sensor hole 707 may be exposed in an inactive area.

In the display 700 disposed at a lower portion of the transparent layer 600, a partial area thereof removed by punching or cutting may include an entire area or at least a partial area that displays a signal. In order to connect the display 700 to the circuit board within the electronic device 401, a lower portion of the display 700 may be folded.

FIG. 7A illustrates that a partial area of the display 700 disposed at a lower portion of the transparent layer 600 is removed by punching or cutting, but a partial area of the transparent layer 600 together with a partial area of the display 700 may be removed by punching or cutting.

By removing a portion of the transparent layer 600 by punching or cutting, when a hole is formed, at a position corresponding to the hole, at least one of the receiver, speaker, and physical key instead of the camera hole 705 and the sensor hole 707 may be mounted.

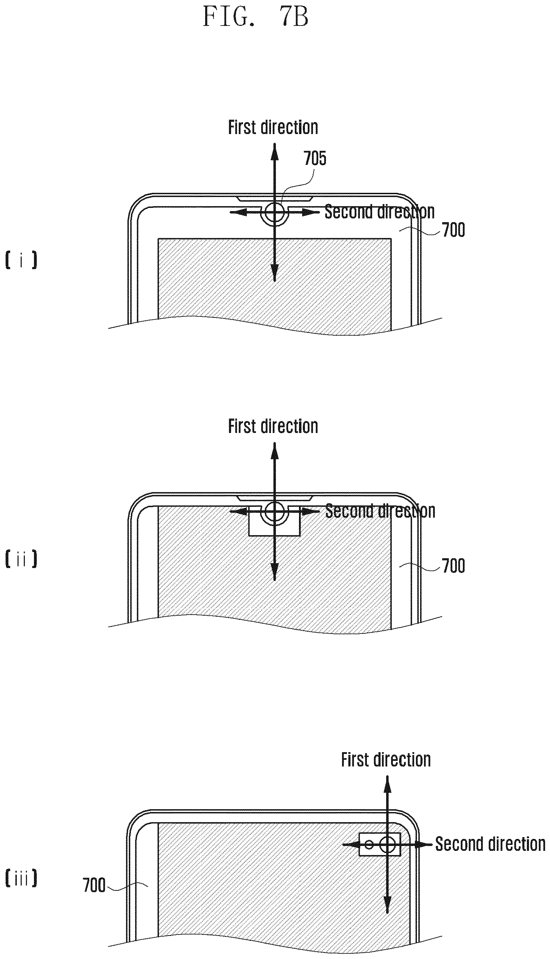

FIG. 7B is a diagram illustrating various examples representing whether a first adhesive layer of an electronic device exists, according to an embodiment of the present disclosure.

As shown in FIG. 7B, a portion of the display 700, except for the transparent layer 600 of FIGS. 6A and 6B, may be removed.

FIG. 7B illustrates an example in which the camera hole 705 is exposed through a U-cut, and FIG. 7B (at (iii)) illustrates an example in which the camera hole 705 is exposed through an L-cut.

As shown in FIG. 7B (at (i)), the first adhesive layer 710 of FIGs. 6A and 6B may exist at only a lower surface about the camera hole 705 in a first direction, which is a vertical direction, and may not exist about the camera hole 705 in a second direction, which is a horizontal direction.

As shown in FIG. 7B (at (ii)), the first adhesive layer 710 of FIGs. 6A and 6B may exist at only a lower portion of a lower surface about the camera hole 705 in a first direction, which is a vertical direction, and may exist at both a left surface and a right surface about the camera hole 705 in a second direction, which is a horizontal direction.
as shown in FIG. 7B (at (iii)), the first adhesive layer 710 of FIGs. 6A and 6B may exist at both an upper surface and a lower surface about the camera hole 705 in a first direction, which is a vertical direction, and may exist at both a left surface and a right surface about the camera hole 705 in a second direction, which is a horizontal direction.

FIG. 8 is a diagram illustrating a conductive line of an electronic device, according to an embodiment of the present disclosure.

The touchscreen panel 720 may include a first area 803a that does not overlap with the camera device 800 and a second area 803b that overlaps with the camera device 800. The touchscreen panel 720 may include a gate wiring 1710 and a data wiring 1720. By transferring a first signal to a pixel RGB, the gate wiring 1710 may control a gate of the pixel. The gate wiring 1710 may include a first gate wiring 1701 disposed at the first area 803a and a second gate wiring 1703 that crosses the second area 803b. By transferring a second signal to the pixel, the data wiring 1720 may control an image to display on the touchscreen panel 720. The data wiring 1720 may include a first data wiring 1705 disposed at the first area 803a and a second gate wiring 1707 that crosses the second area 803b.

As shown in FIG. 8, at least one of the first gate wiring 1701 or the first data wiring 1705 may be different from the second gate wiring 1703 or the second data wiring 1707. For example, the first gate wiring 1701 or the first data wiring 1705 may be a straight line shape. Alternatively, at least a portion of the second gate wiring 1703 or the second data wiring 1707 may include a curve shape. Specifically, a portion disposed at the second area 803b in the second gate wiring 1703 or the second data wiring 1707 may include a curve shape. At least a portion of the second gate wiring 1703 or the second data wiring 1707 may include a shape that does not overlap with the camera device 800. At least a portion of the second gate wiring 1703 or the second data wiring 1707 may be disposed to detour or bypass the camera device 800. Therefore, a quantity of light received in the camera device 800 may be prevented from being reduced by the gate wiring 1710 or the data wiring 1720 disposed at the touchscreen panel 720. That is, an influence in a quantity of light received in the camera device 800 by the gate wiring 1710 or the data wiring 1720 may be reduced.

In the conductive line 740 of FIG. 6A, in order to provide image data to the display 700, an IC (e.g., display drive IC (DDI)) or an AP may be included.

The opening 810 may be extended through an entire layer of the first adhesive layer 710, the display panel 709, the third adhesive layer 708, the touchscreen panel 720, the polarization layer 725, and the second adhesive layer 730. The camera device 800 may be mounted in the penetrating opening 810 and come in close contact with the transparent layer 600 to implement a thin thickness.

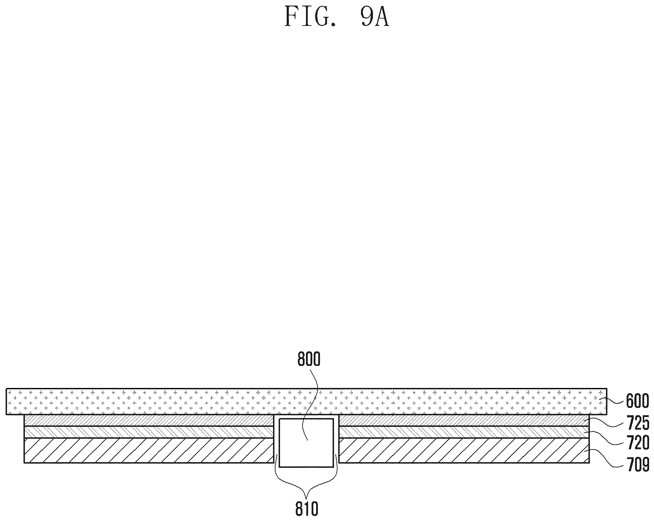

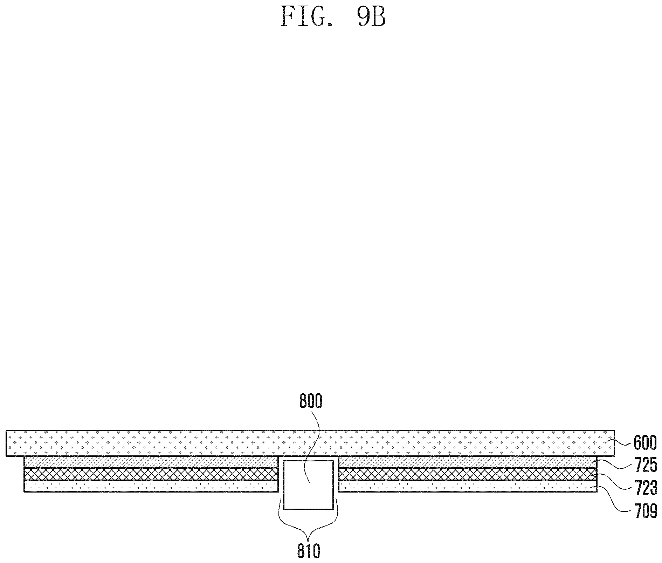

FIGs. 9A and 9B are diagrams illustrating the touchscreen panel 720 that is formed at an upper portion of the display panel 709 and the in-touchscreen panel 723 that is formed at an upper portion of the display panel 709, according to an embodiment of the present disclosure.

As shown in FIG. 9A, at an upper portion of the display panel 709, the touchscreen panel 720 may be disposed. The polarization layer 725 may be disposed between the touchscreen panel 720 and the transparent layer 600.

As shown in FIG. 9B, at an upper portion of the display panel 709, the in-touchscreen panel 723 may be disposed. The polarization layer 725 may be disposed between the in-touchscreen panel 723 and the transparent layer 600.

As shown in FIG. 9A, the opening 810 may be formed by penetration of a portion of the display panel 709, the touchscreen panel 720, and the polarization layer 725. Further, as shown in FIG. 9B, the opening 810 may be formed by penetration of a portion of the display panel 709, the in-touchscreen panel 723, and the polarization layer 725. The camera device 800 may be mounted in the opening 810 penetrating to the second adhesive layer 730 disposed at an upper portion of the polarization layer 725 to be exposed at a rear surface of the transparent layer 600. At least a portion of an FPCB disposed at an upper portion of the second surface 520 of the housing 500 of FIG. 6A or at a lower portion of the display 700 may be penetrated.

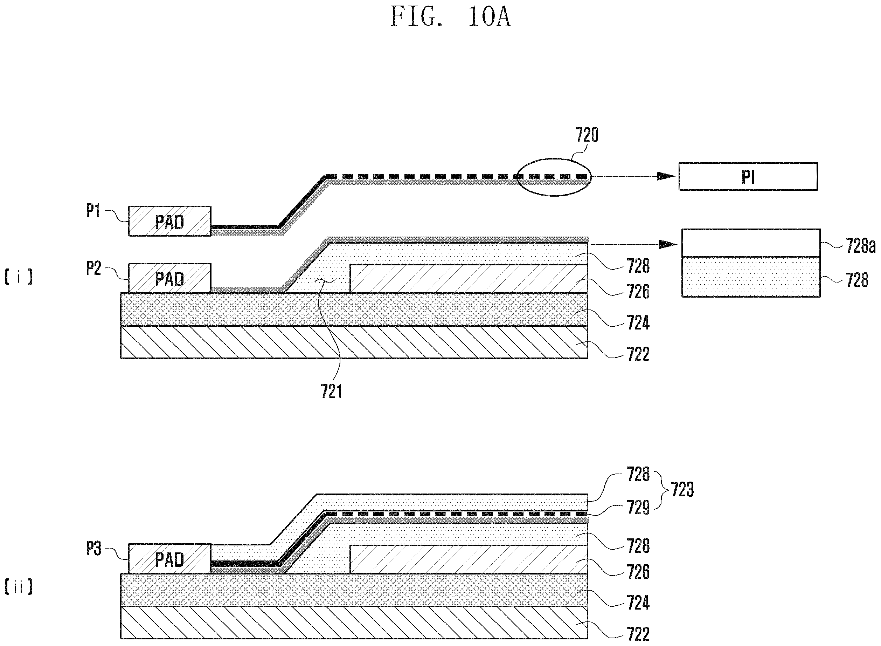

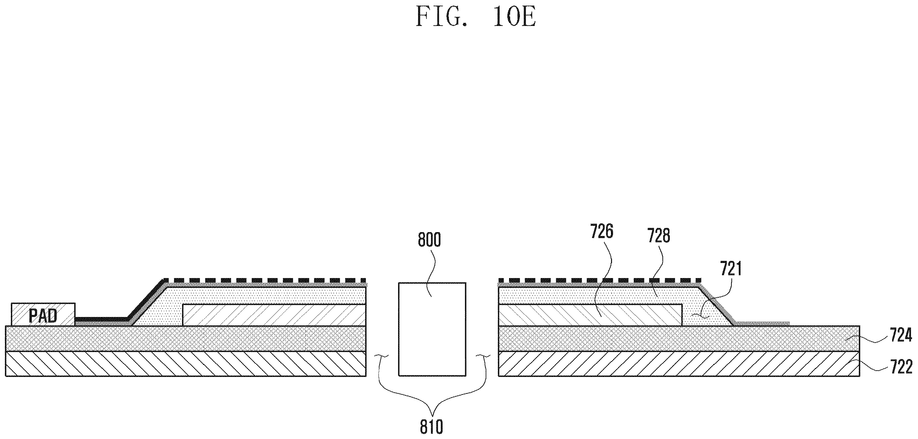

FIG. 10A is a diagram illustrating an example of the display 700 of the electronic device, according to an embodiment of the present disclosure.

As shown in FIG. 10A (at (i)), the electronic device may have a structure in which the touchscreen panel 720 and the display panel 709 are separated. At one end of the touchscreen panel 720 disposed at an upper portion of the display panel 709, electrodes P1 and PAD of the touchscreen panel 720 may be disposed, and at one end of the display panel 709, an electrode P2 and PAD of the display panel 709 may be disposed.

As shown in FIG. 10A (at (ii)), the electronic device may have a structure in which the in-touchscreen panel 723 including the touch pattern 729 and the TFE layer 728 is disposed on the display panel 709. At one end of the in-touchscreen panel 723 disposed at an upper portion of the display panel 709, an electrode P3 of the in-touchscreen panel 723 may be disposed.

The display panel 709 may include a polymer layer 722, a TFT array 724, organic light emitting layer 726, and TFE layer 728.

The polymer layer 722 may be bonded to the first adhesive layer 710 of FIGs. 6A and 6B. The polymer layer 722 may include at least one of polyehyleneterephthalate, polymethylmethacrylate, polyamide, polyimide, polypropylene, and polyurethane.

The TFT array 724 may be disposed at an upper portion of the polymer layer 722. The TFT array 724 may be electrically coupled to a pixel included in an active area of the display panel 709 to drive the pixel.

When electricity is supplied through the electrode P2 or P3, the organic light emitting layer 726 autonomously emits light and may include red, green, and blue fluorescent or phosphorus organic compounds. When the first surface 510 of the housing 500 of FIG. 6A is viewed from the top, the organic light emitting layer 726 may include a portion 721 that does not at least partially overlap with the opening 810. The organic light emitting layer 726 may be included in the transparent layer 600 of FIG. 6A. In the portion 721, the organic light emitting layer 726 may not be included.

In order to prevent moisture from penetrating into the display panel 709, the TFE layer 728 may block the display panel 709 from contact with an external environment. At an upper portion of the TFE layer 728, for planarization of the TFE layer 728, a buffer layer 728a may be additionally provided.

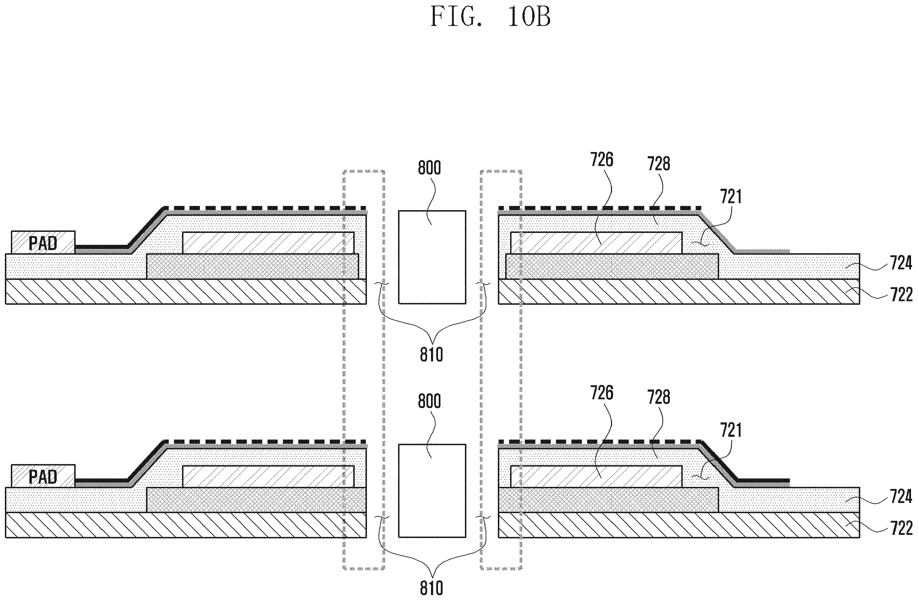

FIG. 10B is a cross-sectional view illustrating another example of the display panel 709 of an electronic device, according to an embodiment of the present disclosure.

As shown in FIG. 10B (at (i) and (ii)), the display panel 709 may include a polymer layer 722, TFT array 724, organic light emitting layer 726, and TFE layer 728.

The TFT array 724 may be disposed at an upper portion of the polymer layer 722. The TFT array 724 may be electrically coupled to a pixel included in an active area of the display panel 709 to drive the pixel. When electricity is supplied, the organic light emitting layer 726 autonomously emits light and may include red, green, and blue fluorescent or phosphorus organic compounds. When the first surface 510 of the housing 500 of FIG. 6A is viewed from the top, the organic light emitting layer 726 may include a portion 721 that does not at least partially overlap with the opening 810. The organic light emitting layer 726 may be included in the transparent layer 600 of FIG. 6A. In the portion 721, the organic light emitting layer 726 may not be included.

As shown in FIG. 10B, by penetrating a portion of the polymer layer 722, TFT array 724, organic light emitting layer 726, and TFE layer 728 of the display panel 709, the opening 810 may be formed. The camera device 800 may be mounted in the opening 810 to be exposed at a rear surface of the transparent layer 600.

The TFE layer 728 may be disposed at an upper portion of the organic light emitting layer 726 and at a lower portion of the second adhesive layer 730 of FIG. 6A. The TFE layer 728 may fill at least a portion of the portion 721.
as shown in FIG. 10B (at (i)), in order to prevent moisture from penetrating into the organic light emitting layer 726, the TFE layer 728 may be configured to enclose both the TFT array 724 and the organic light emitting layer 726.

As shown in FIG. 10B (at (ii)), when a touch pattern does not exist in the TFT array 724, the TFE layer 728 may be configured to enclose only the organic light emitting layer 726 disposed at a surface in which the opening 810 is formed.

At an upper portion of the TFE layer 728, a buffer layer 728a may be additionally provided.

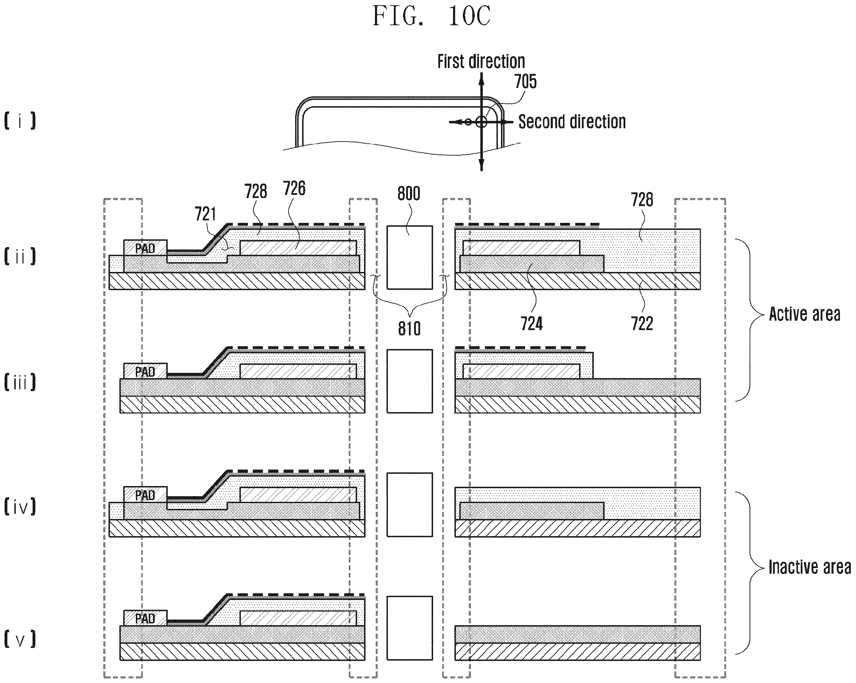

FIG. 10C is a cross-sectional view illustrating an example of a display panel 709 about a camera hole of an electronic device, according to an embodiment of the present disclosure.

As shown in FIG. 10C (at (i)), a first direction, which is a vertical direction and a second direction, which is horizontal direction, may exist about the camera hole 705, and a portion of the display panel 709 may be disposed at an upper portion, lower portion, left portion, and right portion around the camera hole 705. For example, the display panel 709 may have a configuration of FIG. 10C in a first direction of FIG. 10C (at (i)) and may have a configuration of FIG. 10C (at (ii) and (iii)) in a second direction.

When viewed from the opening 810 in which the camera device 800 is mounted, FIG. 10C (at (ii)) illustrates a configuration in which the TFE layer 728 encloses the TFT array 724 and the organic light emitting layer 726, FIG. 10C (at (iii)) illustrates a configuration in which the TFE layer 728 encloses only the organic light emitting layer 726, FIG. 10C (at (iv)) illustrates a configuration in which the TFE layer 728 encloses the TFT array 724 and the organic light emitting layer 726, and FIG. 10C (at (v)) illustrates a configuration in which the TFE layer 728 encloses only the organic light emitting layer 726. Here, FIG. 10C (at (iii) and (v)) illustrates a configuration in which a touch pattern does not exist in the TFT array 724.

FIG. 10C (at (ii) and (iii)) illustrates a case in which active areas exist at the left side and the right side about the camera hole 705, and FIG. 10C (at (iv) and (v)) illustrates a case in which an inactive area exists in at least one surface of the left side and the right side about the camera hole 705.

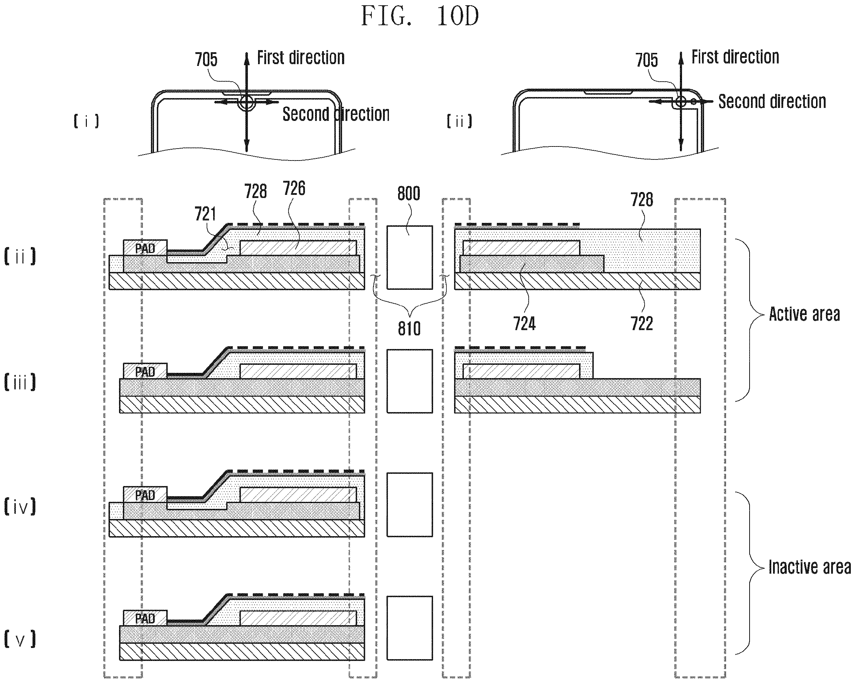

FIG. 10D is a cross-sectional view illustrating another example of a display panel 709 about a camera hole of an electronic device, according to an embodiment of the present disclosure.

As shown in FIG. 10D (at (i) and (ii)), a first direction, which is a vertical direction, and a second direction, which is horizontal direction, may exist about the camera hole 705, and a portion of the display panel 709 may be disposed or may not be disposed at an upper portion, lower portion, left portion, and right portion around the camera hole 705.

For example, the display panel 709 may have a configuration of FIG. 10D (at (v) and (vi)) in a first direction of FIG. 10C (see (i)) and may have a configuration of FIG. 10D (see (iii) and (iv)) in a second direction.

Further, the display panel 709 may have a configuration of FIG. 10D (at (v) and (vi)) in a first direction and a second direction of FIG. 10D (at (ii)).

When viewed from the opening 810 in which the camera device 800 is mounted, FIG. 10D (at (iii)) illustrates a configuration in which the TFE layer 728 encloses both the TFT array 724 and the organic light emitting layer 726, FIG. 10D (at (iv)) illustrates a configuration in which the TFE layer 728 encloses only the organic light emitting layer 726, FIG. 10D (at (v)) illustrates a configuration in which the TFE layer 728 encloses both the TFT array 724 and the organic light emitting layer 726, and FIG. 10D (at (vi)) illustrates a configuration in which the TFE layer 728 encloses only the organic light emitting layer 726. Here, FIG. 10D (at (iv) and (vi)) illustrates a configuration in which a touch pattern does not exist in the TFT array 724.

FIG. 10D (at (iii) and (iv)) illustrates a case in which active areas exist at a left portion and a right portion about the camera hole 705, and FIG. 10D (at (v) and (vi)) illustrates a case in which the display panel 709 does not exist in at least one surface of a left portion and a right portion about the camera hole 705.

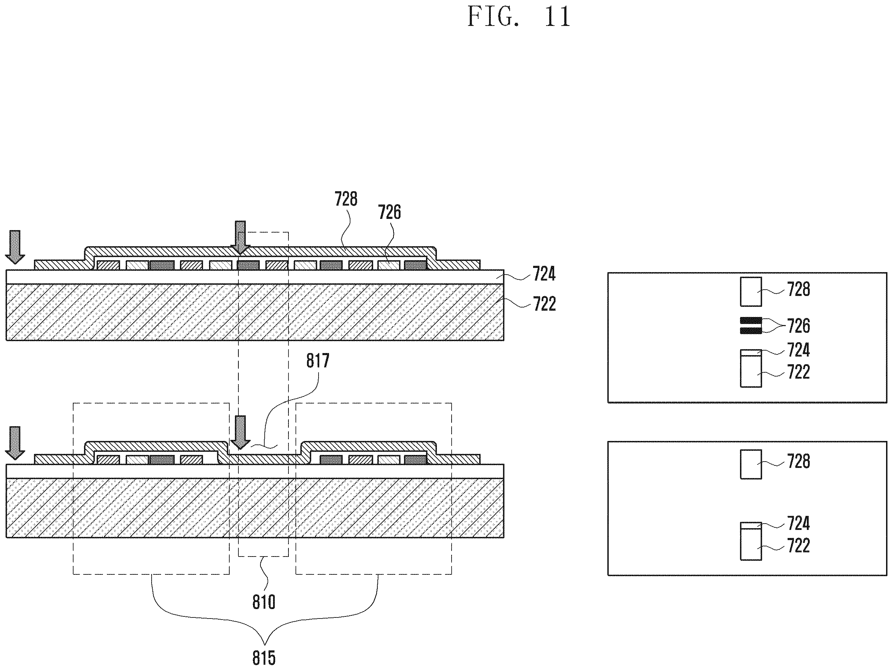

FIG. 11 is a diagram illustrating a method of forming an opening by punching a display panel 709, according to an embodiment of the present disclosure.

The display panel 709 may include the polymer layer 722, the TFT array 724, the organic light emitting layer 726, and the TFE layer 728 from a lower portion toward an upper portion.

The TFT array 724 may be a buffer layer. The buffer layer may prevent an impure element from penetrating into the polymer layer 722 and provide a flat surface to an upper portion of the polymer layer 722. The TFT array 724, which is a buffer layer, may be made of various materials that may provide a flat surface. For example, the buffer layer may contain an inorganic material such as glass, polyethylene terephthalate (PET), silicon oxide, silicon nitride, silicon oxynitride, aluminum oxide, aluminum nitride, titanium oxide, and titanium nitride or an organic material such as polyimide, polyester, and polyacrylonitrile, or other suitable materials. The buffer layer may be deposited by various deposition methods such as a plasma enhanced chemical vapor deposition (PECVD) method, an atmospheric pressure CVD (APCVD) method, and a low pressure CVD (LPCVD) method.

The organic light emitting layer 726 includes a cathode electrode, anode electrode, and organic light emitting element and may be deposited on the TFT array 724.

As shown in FIG. 11, a first area 815 of the display 700 may include a cathode electrode, which is a first electrode, an anode electrode, which is a second electrode, an organic light emitting material interposed between the cathode electrode and the anode electrode, and the TFT array 724 and the organic light emitting layer 726 connected to the cathode electrode or the anode electrode.

A second area 817 of the display 700 may not include at least one of a cathode electrode, which is a first electrode; an anode electrode, which is a second electrode; the organic light emitting material; and/or the TFT array 724 and the organic light emitting layer 726.

The TFE layer 728 includes at least one of an organic layer, inorganic layer, organic metal layer, and/or silicate and may cover the organic light emitting layer 726. The TFE layer 728 may prevent the organic light emitting layer 726 from being oxidizing by moisture and oxygen. The TFE layer 728 may have a structure in which at least one organic layer and at least one inorganic layer are alternately layered repeatedly. When a plurality of organic layers and inorganic layers are alternately layered repeatedly, in order to more effectively prevent moisture from penetrating into the organic light emitting layer 726, an uppermost layer may be formed in an inorganic layer.

The organic layer may include aluminum tris 8-hydroxyquinoline, phthalocyanines, naphthalocyanines, polycyclic aromatics, or compounds of the materials. The inorganic layer may include laser induced fluorescence (LIF), magnesium fluoride (MgFl), calcium fluoride (CaFl), or compounds of the materials.

The TFE layer 728 may additionally include a functional layer in addition to at least one layer of an organic layer, inorganic layer, organic metal layer, and/or silicate. The functional layer may include any one of hardcoat layers, photoresist layers, antiglare layers, antireflective layers, impact protective coatings, antismear/fingerprint coatings, and etch resistant material selected from silanes, siloxanes, hexafluorobenzene, pentafluorostyrene, perfluoro-1, 3-butadiene, chlorocarbon compounds, and thermoplastic polymers.

At a cross-section of the opening 810, a method of preventing an organic light emitting material included in the organic light emitting layer 726 from being exposed to external moisture or air may be considered. First, the organic light emitting layer 726 including the cathode electrode, anode electrode, and organic light emitting element may be deposited on the TFT array 724, which is a buffer layer. Laser etching may be performed in the organic light emitting layer 726 exposed at one surface of the opening 810. At an upper portion of the organic light emitting layer 726 in which laser etching is performed, the TFE layer 728 may be deposited, and laser cutting may be performed in the opening 810.

The polymer layer 722 disposed at a side surface of the opening 810 may be exposed at the outside. An organic layer of the TFE layer 728 and the organic light emitting layer 726 may not be exposed because of penetration of moisture, and the organic light emitting layer 726 may be covered with an inorganic layer of the TFE layer 728. For example, when the opening 810 is formed in the touchscreen panel 720 and when an electric material such as the camera device 800 is mounted in the opening 810, the touchscreen panel 720 adjacent to the electric material may be adjacent to an inorganic layer of the TFE layer 728 and the polymer layer 722 and may not be adjacent to an organic layer of the TFE layer 728 and the organic light emitting layer 726.

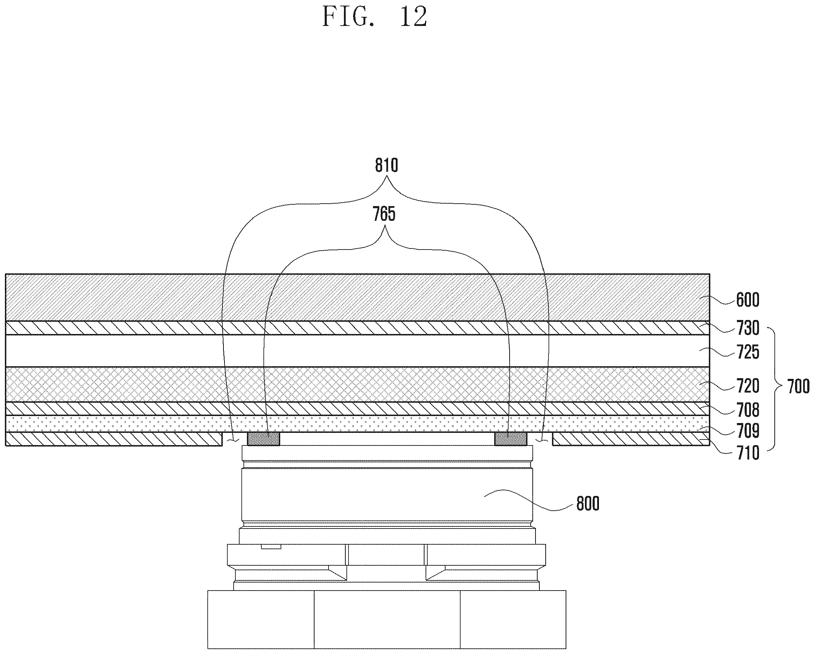

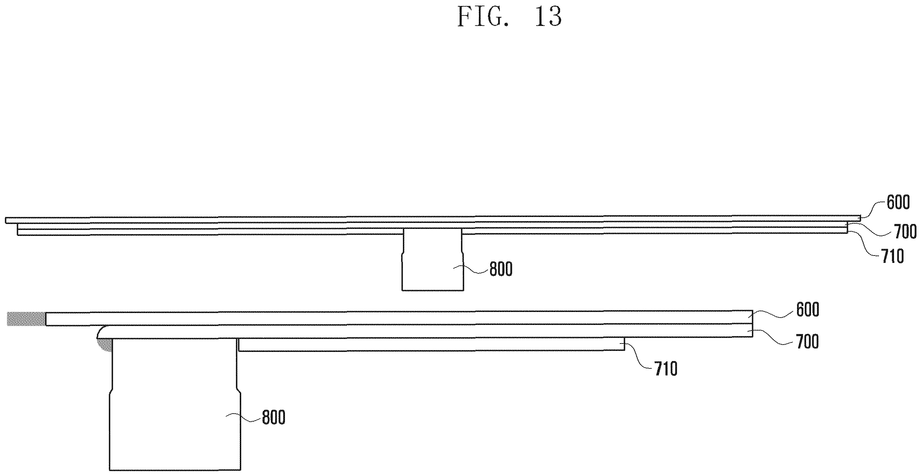

FIG. 12 is a cross-sectional view illustrating another example of an electronic device, according to an embodiment of the present disclosure. FIG. 13 is a diagram illustrating another example of an electronic device, according to an embodiment of the present disclosure.

As shown in FIGs. 12 and 13, an electronic device may include the transparent layer 600, the display 700, and the camera device 800 from an upper portion toward a lower portion.

The display 700 includes the first adhesive layer 710, the display panel 709, the third adhesive layer 708, the touchscreen panel 720, the polarization layer 725, and the second adhesive layer 730 from a lower portion toward an upper portion to configure an active area.

A configuration of FIGs. 12 and 13 is different from the configuration of FIG. 6A in only a position in which the camera device 800 is mounted at the opening 810.

By penetrating at least the first adhesive layer 710, the opening 810 may be formed. When the first surface 510 of the housing 500 of FIG. 6A is viewed from the top, the opening 810 may be positioned at least partially in an active area of the display panel 709. The camera device 800 may be mounted at the opening 810 that penetrates the first adhesive layer 710.

The opening 810 penetrates the first adhesive layer 710, but the organic light emitting layer 726 and the TFT layer 724 of the display panel 709 of FIGs. 10A to 10D may be selectively removed, and the camera device 800 may be mounted. Because a driving performance of the camera device 800 can be secured without removal of some segments of the display panel 709, when viewing an external appearance, a sense of difference due to a disconnection segment can be minimized.

At least one sponge 765 is mounted between the display panel 709 and the camera device 800 disposed at a lower portion of the display panel 709, and this can prevent dust from entering into a lens of the camera device 800, and an impact applied from the outside to the camera device 800 can be mitigated.

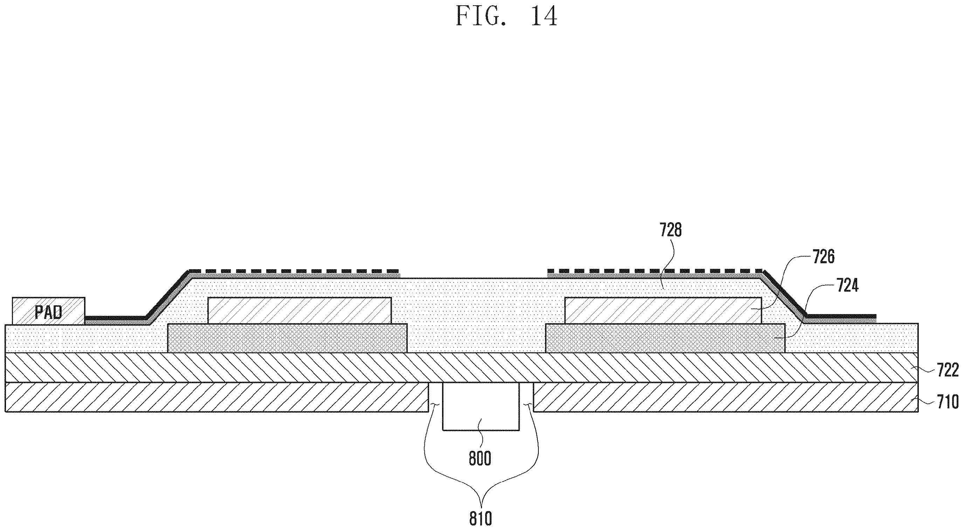

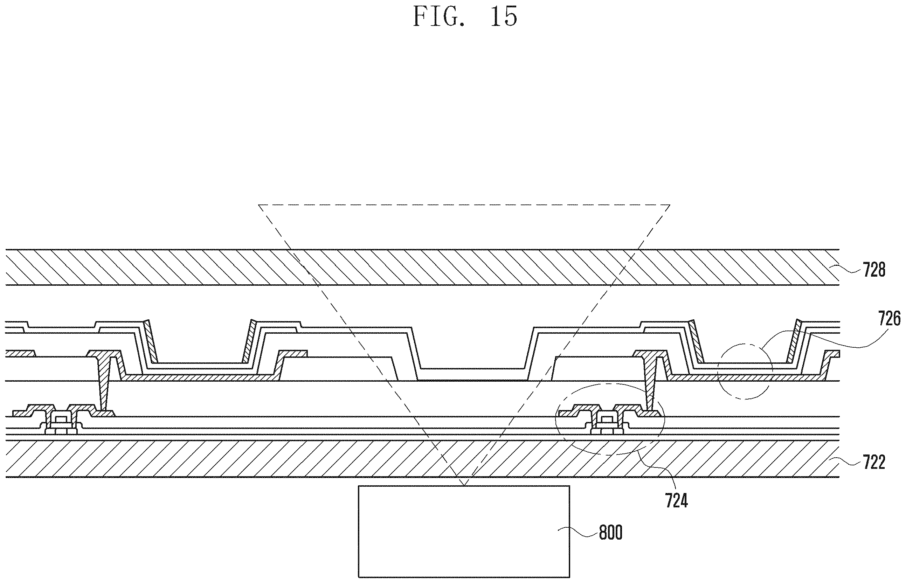

FIGs. 14 and 15 are cross-sectional views illustrating another example of an electronic device, according to an embodiment of the present disclosure.

As shown in FIGs. 14 and 15, the camera device 800 may be mounted in the opening 810 in which a portion of the first adhesive layer 710 is removed to face the polymer layer 722 of the touchscreen panel 720.

The display panel 709 may include the polymer layer 722, the TFT array 724, the organic light emitting layer 726, and the TFE layer 728 from a lower portion toward an upper portion.

The opening 810 may penetrate only to the first adhesive layer 710 instead of penetrating to the display panel 709. The camera device 800 may be mounted to face a rear surface of the polymer layer 722 of the display panel 709 in which transparency is secured. Only a portion of an FPCB that may be disposed at an upper portion of the second surface 520 of the housing 500 of FIG. 6A or at a lower portion of the polymer layer 722 may be punched and provided. The camera device 800 may face a rear surface of the polymer layer 722 in which transparency is secured through the punched portion. The display panel 709 including the polymer layer 722 may include an FPCB, which is a flexible layer including a bent portion curved along a side surface of the first surface 510 of the housing 500. The opening 810 may be at least partially overlapped with the bent portion.

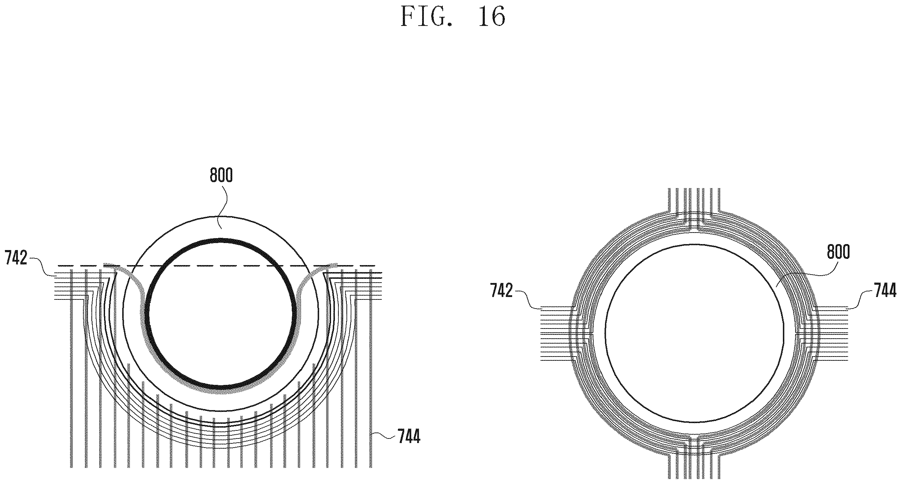

FIG. 16 is a diagram illustrating a disposition structure of a conductive line of an electronic device, according to an embodiment of the present disclosure.

As shown in FIGs. 7A and 7B, when a portion of the display 700 is removed by a U-cut or punching, a rear surface of the polymer layer 722 and a portion of the FPCB may be removed. With reference to FIG. 16, the conductive line 740 including a scan line 742 and a data line 744 may be bent and disposed at a periphery of the camera device 800. When the opening 810 is formed in a portion of the polymer layer 722 in which the camera device 800 is mounted, in order to secure transparency of the camera device 800, the conductive line 740 may be designed to avoid an angle of view of the camera device 800.

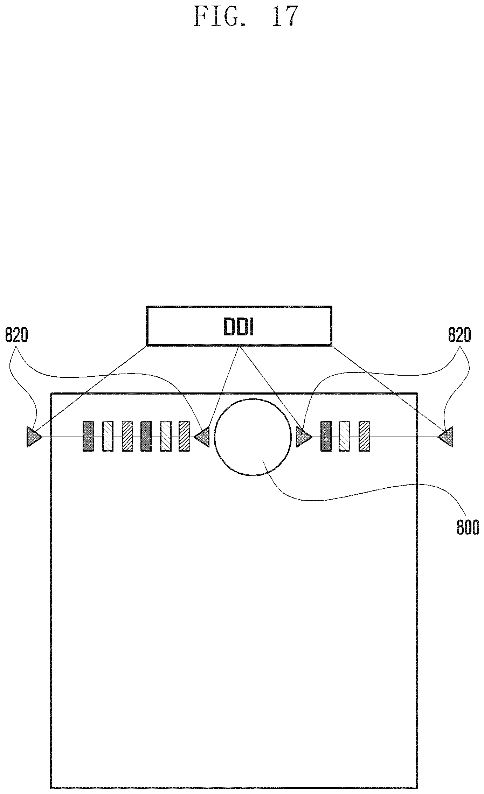

FIG. 17 is a diagram illustrating a disposition structure of a power drive of an electronic device, according to an embodiment of the present disclosure.

When the opening 810 is formed in a portion of the polymer layer 722, in a portion in which the polymer layer 722 of both sides of the camera device 800 is removed, at least one power drive 820 may be formed. The power drive 820 may include a scan line driver, data line driver, power unit, and timing controller.

As shown in FIG. 6A, in order to provide image data to the display 700, the conductive line 740 may include, for example, an IC such as a DDI.

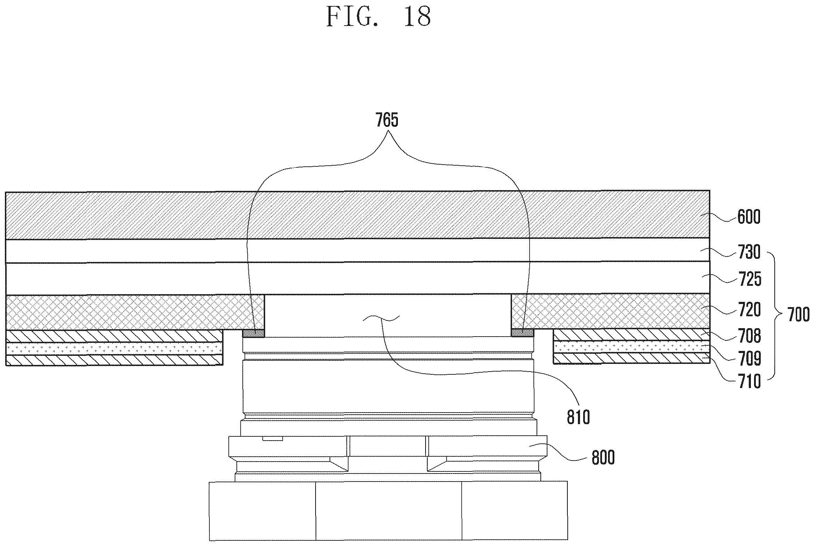

FIG. 18 is a cross-sectional view illustrating another example of an electronic device, according to an embodiment of the present disclosure.

As shown in FIG. 18, an electronic device may include the transparent layer 600, the second adhesive layer 730, the polarization layer 725, the touchscreen panel 720, the third adhesive layer 708, the display panel 709, the first adhesive layer 710, and the camera device 800 from an upper portion toward a lower portion.

A configuration of FIG. 18 is different from that of FIG. 6A in only a position in which the camera device 800 is mounted in the opening 810.

The opening 810 may be further extended through at least a portion of the first adhesive layer 710, the display panel 709, the third adhesive layer 708, and the touchscreen panel 720. The camera device 800 may be mounted in the opening 810 penetrating to the touchscreen panel 720. The opening 810 may be further extended through the touchscreen panel 720, but it may not penetrate the polarization layer 725.

At both ends of the opening 810 of the display panel 709, a TFE layer may be included. At least one sponge 765 is mounted between the TFE layer formed at both ends of the display panel 709 and the camera device 800 to prevent dust from entering into a lens of the camera device 800 and to mitigate an impact applied from the outside to the camera device 800.

A TFE layer is formed at both ends of the opening 810 of the display panel 709, but a TFE layer may not be formed at both ends of the opening 810 of the display panel 709 and at least one sponge 765 may be mounted.

In FIG. 18, an example in which the opening 810 penetrates to the touchscreen panel 720 is described, but the opening 810 may be further extended through the polarization layer 725.

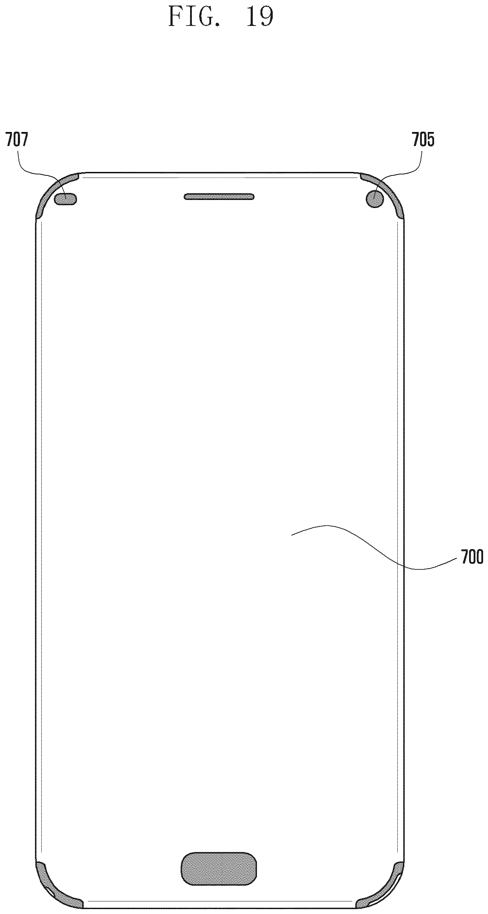

FIG. 19 is a diagram illustrating an example in which a device is mounted at a corner portion of an electronic device, according to an embodiment of the present disclosure.

When an active area of the display 700 is not disposed at a portion of a corner portion of the electronic device, the sensor hole 707 and the hole 705 of the camera device 800 may be disposed at the corner portion. The hole 705 of the camera device 800 may be disposed to correspond to the camera device 800 that photographs an image and a moving picture of the front side of the electronic device. At least one sensor hole 707 may be included at a predetermined position within the electronic device and be disposed to correspond to a sensor that measures a physical quantity or detects an operation state of the electronic device and that converts measured or detected information to an electric signal. The sensor may include at least one of a fingerprint sensor, haptic sensor, vibration sensor, pressure sensor, gesture sensor, proximity sensor, grip sensor, gyro sensor, acceleration sensor, terrestrial magnetic sensor, atmospheric pressure sensor, temperature/humidity sensor, hole sensor, Red, Green, and Blue (RGB) sensor, illumination sensor, bio sensor, and a UV sensor.

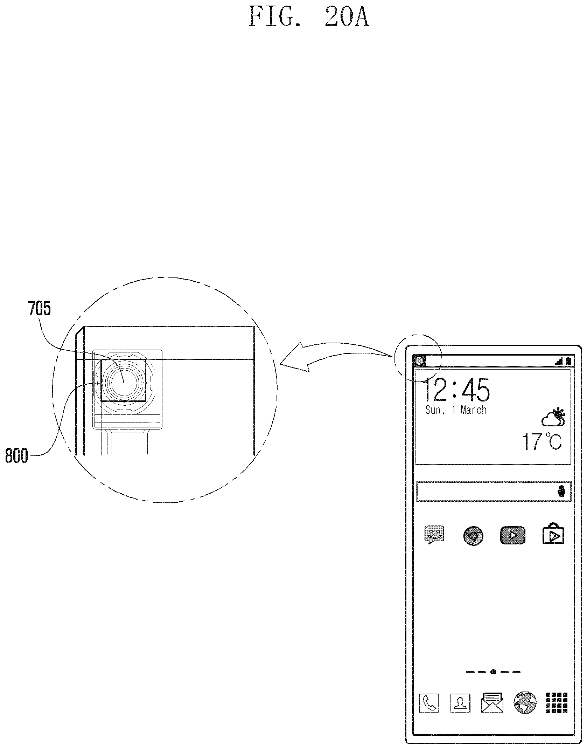

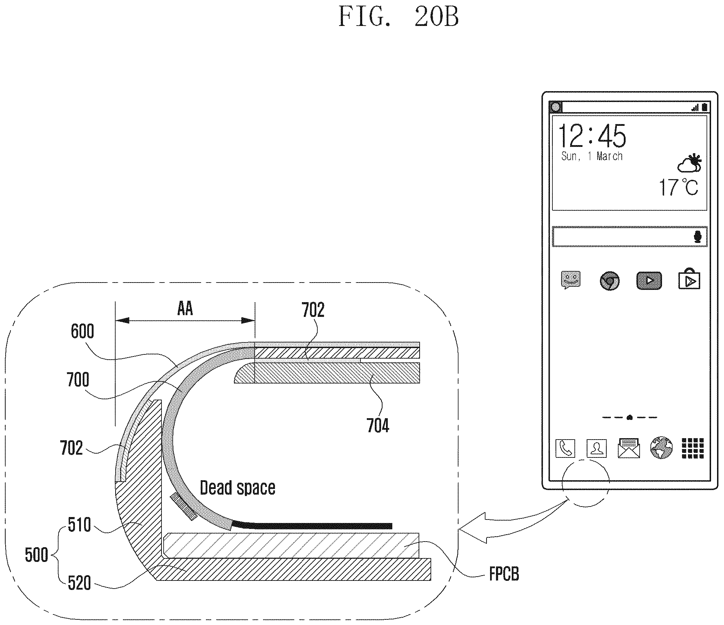

FIGs. 20A and 20B are diagrams illustrating an example in which a device is mounted at a corner portion of the electronic device and an example in which a display is bent and disposed at a side surface of the electronic device, according to an embodiment of the present disclosure.

As shown in FIG. 20A, the hole 705 of the camera device 800 may be disposed at one side of a state bar of the electronic device.

As shown in FIG. 20B, the transparent layer 600 may be extended from a front surface of the electronic device and be bent in a lower direction. The extended transparent layer 600 may be attached to the outside of the first surface 510 of the housing 500 through a double-sided tape 702. The display 700 may be extended from a front surface of the electronic device and be bent in a lower direction. The extended display 700 may be coupled to the FPCB disposed at an upper portion of the second surface 520 of the housing 500. When the display 700 is formed at a side surface of the electronic device, as shown in a line AA of FIG. 20B, an active area of the display 700 may be extended, and a dead space area of the electronic device may be reduced. The display 700 disposed at a front surface may be attached to a device such as a bracket 704 within the electronic device through the double-sided tape 702.

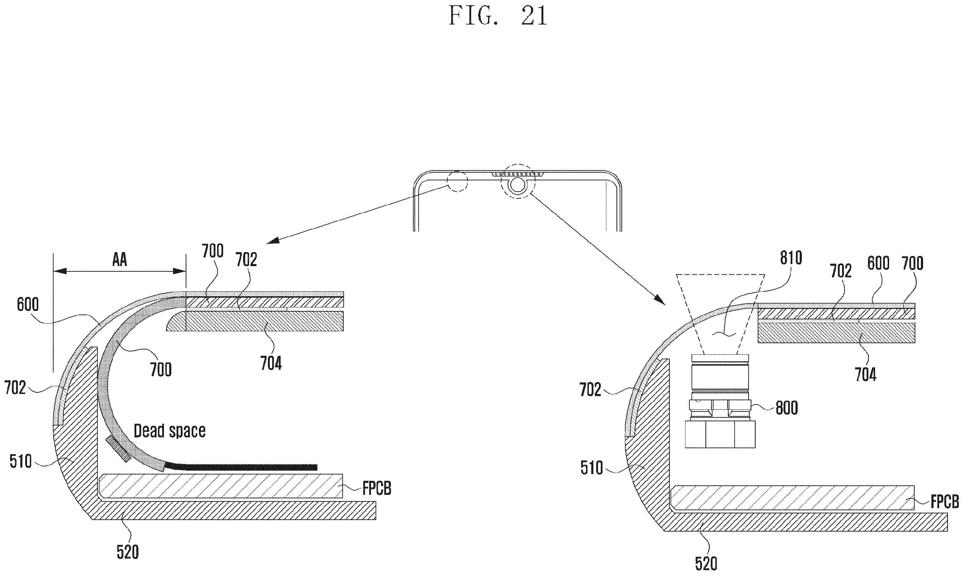

FIG. 21 is a diagram illustrating an example in which a camera device is mounted at an opening 810 formed in a central portion of an electronic device, according to an embodiment of the present disclosure.

As shown in FIG. 21 (and FIG. 20B), the transparent layer 600 may include a curved portion extended from a front surface of the electronic device and bent in a lower direction. The extended transparent layer 600 may be attached to the outside of the first surface 510 of the housing 500 through the double-sided tape 702. The display 700 may include a curved portion extended from a front surface of the electronic device and bent in a lower direction. The extended display 700 may be coupled to the FPCB that may be disposed at an upper portion of the second surface 520 of the housing 500.

The opening 810 may be extended through the bracket 704, the double-sided tape 702, and the display 700. The camera device 800 may be mounted at the penetrating opening 810 and come in close contact with the transparent layer 600. The camera device 800 may be mounted at a dead space portion. Thereby, an active area (AA of FIG. 21) of the display 700 may be extended.

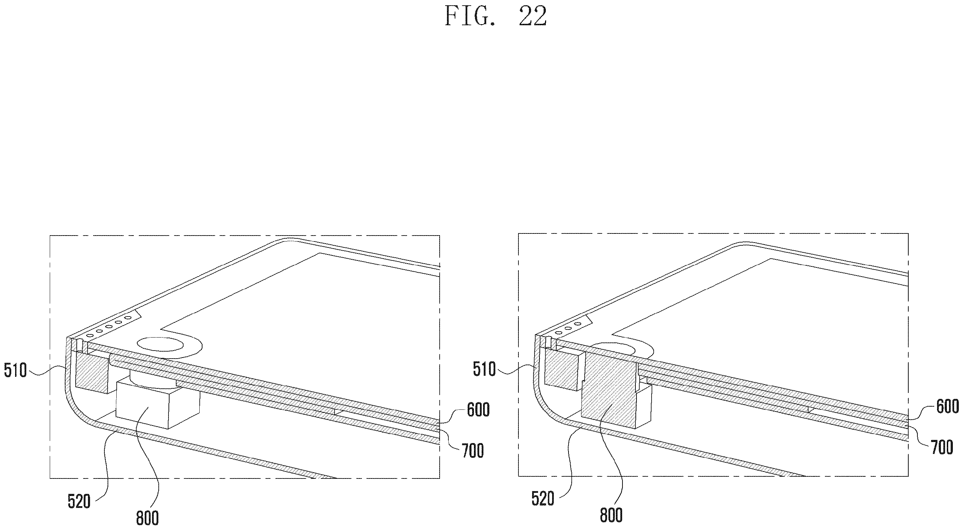

FIG. 22 is a diagram illustrating a mounting structure of a camera device 800 of an electronic device, according to an embodiment of the present disclosure.

As shown in FIG. 22, at a segment in which the display 700 is overlapped with an electric material (e.g., sensor) such as the camera device 800, by escaping or removing the FPCB connected to the display 700 or a partial layer (e.g., the polymer layer 722 of the display panel 709) or an entire layer of the display 700, an electric material such as the camera device 800 may be disposed. A portion of the active area of the display 700 may be removed.

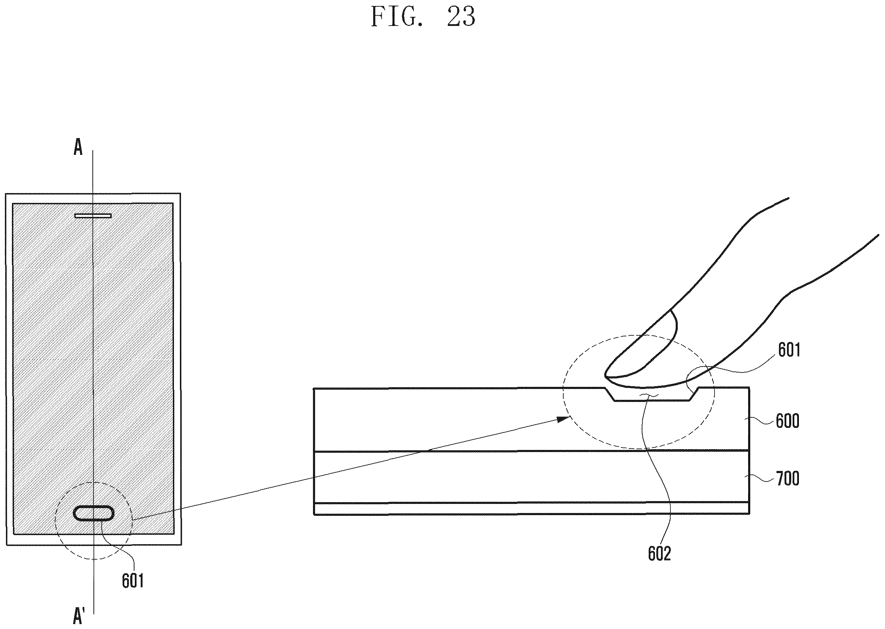

FIG. 23 is a diagram illustrating a state in which a groove is formed by removing a portion of the transparent layer 600 in an electronic device, according to an embodiment of the present disclosure.

By removing a portion of the transparent layer 600 corresponding to an area of a home key 601 of the electronic device, a groove 602 may be formed. By removing a partial area of the transparent layer 600, the groove 602 is formed, thereby providing a position for a specific function, e.g., the home key 601) that may be easily displayed to the user. By removing a portion of the transparent layer 600, when the groove 602 is formed, an area in which a user finger contacts the transparent layer 600 may increase, and a thickness thereof is smaller than that of other areas of the transparent layer 600; thus, a signal transferred to the display 700 may be sensitively received. When the groove 602 is formed in the transparent layer 600, a vibration can be transferred through the haptic element that may be included within the electronic device may be amplified.

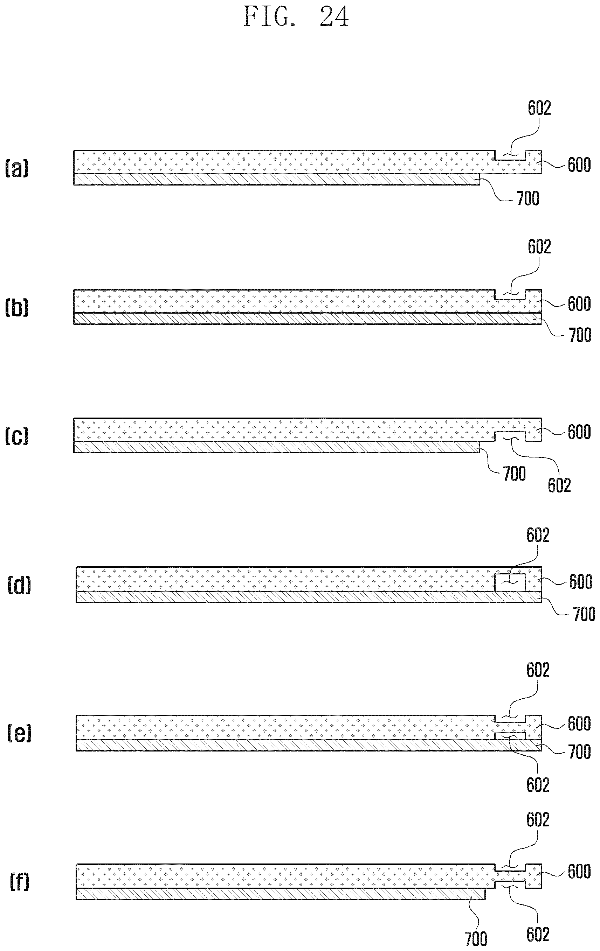

FIG. 24 is a diagram illustrating various examples in which the groove 602 is formed by removing a portion of the transparent layer 600 in an electronic device, according to an embodiment of the present disclosure.

As shown in FIG. 24 (at (a) and (b)), the groove 602 formed by removing a portion of the transparent layer 600 may be formed at an upper portion of one side of the transparent layer 600. A portion of the display 700 disposed at a lower portion of the transparent layer 600 in which the groove 602 is formed may be removed or may not be removed.

As shown in FIG. 24 (at (c)), the groove 602 formed by removing a portion of the transparent layer 600 may be formed at a lower portion of one side of the transparent layer 600. A portion of the display 700 disposed at a lower portion of the transparent layer 600 in which the groove 602 is formed may be removed. At the groove 602 formed at the transparent layer 600, the camera device 800, haptic element, and fingerprint sensor may be disposed.

As shown in FIG. 24 (at (d)), the groove 602 may be formed at a lower portion of one side of the transparent layer 600. In this case, a portion of the display 700 disposed at a lower portion of the transparent layer 600 in which the groove 602 is formed may not be removed.

As shown in FIG. 24 (at (e) and (f)), the groove 602 formed by removing a portion of the transparent layer 600 may be formed at an upper portion and a lower portion of one side of the transparent layer 600. In this case, a portion of the display 700 disposed at a lower portion of the transparent layer 600 in which the groove 602 is formed may be removed or may not be removed.

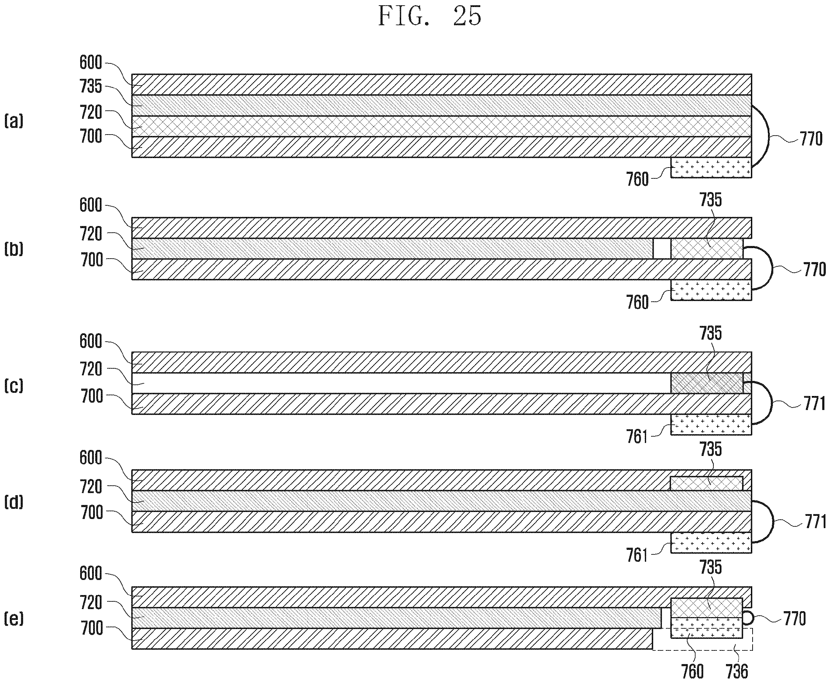

FIG. 25 is a diagram illustrating various examples in which a fingerprint sensor 735 is disposed at the inside of an electronic device, according to an embodiment of the present disclosure.

As shown in FIG. 25 (at (a)), the fingerprint sensor 735 may be disposed at an upper portion of the touchscreen panel 720. In the transparent layer 600, the groove 602 may not be formed. By disposing the fingerprint sensor 735 in an entire area of a lower portion of the transparent layer 600, even if the user touches any area of the transparent layer 600, the fingerprint sensor 735 may sense a user fingerprint simultaneously with the touch. Further, the fingerprint sensor 735 may be connected to an IC 760 that controls the fingerprint sensor 735 through an FPCB 770, and the IC 760 may be disposed at a lower portion of the display 700. An active area of the display 700 may be prevented from being covered because of an IC 760 connected to the fingerprint sensor 735.

As shown in FIG. 25 (at (b)), the fingerprint sensor 735 may be disposed at a predetermined area of the touchscreen panel 720 whose portion is removed. By disposing the fingerprint sensor 735 in a predetermined area of a lower portion of the transparent layer 600, when the user touches a predetermined area of the transparent layer 600, the fingerprint sensor 735 may sense a user fingerprint simultaneously with the touch. Further, the fingerprint sensor 735 may be connected to the IC 760 that controls the touchscreen sensor 735 through the FPCB 770, and the IC 760 may be disposed at a lower portion of the display 700. An active area of the display 700 may be prevented from being covered because of the IC 760 connected to the fingerprint sensor 735.

As shown in FIG. 25 (at (c)), the fingerprint sensor 735 may be together formed in a partial area of the touchscreen panel 720. By disposing the fingerprint sensor 735 in a predetermined area of a lower portion of the transparent layer 600, when the user touches a predetermined area of the transparent layer 600, the fingerprint sensor 735 may sense a user fingerprint simultaneously with the touch. Further, the fingerprint sensor 735 may be together controlled through the IC 761 that controls the touchscreen panel 720, and the IC 761 may be connected through an FPCB 771 to be disposed at a lower portion of the display 700. An active area of the display 700 may be prevented from being covered because of the IC 761 connected to the fingerprint sensor 735.

As shown in FIG. 25 (at (d)), the fingerprint sensor 735 may be disposed in a predetermined area of the transparent layer 600 whose portion is removed. By r disposing the fingerprint sensor 735 in a predetermined area of the transparent layer 600, when the user touches a predetermined area of the transparent layer 600, the fingerprint sensor 735 may sense a user fingerprint simultaneously with the touch. Further, the fingerprint sensor 735 may be together controlled through the IC 761 that controls the touchscreen panel 720, and the IC 761 may be connected through the FPCB 771 to be disposed at a lower portion of the display 700. An active area of the display 700 may be prevented from being covered because of the IC 761 connected to the fingerprint sensor 735.

As shown in FIG. 25 (at (e)), by cutting a portion of the display 700, a cutting area 736 is formed, and the fingerprint sensor 735 may be disposed on the cutting area 736. When the user touches a predetermined area of the transparent layer 600, the fingerprint sensor 735 disposed at the cutting area 736 may be touched to sense a user fingerprint. Further, the fingerprint sensor 735 may be connected to the IC 760 that controls the fingerprint sensor 735 through the FPCB 770, and the IC 760 may be disposed at an upper portion of the cutting area 736, which is an upper portion of the display 700. A layered thickness of a portion of the IC 760 connected to the fingerprint sensor 735 may be reduced.

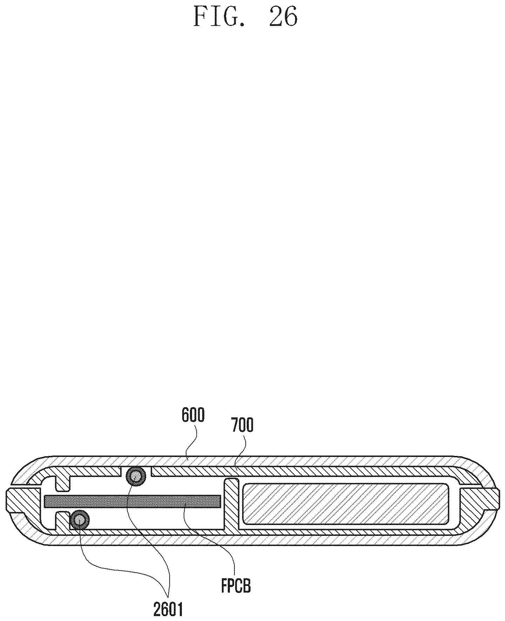

FIG. 26 is a diagram illustrating examples in which a haptic element 2601 is disposed at the inside of an electronic device, according to an embodiment of the present disclosure.

A haptic element 2601 may be disposed at a partial area of the display 700 whose portion is removed. A vibration of a partial area of the transparent layer 600 in which the haptic element 2601 is disposed may be larger than that of other areas in which the haptic element 2601 is not disposed. The haptic element 2601 may be disposed on a peripheral device or an electric material such as an FPCB connected to the display 700.

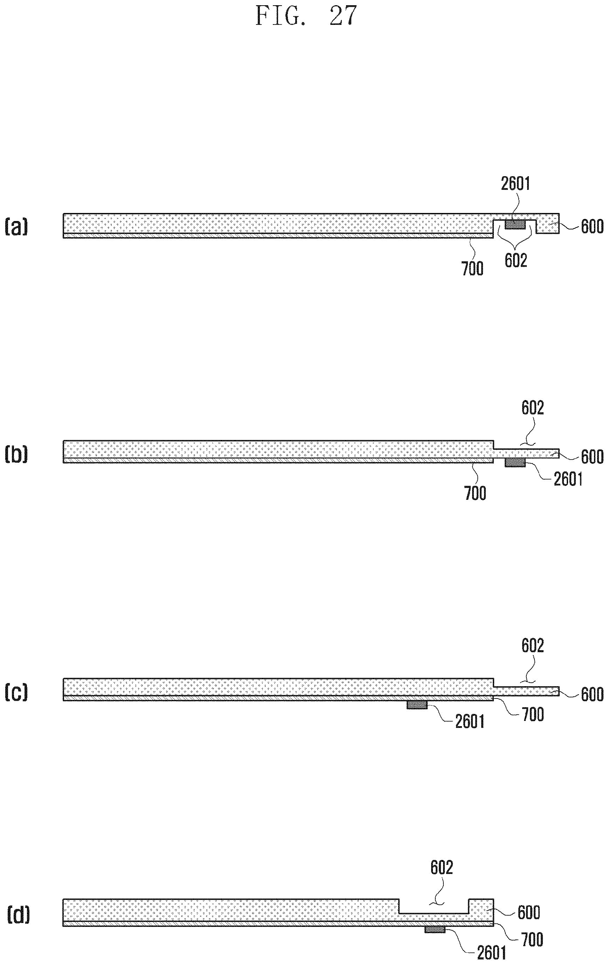

FIG. 27 is a diagram illustrating various examples in which the haptic element 2601 is disposed at the inside of an electronic device, according to an embodiment of the present disclosure.

As shown in FIG. 27 (at (a)), at a lower portion of one side of the transparent layer 600, the groove 602 may be formed. The haptic element 2601 is disposed within the groove 602 formed at a lower portion of one side of the transparent layer 600 to transfer a larger vibration to the user.

As shown in FIG. 27 (at (b)), at an upper portion of one side of the transparent layer 600, the groove 602 may be formed. The haptic element 2601 is disposed at a lower portion of the groove 602 formed at an upper portion of one side of the transparent layer 600 to transfer a larger vibration to the user.

As shown in FIG. 27 (at (c)), the haptic element 2601 may be disposed at a lower portion of the display 700.

As shown in FIG. 27 (at (d)), at an upper portion of one side of the transparent layer 600, the groove 602 may be formed. The haptic element 2601 is disposed at a lower portion of the display 700 disposed at a lower portion of the groove 602 formed at an upper portion of one side of the transparent layer 600 to transfer a larger vibration to a user.

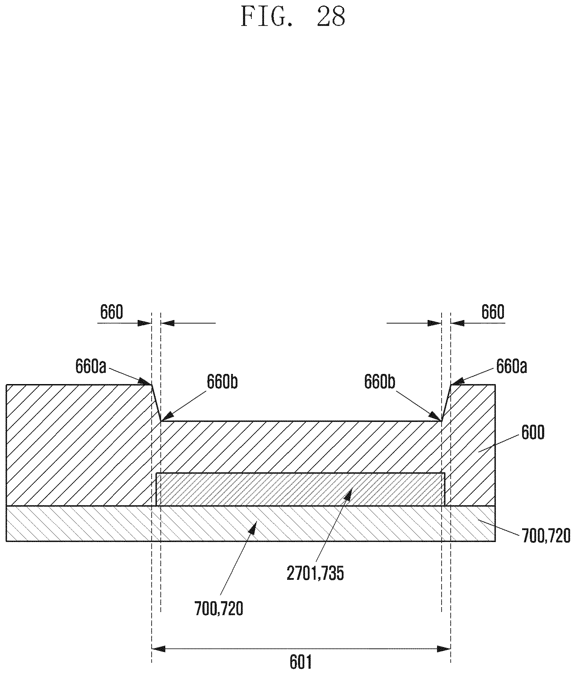

FIGs. 28 to 30 are diagrams illustrating various examples of securing a mounting space of an electronic device, according to an embodiment of the present disclosure.

As shown in FIG. 28, by forming the groove 602 at a portion corresponding to the home key 601 included in a partial area of the transparent layer 600 and by disposing the haptic element 2701 at a corresponding portion of a lower portion of the formed groove 602, a larger vibration may be transferred to the user. Further, by adjusting a refraction shape (refractive index) through grinding (surface roughness) of an inclined surface (or the other surface) 660 of the home key 601, a refractive index of light that transmits the inclined surface 660 may be changed. Further, an interface of the fingerprint sensor 735 and the display 700 or the touchscreen panel 720 may be positioned between one end 660a and the other end 660b of the inclined surface 660, and a boundary line of an additional display, sensor, and various films that may be provided along a home key shape at a rear surface of the transparent layer 600 may be covered. Because specific decoration and pattern may be added to such an inclined surface 660, an internal covering effect or an esthetic effect of the boundary line may be given.

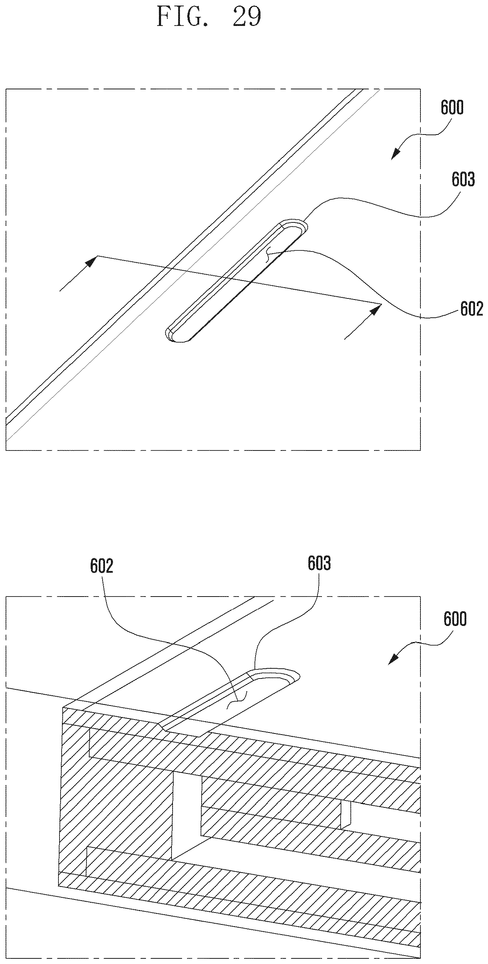

As shown in FIG. 29, by forming the groove 602 at a portion corresponding to a receiver hole 603 included in a partial area of the transparent layer 600 and by disposing a speaker at a corresponding portion of the formed groove 602, a larger audio signal may be transferred to the user.

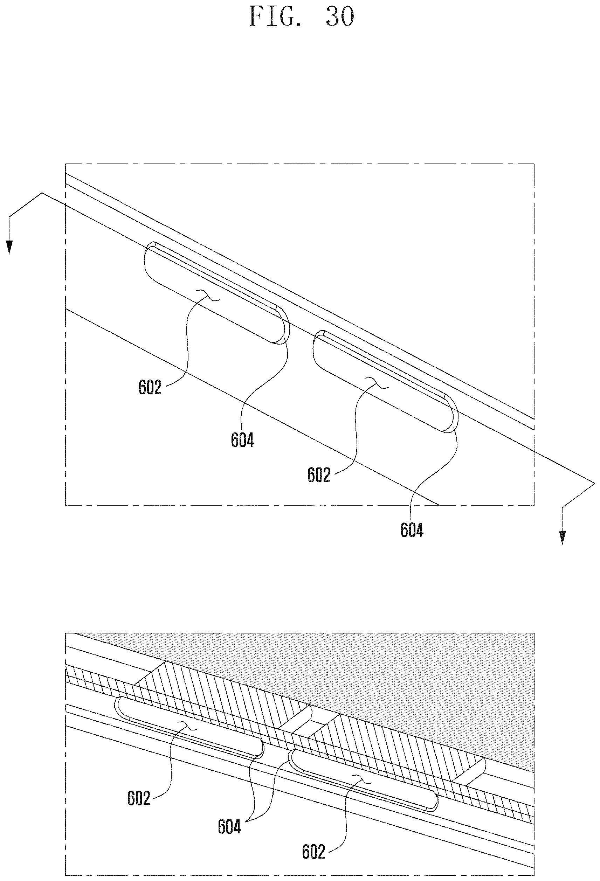

As shown in FIG. 30, at a portion corresponding to a side key 604 of the electronic device, the groove 602 may be formed, and at a corresponding portion of the formed groove 602, function keys such as a volume adjustment key and a power button may be disposed.

A dead space area may be reduced within an active area of the display module included in the electronic device, and an active area of the display module may be extended.

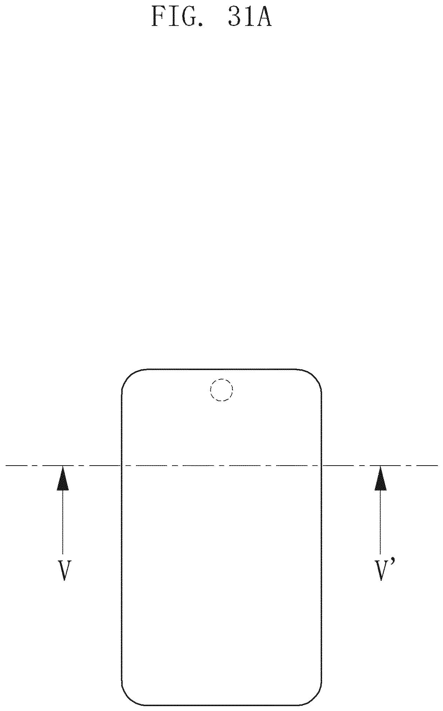

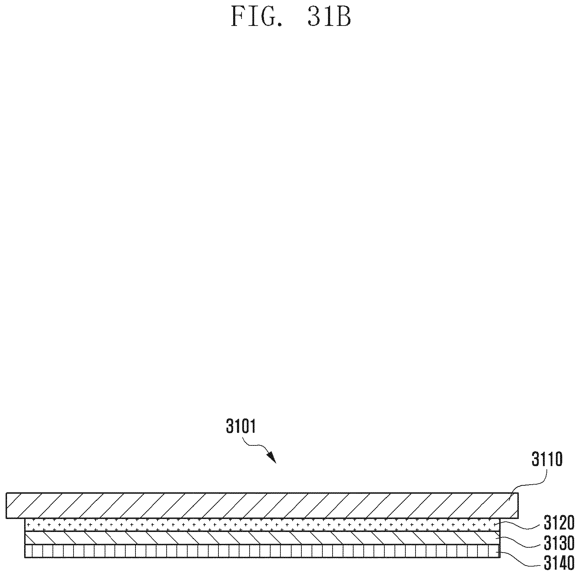

FIG. 31A is a front view illustrating an electronic device, according to an embodiment of the present disclosure. FIGs. 31B to 31I are cross-sectional views illustrating the electronic device taken along line V-V' of FIG. 31A.

As shown in FIG. 31B, an electronic device 3101 may include a transparent layer 3110, touchscreen panel 3120, display panel 3130, and pressure sensor 3140. The pressure sensor 3140 may replace a physical key. That is, because the display panel 3130 is disposed at a front surface, an existing physical key may be omitted, and the pressure sensor 3140 may replace a physical key. The pressure sensor 3140 may be provided in various forms in a shape, a size, or number. The pressure sensor 3140 may be transparently provided not to be viewed from the outside. Further, the pressure sensor 3140 may be opaquely formed. The pressure sensor 3140 may be disposed at a rear surface of the display panel 3130.

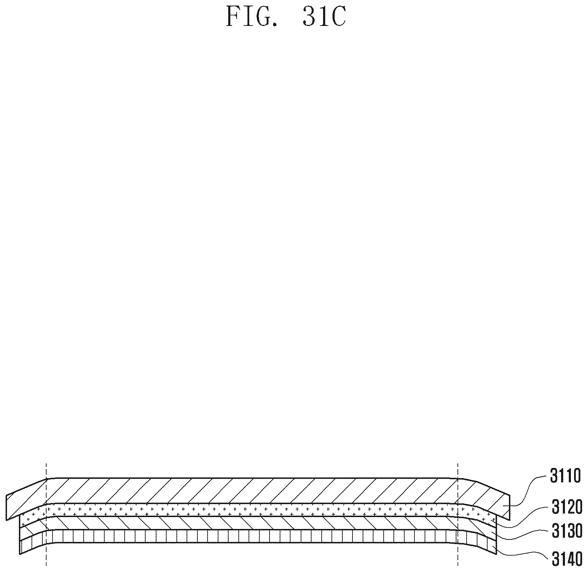

As shown in FIG. 31C, at least one side surface of the transparent layer 3110, the touchscreen panel 3120, the display panel 3130, and the pressure sensor 3140 may have a bent shape. One side surface of the transparent layer 3110, the touchscreen panel 3120, the display panel 3130, and the pressure sensor 3140 may be bent from a front surface. The transparent layer 3110, the touchscreen panel 3120, the display panel 3130, and the pressure sensor 3140 may include a curved surface. At least one side surface of the transparent layer 3110, the touchscreen panel 3120, the display panel 3130, and the pressure sensor 3140 may include a curved surface.

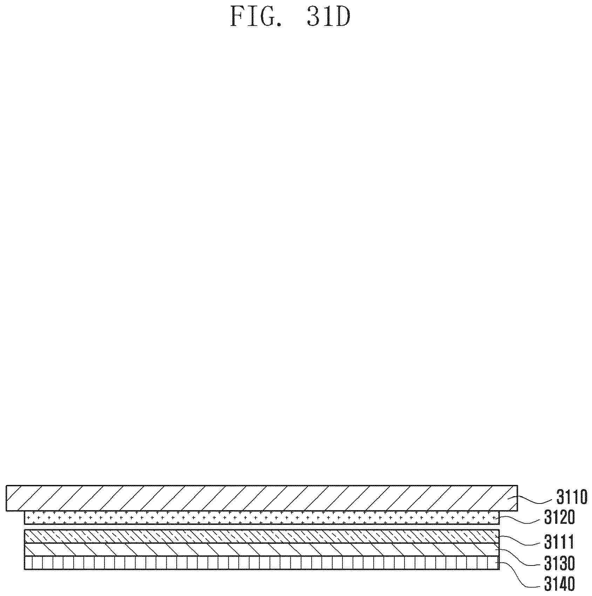

As shown in FIG. 31D, the touchscreen panel 3120 may be integrally formed on the transparent layer 3110. That is, configurations of the touchscreen panel 3120 may be formed on the transparent layer 3110. At a lower portion of the transparent layer 3110 in which the touchscreen panel 3120 is integrally formed, the display panel 3130 may be disposed. The transparent layer 3110 and the display panel 3130 may be bonded by a first adhesive layer 3111. At a lower portion of such a display panel 3130, the pressure sensor 3140 may be disposed.

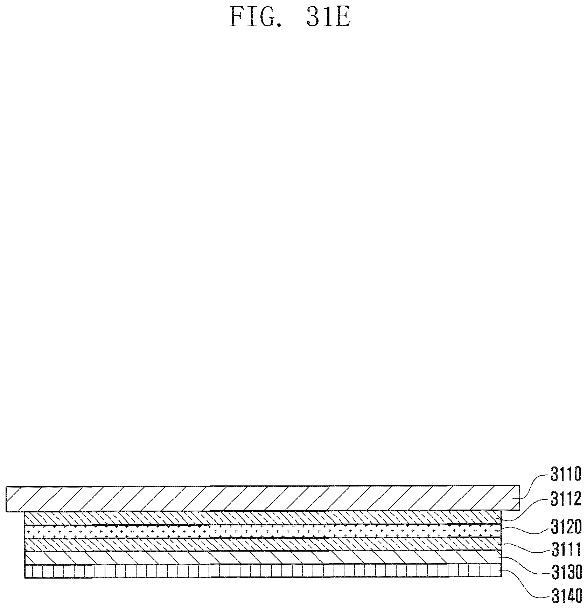

As shown in FIG. 31E, at a lower portion of the transparent layer 3110, the touchscreen panel 3120 may be separately disposed, and the transparent layer 3110 and the touchscreen panel 3120 may be bonded by a second adhesive layer 3112. At a lower portion of the touchscreen panel 3120, the display panel 3130 may be disposed. The touchscreen panel 3120 and the display panel 3130 may be bonded by the first adhesive layer 3111. At a lower portion of such a display panel 3130, the pressure sensor 3140 may be disposed.

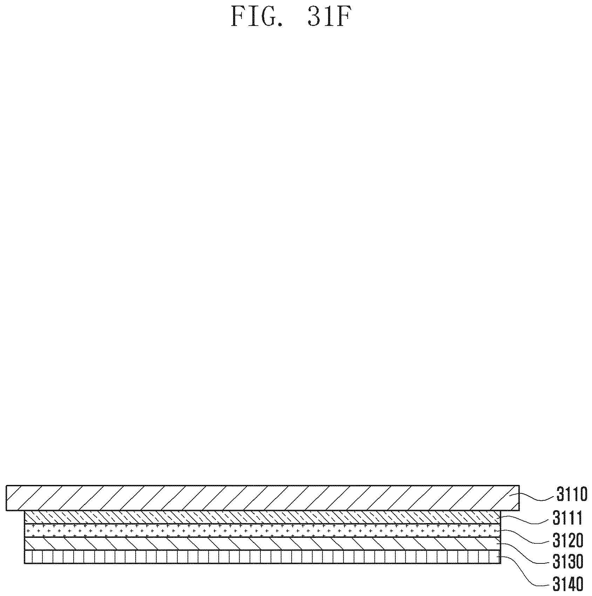

As shown in FIG. 31F, the touchscreen panel 3120 may be integrally formed on the display panel 3130. That is, configurations of the touchscreen panel 3120 may be formed on the display panel 3130. The transparent layer 3110 and the integral display panel 3130 of the touchscreen panel 3120 may be bonded by the first adhesive layer 3111. At a lower portion of such a display panel 3130, the pressure sensor 3140 may be disposed.

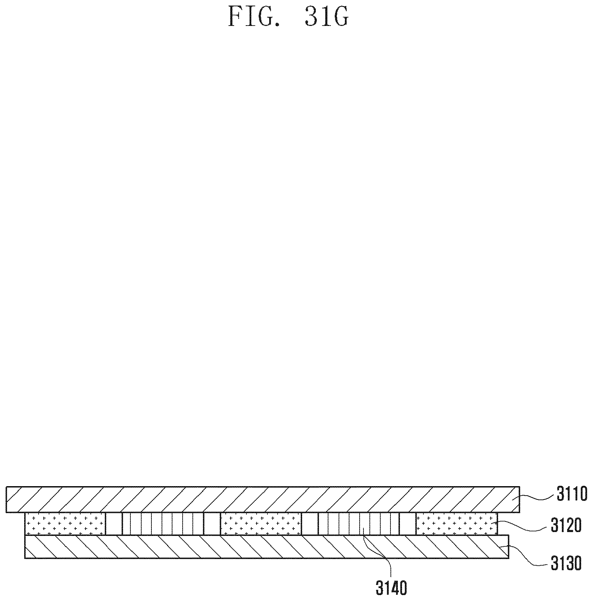

As shown in FIG. 31G, the pressure sensor 3140 and the touchscreen panel 3120 may be disposed at the same layer. For example, configurations of the pressure sensor 3140 and the touchscreen panel 3120 may be formed on the display panel 3130. That is, the pressure sensor 3140 and the touchscreen panel 3120 may be integrally formed on the display panel 3130. Configurations of the pressure sensor 3140 and the touchscreen panel 3120 may be alternately disposed.

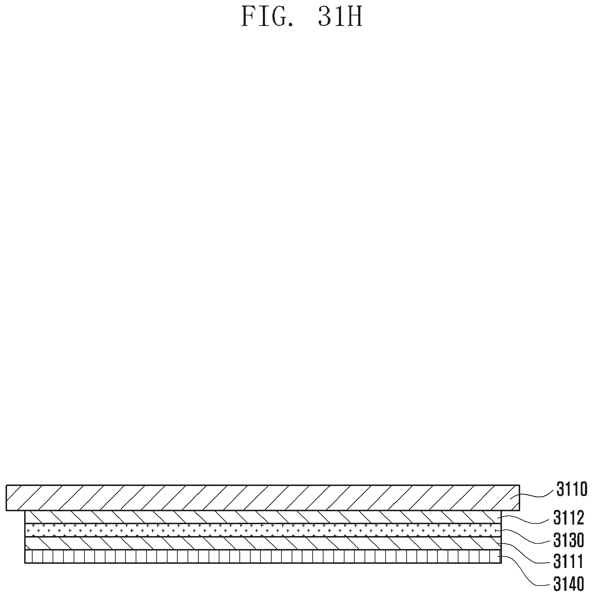

As shown in FIG. 31H, the touchscreen panel may be formed within the display panel 3130. That is, configurations of the touchscreen panel may be housed within the display panel 3130. The transparent layer 3110 and the integral touchscreen panel of the display panel 3130 may be bonded by the second adhesive layer 3112. At a lower portion of such a display panel 3130, the pressure sensor 3140 may be disposed. The display panel 3130 and the pressure sensor 3140 may be bonded by the first adhesive layer 3111.

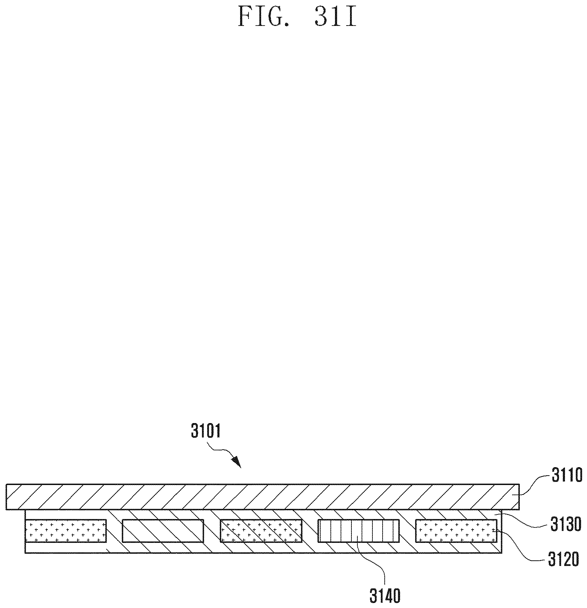

As shown in FIG. 31I, the pressure sensor 3140 and the touchscreen panel 3120 may be disposed within the display panel 3130. That is, configurations of the pressure sensor 3140 and the touchscreen panel 3120 may be housed within the display panel 3130. Thereby, a thickness of the electronic device 3101 may be reduced.

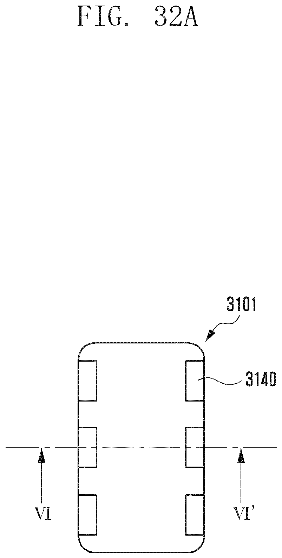

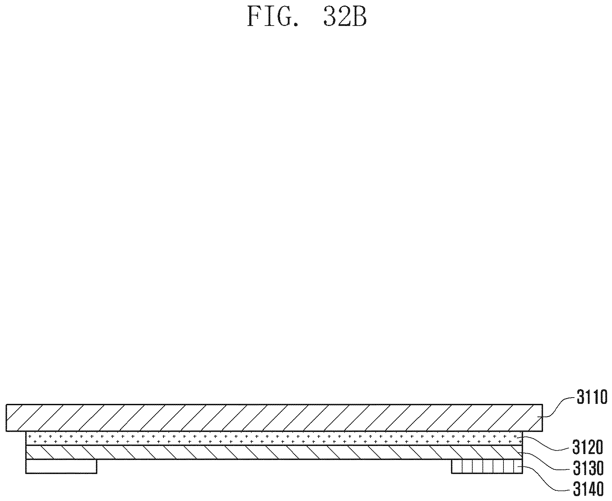

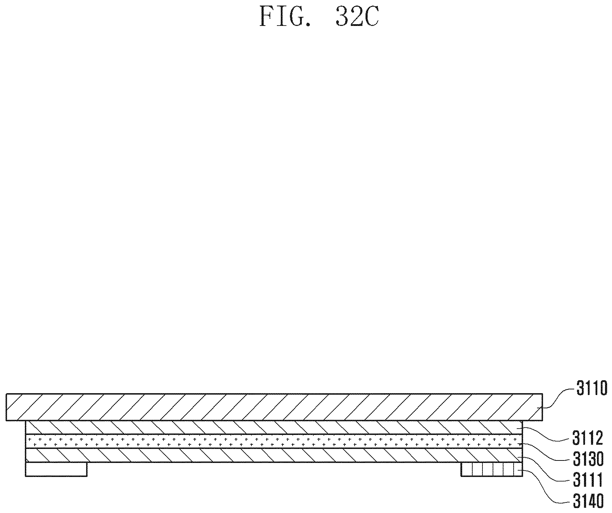

FIG. 32A is a front view illustrating an electronic device, according to an embodiment of the present disclosure. FIGs. 32B and 32C are cross-sectional views illustrating the electronic device taken along line VI-VI' of FIG. 32A.

As shown in FIG. 32A, the pressure sensor 3140 of the present disclosure may be disposed in only a partial area of the electronic device 3101. For example, the pressure sensor 3140 may be disposed at a side surface of the electronic device 3101. As shown in FIG. 32B, the electronic device 3101 may include the transparent layer 3110, the touchscreen panel 3120, the display panel 3130, and the pressure sensor 3140. At a side surface of the electronic device 3101, the pressure sensor 3140 may replace a physical key.

As shown in FIG. 32C, the touchscreen panel may be formed within the display panel 3130. That is, configurations of the touchscreen panel may be housed within the display panel 3130. The transparent layer 3110 and the integral display panel 3130 of the touchscreen panel may be bonded by the second adhesive layer 3112. At a lower portion of such a display panel 3130, the pressure sensor 3140 may be disposed. The display panel 3130 and the pressure sensor 3140 may be bonded by the first adhesive layer 3111.

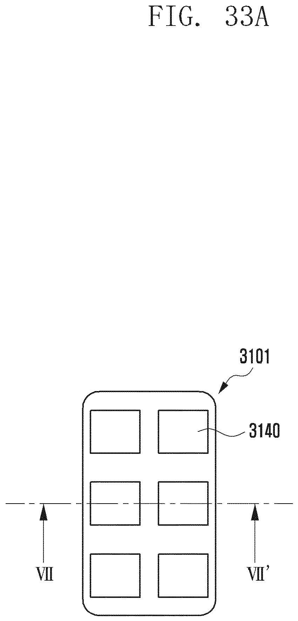

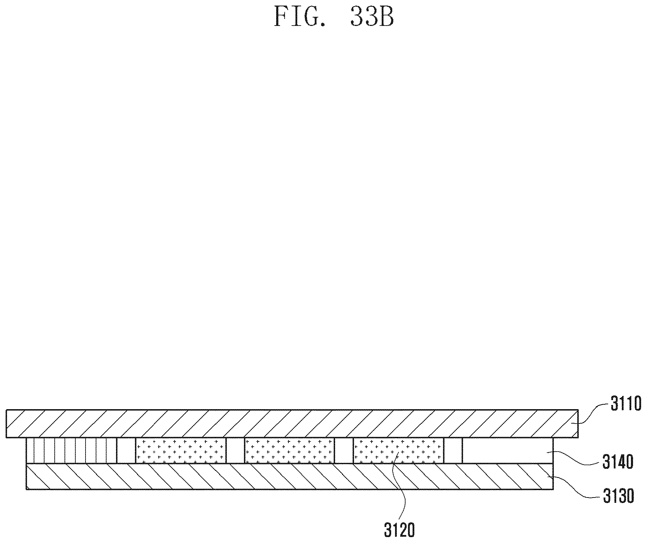

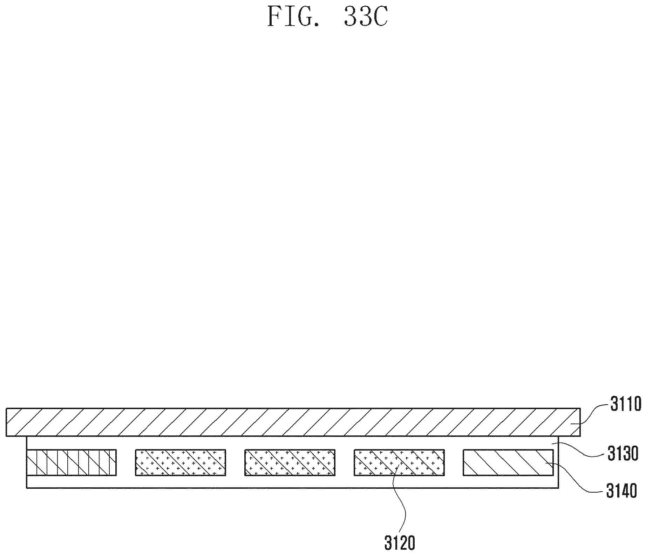

FIG. 33A is a front view illustrating an electronic device, according to an embodiment of the present disclosure. FIGs. 33B and 33C are cross-sectional views illustrating the electronic device taken along line VII-VII' of FIG. 33A.

As shown in FIG. 33A, the pressure sensor 3140 may be disposed at a partial area of the electronic device 3101. As shown in FIG. 33B, the pressure sensor 3140 and the touchscreen panel 3120 may be disposed at the same layer. For example, configurations of the pressure sensor 3140 and the touchscreen panel 3120 may be formed on the display panel 3130. That is, the pressure sensor 3140 and the touchscreen panel 3120 may be integrally formed on the display panel 3130.

As shown in FIG. 33C, the pressure sensor 3140 and the touchscreen panel 3120 may be disposed within the display panel 3130. That is, configurations of the pressure sensor 3140 and the touchscreen panel 3120 may be housed within the display panel 3130.

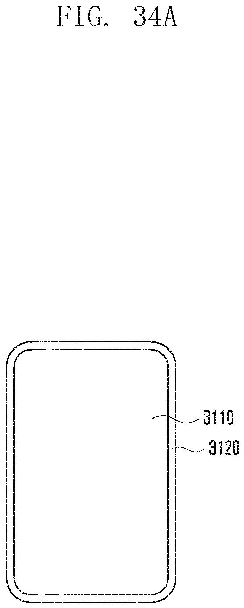

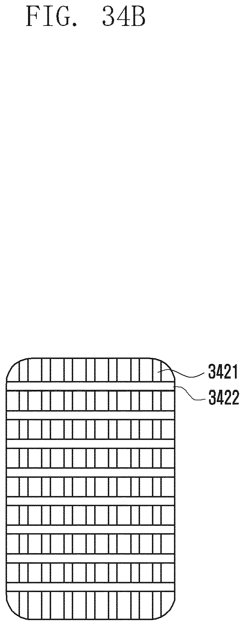

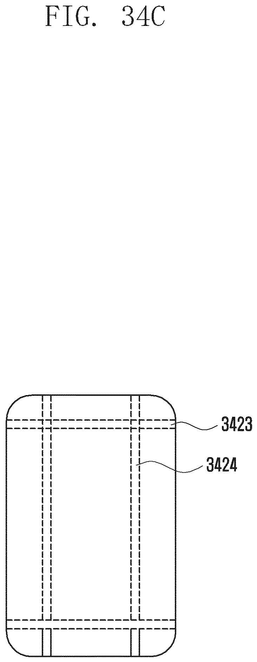

FIG. 34 is a front view illustrating an electronic device, according to an embodiment of the present disclosure, in which an antenna is disposed on a display.

As shown in FIG. 34A, an antenna 3420 may be disposed on a display panel 3410. The antenna 3420 may be disposed along an outer edge of the display panel 3410. The antenna 3420 may include a transparent conductive material. For example, the antenna 3420 may include Indium tin oxide (ITO), indium zinc oxide (IZO), silver (Ag) nanowire, metal mesh, carbon nano tube, or graphene. The antenna 3420 may include an opaque conductive material. For example, the antenna 3420 may include various metals such as Cu, Mo, Ti or Al. The antenna 3420 may be disposed at a bezel, which is an inactive area of the display panel 3410.

As shown in FIG. 34B, the antenna may include a first antenna 3421 and a second antenna 3422. The first antenna 3421 and the second antenna 3422 may be disposed in a lattice form on the display panel 3410. The first antenna 3421 and the second antenna 3422 may be disposed in a matrix form. The first antenna 3421 and the second antenna 3422 may be disposed at an active area of the display panel 3410. The first antenna 3421 and the second antenna 3422 may be disposed not to overlap with a gate wiring and a data wiring of the display panel 3410. The first antenna 3421 and the second antenna 3422 may be disposed so as not to overlap with a touch electrode pattern of the touchscreen panel. The first antenna 3421 and the second antenna 3422 may include a transparent conductive material. For example, the first antenna 3421 and the second antenna 3422 may include ITO, IZO, silver (Ag) nanowire, metal mesh, carbon nano tube, or graphene.

As shown in FIG. 34C, the antenna may include a third antenna 3423 and a fourth antenna 3424. The third antenna 3423 and the fourth antenna 3424 may be disposed in a lattice form on the display panel 3410. The third antenna 3423 and the fourth antenna 3424 may be disposed in a matrix form. The third antenna 3423 and the fourth antenna 3424 may be disposed at a partial area of the display panel 3410. The third antenna 3423 and the fourth antenna 3424 may include a transparent conductive material. For example, the third antenna 3423 and the fourth antenna 3424 may include ITO, IZO, silver (Ag) nanowire, metal mesh, carbon nano tube, or graphene.

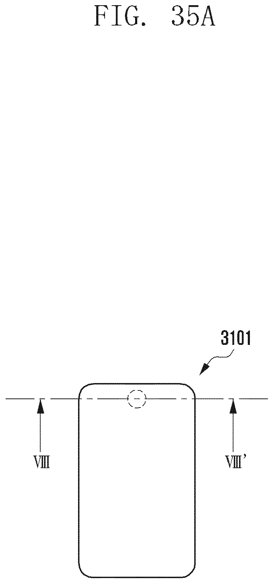

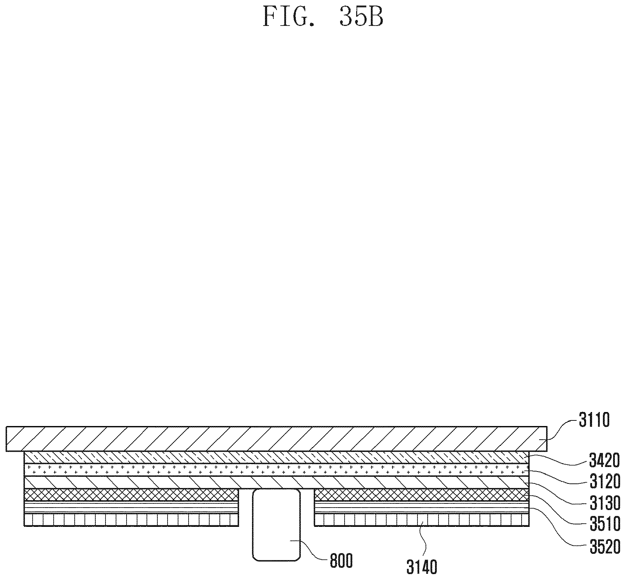

FIG. 35A is a front view illustrating an electronic device, according to an embodiment of the present disclosure. FIG. 35B is a cross-sectional view illustrating the electronic device taken along line VIII-VIII' of FIG. 35A.

As shown in FIGs. 35A and 35B, the electronic device 3101 may include the transparent layer 3110, the antenna 3420, the touchscreen panel 3120, the display panel 3130, a first protection layer 3510, a second protection layer 3520, the pressure sensor 3140, and the camera device 800. The antenna 3420 may be disposed between the transparent layer 3110 and the touchscreen panel 3120. The first protection layer 3510 may be disposed between the display panel 3130 and the pressure sensor 3140. The second protection layer 3520 may be disposed between the first protection layer 3510 and the pressure sensor 3140.

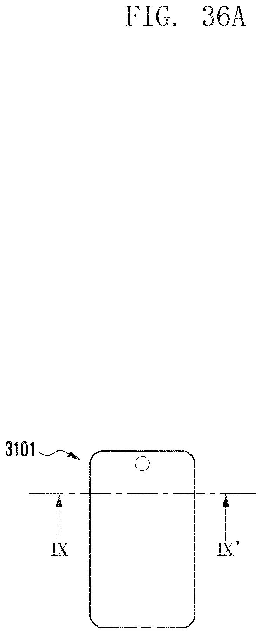

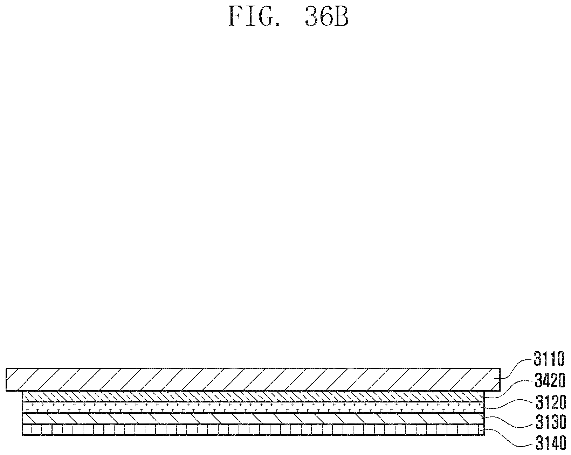

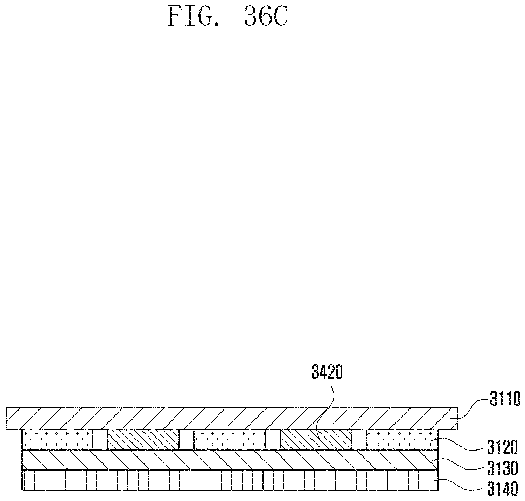

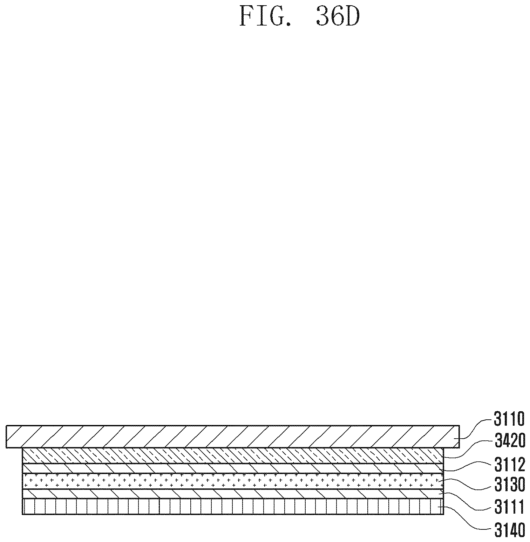

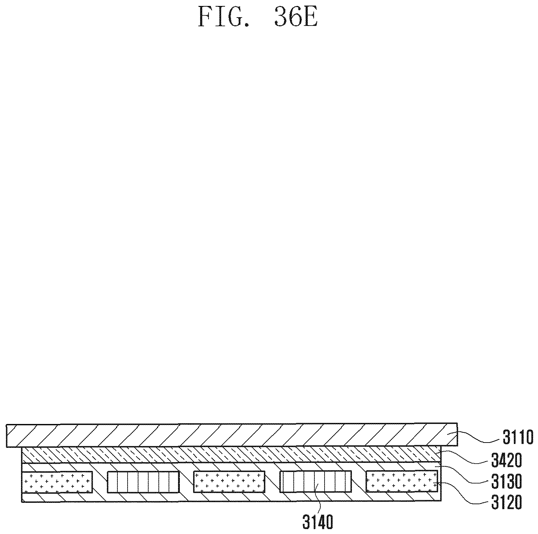

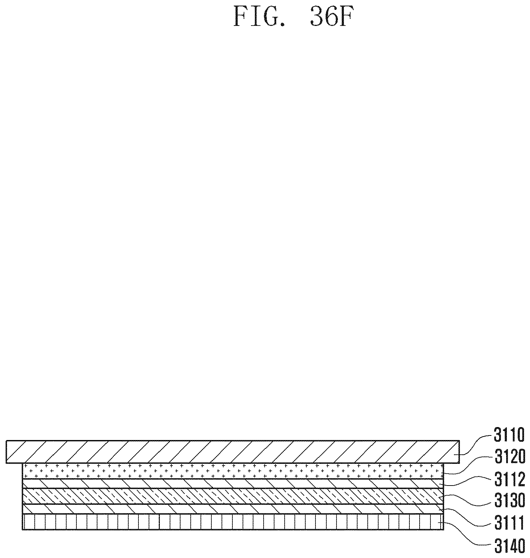

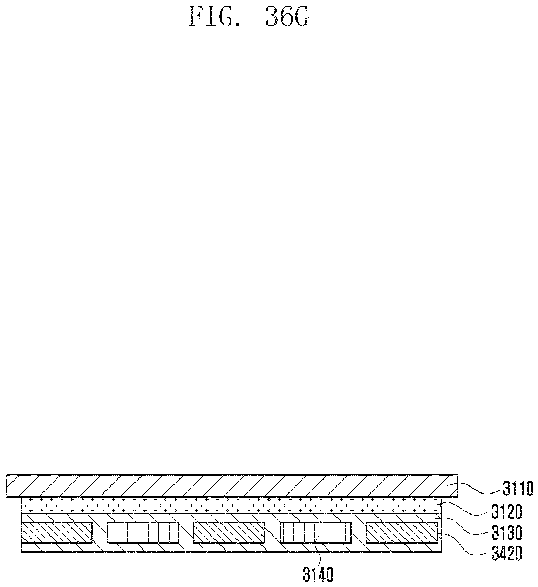

FIG. 36A is a front view illustrating an electronic device, according to an embodiment of the present disclosure. FIGs. 36B to 36G are cross-sectional views illustrating the electronic device taken along line IX-IX' of FIG. 36.

As shown in FIG. 36B, the antenna 3420 may be disposed between the transparent layer 3110 and the touchscreen panel 3120. As shown in FIG. 36C, the antenna 3420 may be disposed at the same layer as that of the touchscreen panel 3120. For example, configurations of the antenna 3420 and the touchscreen panel 3120 may be formed on the display panel 3130. That is, the antenna 3420 and the touchscreen panel 3120 may be integrally formed on the display panel 3130. Configurations of the antenna 3420 and the touchscreen panel 3120 may be alternately disposed.

As shown in FIG. 36D, the touchscreen panel may be formed within the display panel 3130. That is, configurations of the touchscreen panel may be housed within the display panel 3130. At a lower portion of the transparent layer 3110, the antenna 3420 may be disposed. The transparent layer 3110 and the integral display panel 3130 of the touchscreen panel may be bonded by the second adhesive layer 3112. At a lower portion of such a display panel 3130, the pressure sensor 3140 may be disposed. The display panel 3130 and the pressure sensor 3140 may be bonded by the first adhesive layer 3111.

As shown in FIG. 36E, the pressure sensor 3140 and the touchscreen panel 3120 may be disposed within the display panel 3130. That is, configurations of the pressure sensor 3140 and the touchscreen panel 3120 may be housed within the display panel 3130, thereby reducing a thickness of the electronic device 3101.

As shown in FIG. 36F, the touchscreen panel 3120 may be integrally formed on the transparent layer 3110. That is, configurations of the touchscreen panel 3120 may be formed on the transparent layer 3110. At a lower portion of the transparent layer 3110 in which the touchscreen panel 3120 is integrally formed, the display panel 3130 may be disposed. The antenna may be formed within the display panel 3130. That is, configurations of the antenna may be housed within the display panel 3130. The transparent layer 3110 and the antenna integral display panel 3130 may be bonded by the second adhesive layer 3112. At a lower portion of such a display panel 3130, the pressure sensor 3140 may be disposed. The display panel 3130 and the pressure sensor 3140 may be bonded by the first adhesive layer 3111.

As shown in FIG. 36G, the touchscreen 3120 may be integrally formed on the transparent layer 3110. That is, configurations of the touchscreen panel 3120 may be formed on the transparent layer 3110. At a lower portion of the transparent layer 3110 in which the touchscreen panel 3120 is integrally formed, the display panel 3130 may be disposed. The pressure sensor 3140 and the antenna 3420 may be disposed within the display panel 3130. That is, configurations of the pressure sensor 3140 and the antenna 3420 may be housed within the display panel 3130. Thereby, a thickness of the electronic device 3101 may be reduced.

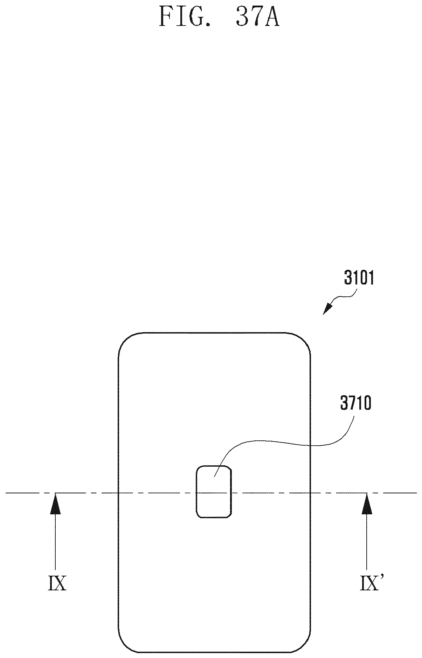

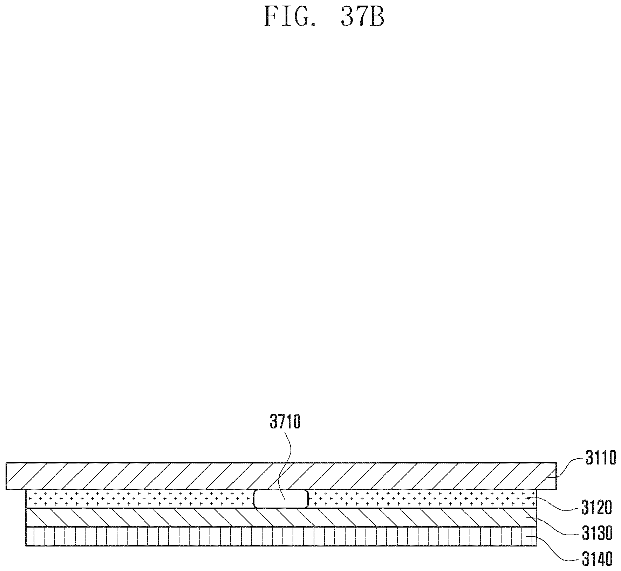

FIG. 37A is a front view illustrating an electronic device, according to an embodiment of the present disclosure. FIGs. 37B to 37I are cross-sectional views illustrating the electronic device taken along line IX-IX' of FIG. 37A.

As shown in FIGs. 37A and 37B, the electronic device 3101 may further include a fingerprint sensor 3710. The fingerprint sensor 3710 may be disposed at a central area of the display panel 3130. The fingerprint sensor 3710 may be transparently provided not to be viewed from the outside. The fingerprint sensor 3710 may be disposed at a lower portion of the transparent layer 3110, and the fingerprint sensor 3710 may be disposed within the touchscreen panel 3120.

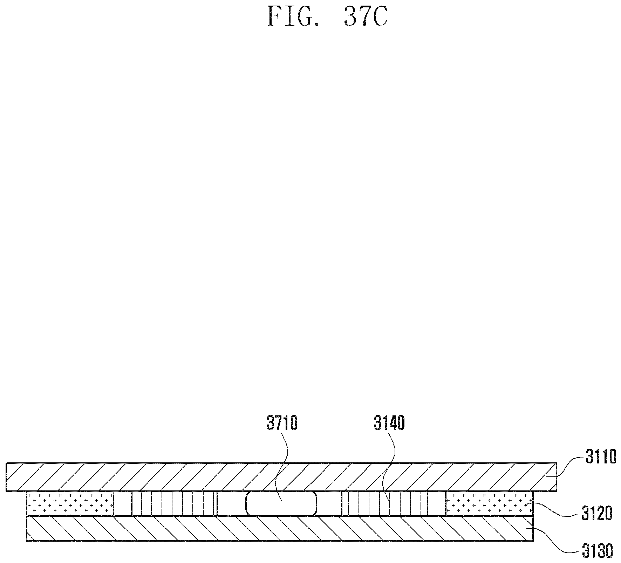

As shown in FIG. 37C, the fingerprint sensor 3710, the pressure sensor 3140, and the touchscreen panel 3120 may be disposed at the same layer. For example, configurations of the fingerprint sensor 3710, the pressure sensor 3140, and the touchscreen panel 3120 may be formed on the display panel 3130. That is, the fingerprint sensor 3710, the pressure sensor 3140, and the touchscreen panel 3120 may be integrally formed on the display panel 3130, or configurations of the pressure sensor 3140 and the touchscreen panel 3120 may be alternately disposed.

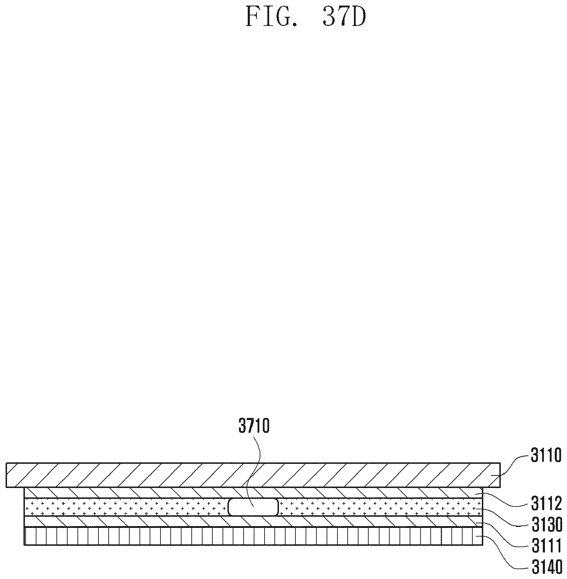

As shown in FIG. 37D, the touchscreen panel may be formed within the display panel 3130. That is, configurations of the touchscreen panel may be housed within the display panel 3130. The fingerprint sensor 3710 may be disposed within the integral display panel 3130 of the touchscreen panel, and the fingerprint sensor 3710 may be housed within the integral display panel 3130 of the touchscreen panel.

The transparent layer 3110 and the integral display panel 3130 of the touchscreen panel may be bonded by the second adhesive layer 3112. At a lower portion of such a display panel 3130, the pressure sensor 3140 may be disposed, and the display panel 3130 and the pressure sensor 3140 may be bonded by the first adhesive layer 3111.

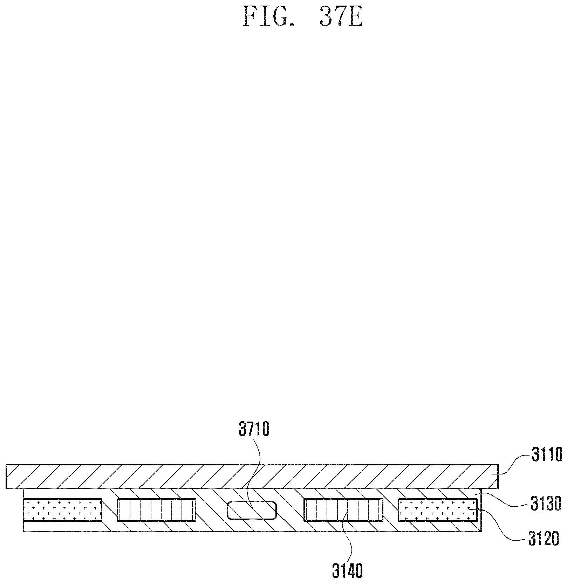

As shown in FIG. 37E, the fingerprint sensor 3710, the pressure sensor 3140, and the touchscreen panel 3120 may be disposed within the display panel 3130. That is, configurations of the fingerprint sensor 3710, the pressure sensor 3140, and the touchscreen panel 3120 may be housed within the display panel 3130, thereby reducing a thickness of the electronic device 3101.

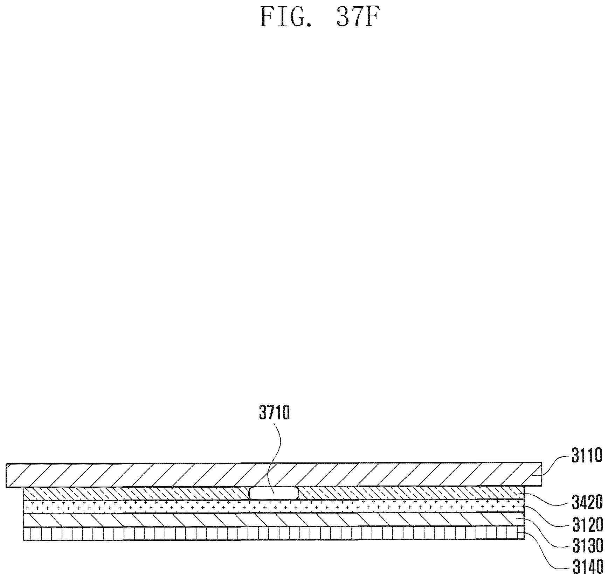

As shown in FIG. 37F, the fingerprint sensor 3710 may be disposed within the antenna 3420. That is, configurations of the fingerprint sensor 3710 may be housed within the antenna 3420, and at a lower portion of the antenna 3420, the touchscreen panel 3120, the display panel 3130, and the pressure sensor 3140 may be disposed.

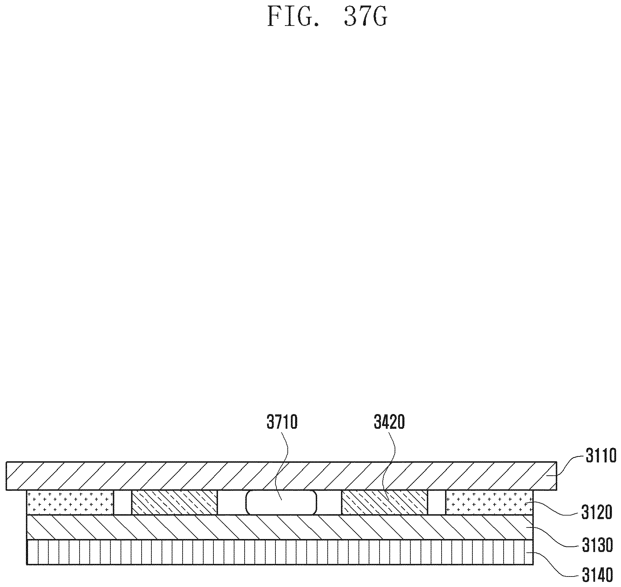

As shown in FIG. 37G, the fingerprint sensor 3710 and the antenna 3420 may be disposed at the same layer as that of the touchscreen panel 3120. For example, configurations of the fingerprint sensor 3710, the antenna 3420, and the touchscreen panel 3120 may be formed on the display panel 3130. That is, the fingerprint sensor 3710, the antenna 3420, and the touchscreen panel 3120 may be integrally formed on the display panel 3130, or configurations of the antenna 3420 and the touchscreen panel 3120 may be alternately disposed.

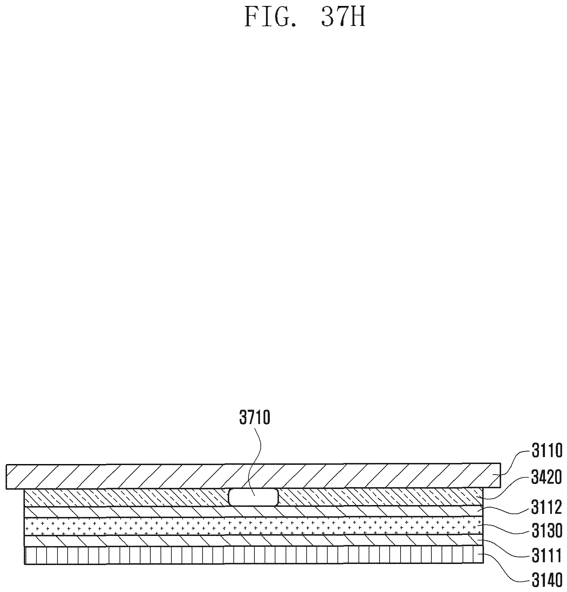

As shown in FIG. 37H, the fingerprint sensor 3710 may be disposed within the antenna 3420. That is, configurations of the fingerprint sensor 3710 may be housed within the antenna 3420. The touchscreen panel may be formed within or housed in the display panel 3130. The transparent layer 3110 and the integral display panel 3130 of the touchscreen panel may be bonded by the second adhesive layer 3112. At a lower portion of such a display panel 3130, the pressure sensor 3140 may be disposed. The display panel 3130 and the pressure sensor 3140 may be bonded by the first adhesive layer 3111.

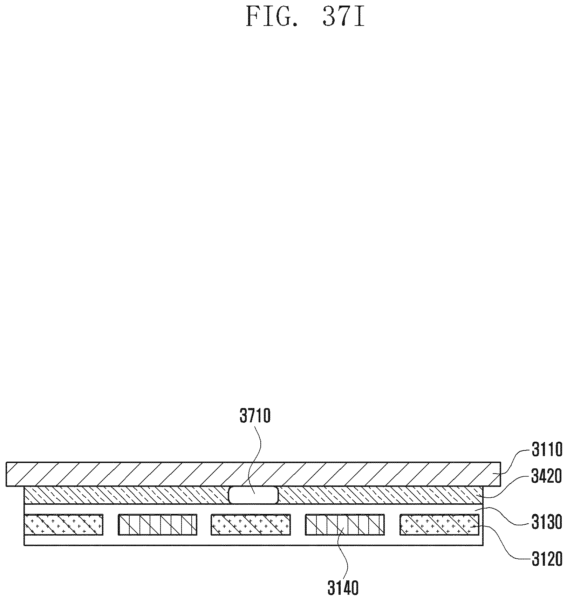

As shown in FIG. 37I, the fingerprint sensor 3710 may be disposed within the antenna 3420. That is, configurations of the fingerprint sensor 3710 may be housed within the antenna 3420, and the pressure sensor 3140 and the touchscreen panel 3120 may be disposed within the display panel 3130. That is, configurations of the pressure sensor 3140 and the touchscreen 3120 may be housed within the display panel 3130.

Although not shown in the drawing, the fingerprint sensor 3710 may be disposed at a lower portion of the display panel 3130. When the fingerprint sensor 3710 is disposed at a lower portion of the display panel 3130, the fingerprint sensor 3710 may be opaquely provided.

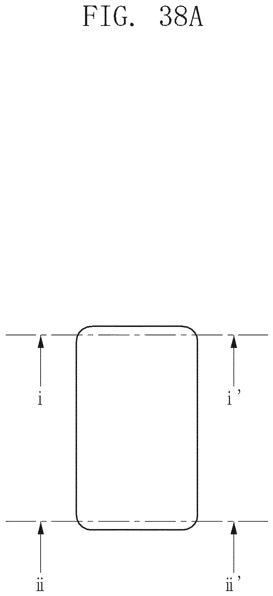

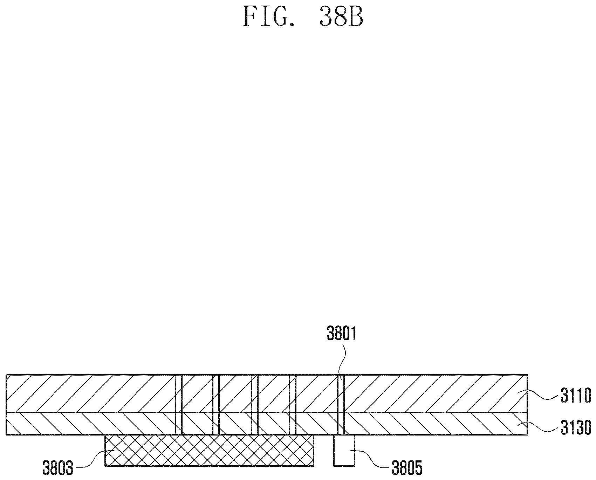

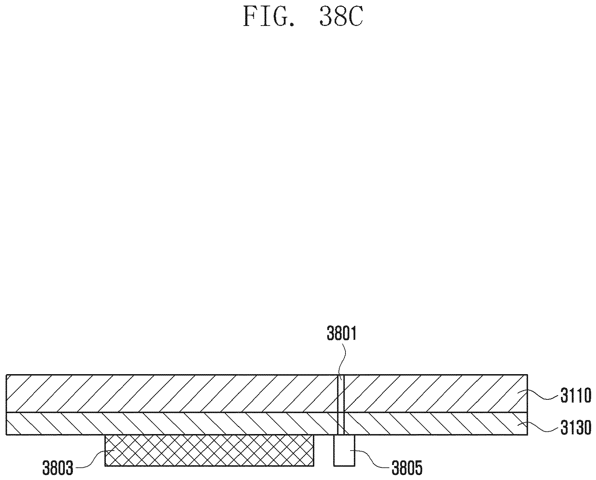

FIG. 38A is a front view illustrating an electronic device, according to an embodiment of the present disclosure. FIG. 38B is a cross-sectional view illustrating the electronic device taken along line i-i' of FIG. 38A. FIG. 38C is a cross-sectional view illustrating the electronic device taken along line ii - ii ' of FIG. 38A.

As shown in FIGs. 38A and 38B, in an inactive area of the display panel 3130, a receiver 3803 and a microphone 3805 may be disposed. Although not shown in FIG. 38, at a position in which the receiver 3803 is disposed, a speaker may be disposed. The receiver 3803 and the microphone 3805 may be disposed at a lower portion of the transparent layer 3110 and the display panel 3130. The transparent layer 3110 and the display panel 3130 may include at least one hole 3801, which may be formed at a position corresponding to the receiver 3803 and the microphone 3805 in the transparent layer 3110 and the display panel 3130. The hole 3801 may be a microhole having a diameter of 1/10 mm or less.

As shown in FIGs. 38B and 38C, the receiver 3803 may include a piezoelectric material. The hole 3801 may be provided at a position corresponding to the microphone 3805 in the transparent layer 3110 and the display panel 3130. That is, the hole 3801 may not be provided at a position corresponding to the receiver 3803 in the transparent layer 3110 and the display panel 3130.

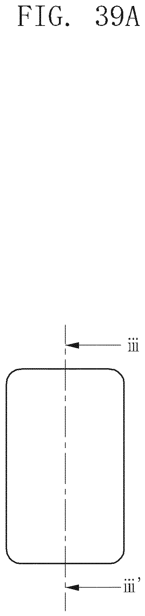

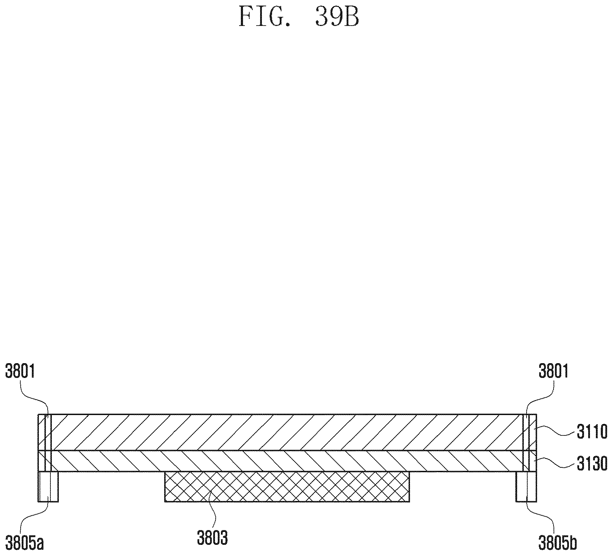

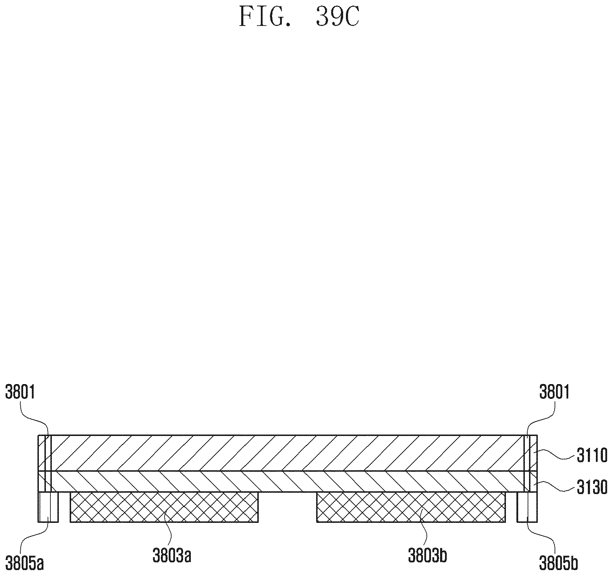

FIG. 39A is a front view illustrating an electronic device, according to an embodiment of the present disclosure. FIGs. 39B and 39C are cross-sectional views illustrating the electronic device taken along line iii-iii' of FIG. 39A.

As shown in FIGs. 39A and 39B, in an inactive area of the display panel 3130, a first microphone 3805a and a second microphone 3805b may be disposed. In an active area of the display panel 3130, the receiver 3803 may be disposed, and the receiver 3803 may include a piezoelectric material. The hole 3801 may be provided at a position corresponding to the first microphone 3805a and the second microphone 3805b in the transparent layer 3110 and the display panel 3130. The hole 3801 may not be provided at a position corresponding to the receiver 3803 in the transparent layer 3110 and the display panel 3130. The receiver 3803 includes a piezoelectric material, thereby vibrating the display panel 3130, and thus a separate hole may not be provided.

As shown in FIG. 39C, in an inactive area of the display panel 3130, the first microphone 3805a and the second microphone 3805b may be disposed, and in an active area of the display panel 3130, a first receiver 3803a and a second receiver 3803b may be disposed. The first receiver 3803a and the second receiver 3803b may include a piezoelectric material. The hole 3801 may be provided at a position corresponding to the first microphone 3805a and the second microphone 3805b in the transparent layer 3110 and the display panel 3130. That is, the hole 3801 may not be provided at a position corresponding to the first receiver 3803a and the second receiver 3803b in the transparent layer 3110 and the display panel 3130.

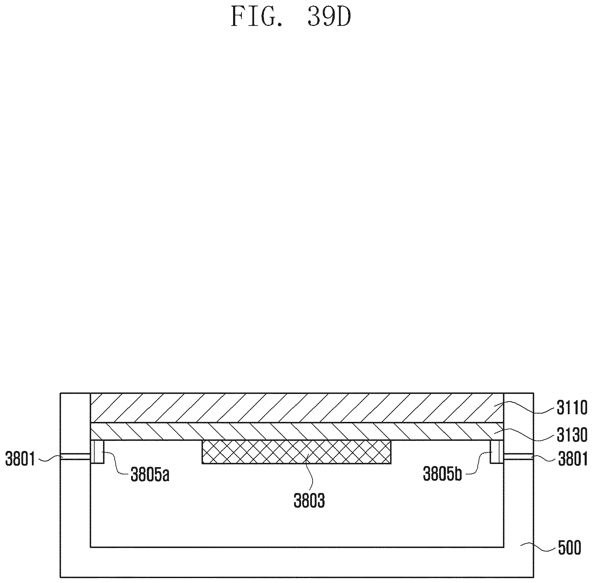

As shown in FIG. 39D, in an inactive area of the display panel 3130, the first microphone 3805a and the second microphone 3805b may be disposed, and in an active area of the display panel 3130, the receiver 3803 may be disposed. The receiver 3803 may include a piezoelectric material. The hole 3801 may be provided in the housing 500. The hole 3801 may be provided at a position corresponding to the first microphone 3805a and the second microphone 3805b in the housing 500.

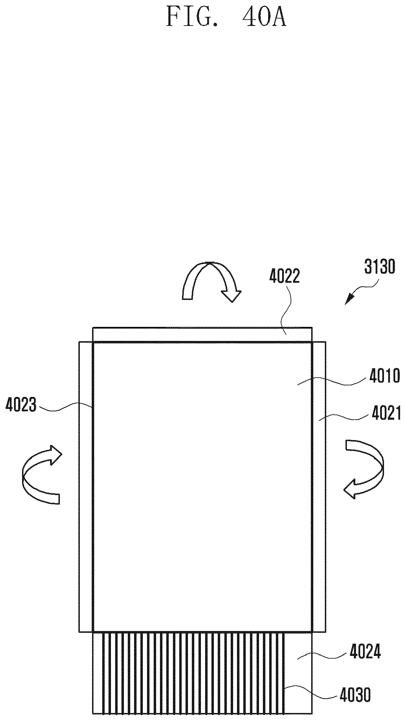

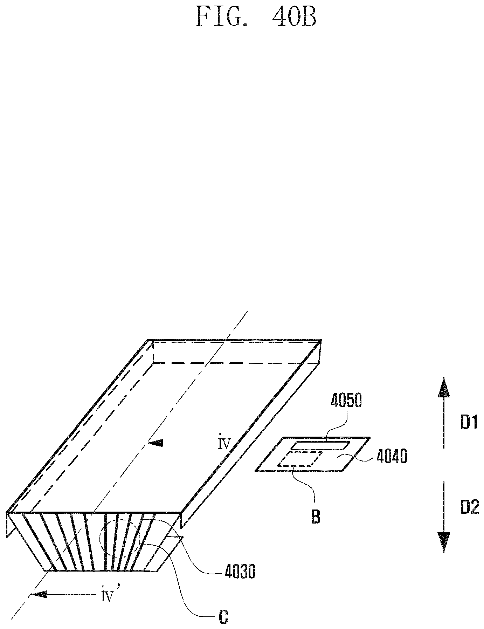

FIG. 40A is a front view illustrating an electronic device, according to an embodiment of the present disclosure. FIG. 40B is a perspective view illustrating an electronic device, according to an embodiment of the present disclosure.

As shown in FIG. 40A, the display panel 3130 may include an active area 4010 including an OLED and inactive areas 4021, 4022, 4023, and 4024 that do not include an OLED. The inactive areas 4021, 4022, 4023, and 4024 may be disposed to enclose the active area 4010, and the inactive areas 4021, 4022, 4023, and 4024 may be disposed at an edge of the active area 4010.

At least a portion of the inactive areas 4021, 4022, 4023, and 4024 may be folded in a second direction D2. The inactive areas 4021, 4022, 4023, and 4024 may be a bezel area in which conductive lines 4030 are disposed.

As shown in FIG. 40B, all the inactive areas 4021, 4022, 4023, and 4024 may be folded in a second direction D2. The conductive lines 4030 disposed at the inactive areas 4021, 4022, 4023, and 4024 may be folded. The conductive lines 4030 may be folded to be electrically coupled to the FPCB 4040 disposed at a lower portion of the display panel 3130.

A driving chip 4050 that may drive the display panel 3130 may be disposed on the FPCB 4040. The driving chip 4050 may be electrically coupled to the FPCB 4040, and the conductive lines 4030 may be electrically coupled to the driving chip 4050.

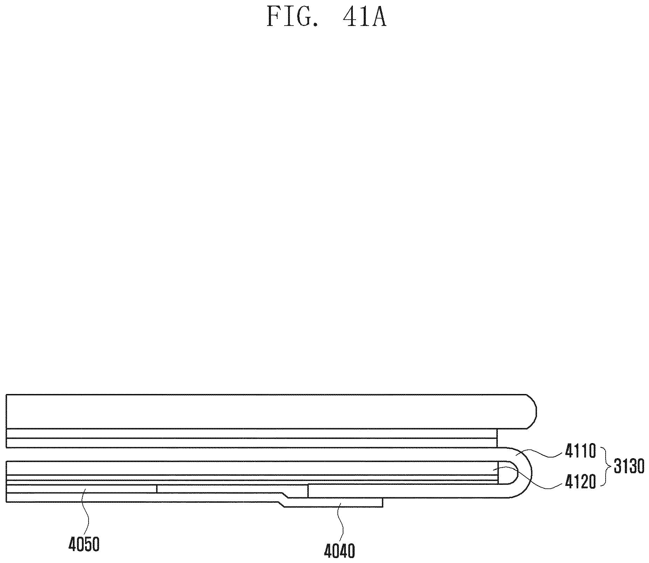

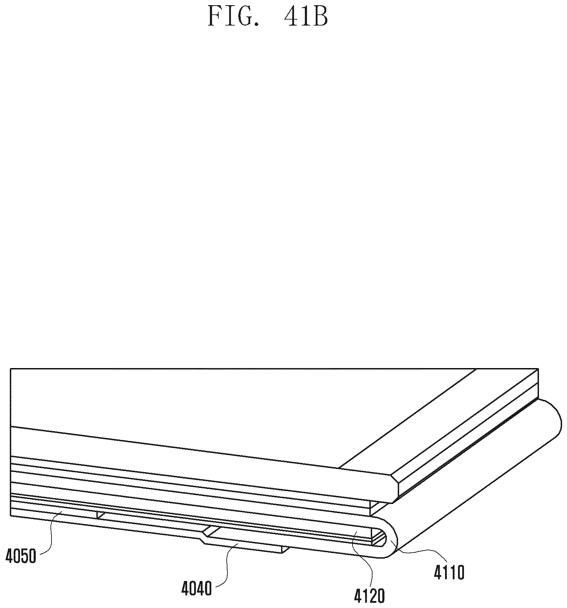

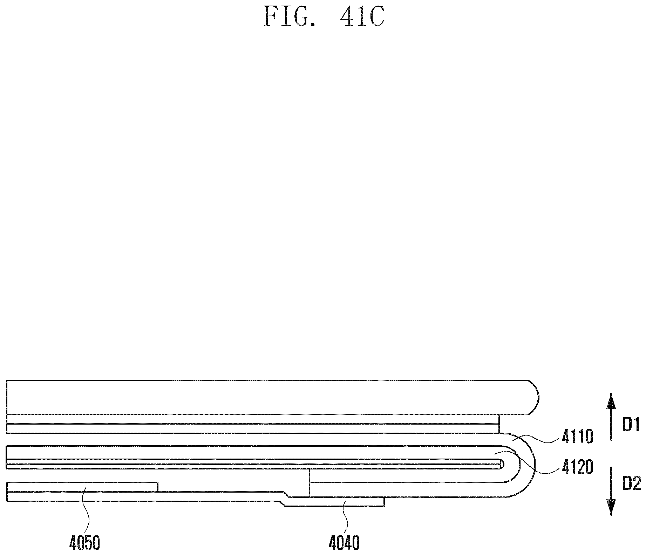

FIG. 41A is a cross-sectional view illustrating an electronic device, according to an embodiment of the present disclosure. FIG. 41B is a perspective view illustrating an electronic device, according to an embodiment of the present disclosure. FIG. 41C is a cross-sectional view illustrating an electronic device, according to an embodiment of the present disclosure.

As shown in FIGs. 41A and 41B, the display panel 3130 may include a first polymer layer 4110 and a second polymer layer 4120. At a lower portion of the display panel 3130, the FPCB 4040 mounts to the driving chip 4050 that may drive the display panel 3130 may be disposed. The first polymer layer 4110 may include, for example an encapsulation layer for blocking moisture and air entered into the display panel 3130. The encapsulation layer may be formed in one layer or may be formed in a form in which an organic material and an inorganic material are repeatedly layered. The first polymer layer 4110 may be, for example a color filter substrate (or color filter glass). The first polymer layer 4110 may include a black matrix and a color filter. The first polymer layer 4110 may provide internal light transferred through liquid crystal with a predetermined color. Such a first polymer layer 4110 may be formed with a plurality of RGB pixels for exhibiting internal light with a predetermined color. The first polymer layer 4110 may be folded to contact with the FPCB 4040. Wirings disposed at the first polymer layer 4110 may be folded to be electrically coupled to the driving chip 4050.

The second polymer layer 4120 may be, for example, a TFT substrate (or TFT glass). In the second polymer layer 4120, a TFT, a pixel electrode connected to the TFT, and a common electrode may be formed. The second polymer layer 4120 may be formed such that a plurality of polymer layers are layered. For example, the second polymer layer 4120 may be formed in a double layer of a polymer layer and polyethylene terephthalate.

Liquid crystal may be interposed between the first polymer layer 4110 and the second polymer layer 4120. The display panel 3130 may be determined according to a kind of liquid crystal. In order to change light transmittance of internal light transmitted from a light guide plate, the second polymer layer 4120 may change an arrangement of liquid crystal. The second polymer layer 4120 may transfer the internal light in a desired shape through liquid crystal.

As shown in FIG. 41C, the first polymer layer 4110 and/or the second polymer layer 4120 may be folded in a second direction D2. The first polymer layer 4110 and/or the second polymer layer 4120 may be folded to contact the FPCB 4040. Wirings disposed at the first polymer layer 4110 and/or the second polymer layer 4120 may be folded to be electrically coupled to the driving chip 4050. For example, wirings disposed at the first polymer layer 4110 and/or the second polymer layer 4120 may be formed with at least one of titanium (Ti), copper (Cu), aluminum (Al), molybdenum (Mo), or graphene. When the second polymer layer 4120 is formed in a form in which a plurality of polymer layers are layered, the second polymer layer 4120 may be formed such that at least a portion is removed in an area in which at least a partial layer is folded.

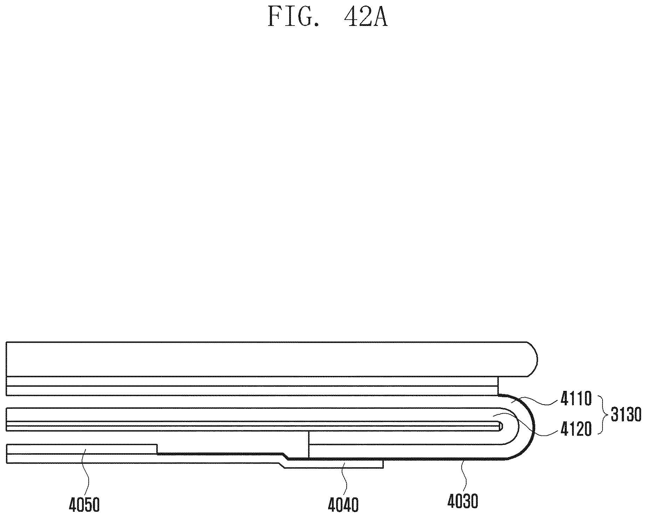

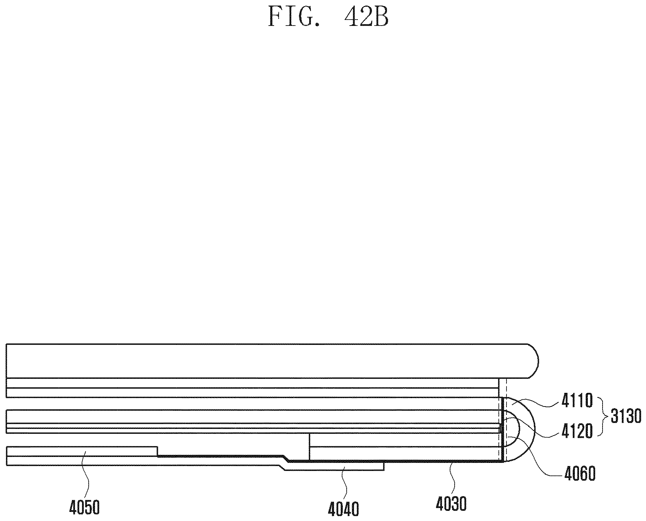

FIGs. 42A and 42B are cross-sectional views of an electronic device according to an embodiment of the present disclosure.

As shown in FIG. 42A, the first polymer layer 4110 and/or the second polymer layer 4120 may be folded in a second direction D2. The conductive line 4030 electrically coupled to the display panel 3130 may be together folded along with the folded first polymer layer 4110 and/or second polymer layer 4120, and the conductive line 4030 may be folded to be electrically coupled to the driving chip 4050.

As shown in FIG. 42B, the first polymer layer 4110 and/or the second polymer layer 4120 may be folded in a second direction D2. The conductive line 4030 electrically coupled to the display panel 3130 may be taken out through an area 4060 removed from the folded first polymer layer 4110 and/or second polymer layer 4120. That is, the first polymer layer 4110 and/or the second polymer layer 4120 may include an area 4060, at least a portion of which formed by removing some of the folded layers, and the area 4060 may be a hole. The conductive line 4030 may be taken out along the removed area 4060 to be electrically coupled to the driving chip 4050.

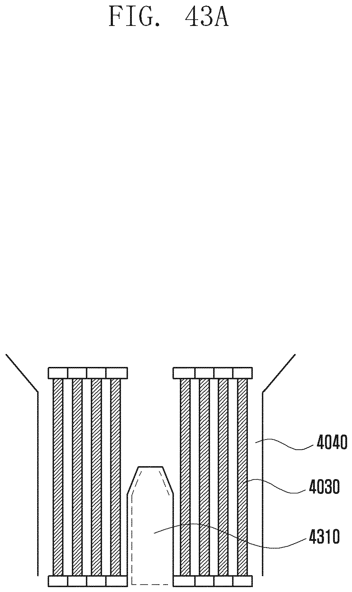

FIGs. 43A to 43C are enlarged views of a portion B of FIG. 40B.

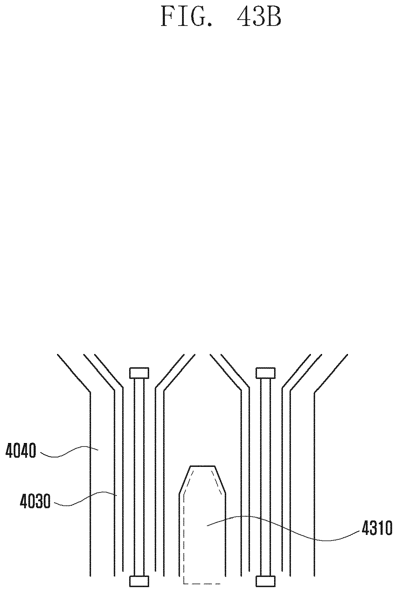

As shown in FIGs. 43A and 43B, the conductive lines 4030 may be taken out from the display panel 3130 and are disposed on the FPCB 4040. The conductive lines 4030 may be disposed to detour or bypass various interfaces 4310. That is, the conductive lines 4030 may be disposed so as not to overlap with various interfaces 4310.

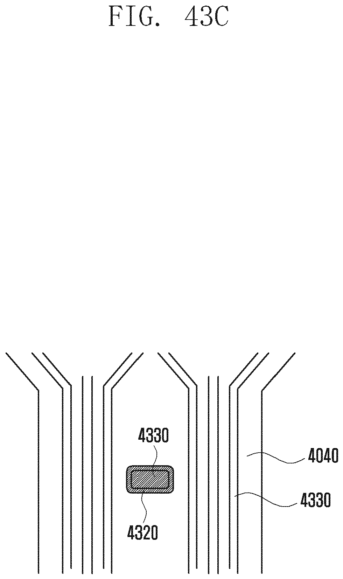

As shown in FIG. 43C, the conductive lines 4030 may be taken out from the display panel 3130 to be disposed on the FPCB 4040. The FPCB 4040 may include a shielding portion 4320 and an opening portion 4330. Various interfaces may be disposed within the opening portion 4330. The shielding portion 4320 may prevent interfaces and the conductive lines 4030 disposed within the opening portion 4330 from contacting. That is, the shielding portion 4320 may prevent electric interference between the interfaces and the conductive lines 4030.

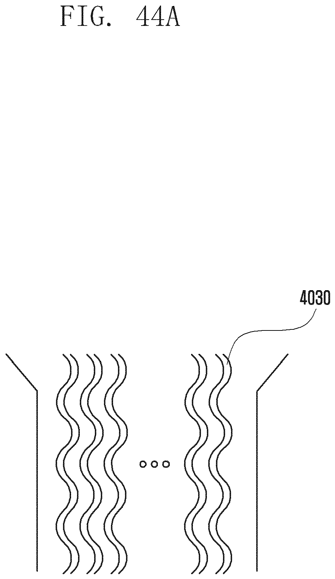

FIGs. 44A to 44D are enlarged views of a portion C of FIG. 40B.

As shown in FIGs. 40A and 40B and FIGs. 44A to 44D, the inactive areas 4021, 4022, 4023, and 4024 of the display panel 3130 are folded, and the conductive lines 4030 disposed at the inactive areas 4021, 4022, 4023, and 4024 may have various shapes. For example, as shown in FIG. 44A, the conductive lines 4030 may include a curve shape.

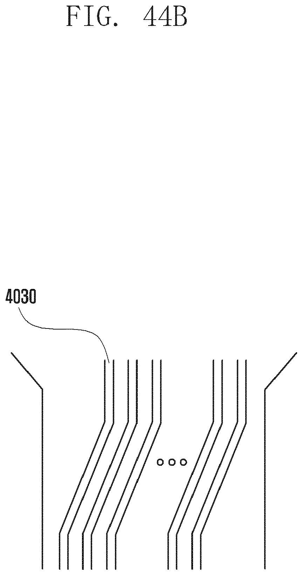

As shown in FIG. 44B, the conductive lines 4030 may be formed in a straight line shape and include a portion taken out in different directions.

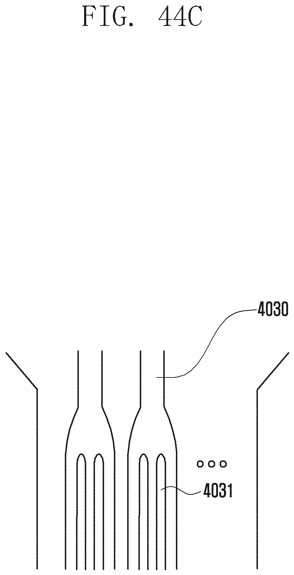

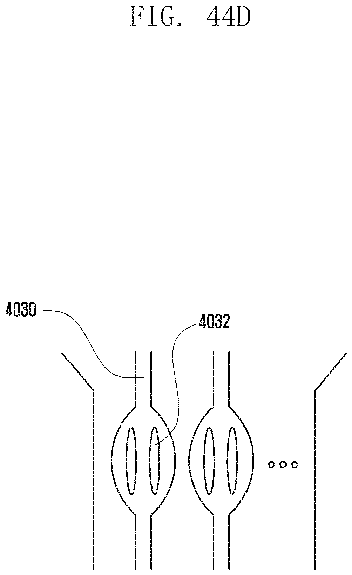

As shown in FIGs. 44C and 44D, the conductive lines 4030 may include opening portions 4031 and 4032 therein, thereby preventing a crack from occurring within the conductive line 4030 when the display panel 3130 is in a folded portion. Therefore, an electric short circuit can be prevented from occurring within the conductive line 4030.

While the present disclosure has been shown and described with reference to certain embodiments thereof, it will be understood by those skilled in the art that various changes in form and details may be made therein without departing from the scope of the present disclosure. Therefore, the scope of the present disclosure should not be defined as being limited to the embodiments, but should be defined by the appended claims.

## Claims

1. An electronic device (401) comprising:
a housing (500) including an upper surface and a lower surface,
a transparent layer (600) disposed at the upper surface;
a display (700) exposed through the transparent layer, the display comprising:
a touchscreen panel (720) coupled to the transparent layer (600) and configured to sense a user touch position occurring at the transparent layer; and
a display panel (709) disposed under the touchscreen panel and comprising an array (724) of thin film transistors, TFTs, interposed between an upper organic light emitting layer (726) and a lower polymer layer (722);
the electronic device further comprising:
a flexible printed circuit board (4040), FPCB, bonded to a lower surface of the polymer layer via a first adhesive layer (710) and electrically coupled to a plurality of conductive lines (740) disposed in the display panel;
a driving chip (4050) disposed on the flexible printed circuit board, electrically coupled to the plurality of conductive lines and configured to provide image data to the display;
a camera device (800) positioned at least partially within an opening (810) formed at least through the FPCB and the first adhesive layer in an active area of the display including pixels configured to display image information;
wherein the array (724) of thin film transistors is devoid of thin film transistors at the opening and, optionally, a periphery of the opening (810),
the organic light emitting layer is devoid of an organic light emitting material at the opening and, optionally, a periphery of the opening;
the plurality of conductive lines extend around a periphery of the opening so as to not optically block the opening, and
the camera device includes an image sensor disposed through at least a portion of the opening.

2. The electronic device of claim 1, wherein the opening further extends through the display panel and at least a portion of the touchscreen panel.

3. The electronic device of claim 2, wherein the opening further extends through a second adhesive layer interposed between the transparent layer and the touchscreen panel.

4. The electronic device of claim 2, further comprising:
a second adhesive layer interposed between the transparent layer and the touchscreen panel; and
a polarization layer between the second adhesive layer and the touchscreen panel,
wherein the opening further extends through the polarization layer.

5. The electronic device of claim 2, further comprising:
a second adhesive layer interposed between the transparent layer and the touchscreen panel; and
a polarization layer between the second adhesive layer and the touchscreen panel,
wherein the opening extends through the touchscreen panel, but not through the polarization layer.

6. The electronic device of any of claims 3 -5, wherein the first adhesive layer is at least partially opaque, and wherein the second adhesive layer is substantially transparent.

7. The electronic device of any of claims 1-6, wherein the touchscreen panel comprises a flexible layer comprising a bent portion curved along a side of the first surface, and wherein the opening overlaps at least partially with the bent portion.

8. The electronic device of any of claims 1-7, wherein the transparent layer comprises:
a first surface;
a second surface; and
a groove formed in the first surface of the transparent layer and a groove formed in the second surface of the transparent layer.

9. The electronic device of any of claims 1-8, wherein the opening is opened toward an edge of the first adhesive layer.

## Patentansprüche

1. Elektronisches Gerät (401), das Folgendes umfasst:
ein Gehäuse (500) mit einer oberen Fläche und einer unteren Fläche;
eine transparente Schicht (600), die an der oberen Fläche angeordnet ist; und
eine Anzeige (700), die durch die transparente Schicht frei liegt, wobei die Anzeige Folgendes umfasst:
eine Berührungsbildschirmtafel (720), die mit der transparenten Schicht (600) gekoppelt ist und dazu konfiguriert ist, eine an der transparenten Schicht auftretende Benutzerberührungsposition zu erfassen; und
eine Anzeigetafel (709), die unter der Berührungsbildschirmtafel angeordnet ist und eine Anordnung (724) von Dünnfilmtransistoren (TFTs, Thin Film Transistors), die zwischen einer oberen organischen lichtemittierenden Schicht (726) und einer unteren Polymerschicht (722) angeordnet ist, umfasst;
wobei das elektronische Gerät weiterhin Folgendes umfasst:
eine flexible Leiterplatte (FPCB, Flexible Printed Circuit Board) (4040), die über eine erste Haftschicht (710) mit einer unteren Fläche der Polymerschicht verklebt ist und mit einer Vielzahl von in der Anzeigetafel angeordneten leitfähigen Leitungen (740) gekoppelt ist;
einen Treiberchip (4050), der auf der flexiblen Leiterplatte angeordnet ist, mit der Vielzahl von leitfähigen Leitungen gekoppelt ist und dazu konfiguriert ist, Bilddaten an die Anzeige zur Verfügung zu stellen;
eine Kameravorrichtung (800), die wenigstens zum Teil in einer Öffnung angeordnet ist, die wenigstens durch die flexible Leiterplatte und die erste Haftschicht in einem aktiven Bereich der Anzeige, der Pixel aufweist, die zum Anzeigen von Bildinformationen konfiguriert sind, ausgebildet ist;
wobei die Anordnung (724) von Dünnfilmtransistoren an der Öffnung und gegebenenfalls einem Umfang der Öffnung (810) frei von Dünnfilmtransistoren ist,
wobei die organische lichtemittierende Schicht an der Öffnung und gegebenenfalls einem Umfang der Öffnung frei von organischem lichtemittierendem Material ist,
wobei die Vielzahl von leitfähigen Leitungen sich derart um den Umfang der Öffnung erstreckt, dass sie die Öffnung nicht optisch blockieren, und
wobei die Kameravorrichtung einen durch wenigstens einen Abschnitt der Öffnung angeordneten Bildsensor aufweist.

2. Elektronisches Gerät nach Anspruch 1, wobei die Öffnung sich weiterhin durch die Anzeigetafel und wenigstens einen Abschnitt der Berührungsbildschirmtafel erstreckt.

3. Elektronisches Gerät nach Anspruch 2, wobei die Öffnung sich weiterhin durch eine zweite Haftschicht erstreckt, die zwischen der transparenten Schicht und der Berührungsbildschirmtafel angeordnet ist.

4. Elektronisches Gerät nach Anspruch 2, das weiterhin Folgendes umfasst:
eine zweite Haftschicht, die zwischen der transparenten Schicht und der Berührungsbildschirmtafel angeordnet ist; und
eine Polarisierungsschicht zwischen der zweiten Haftschicht und der Berührungsbildschirmtafel,
wobei die Öffnung sich weiterhin durch die Polarisierungsschicht erstreckt.

5. Elektronisches Gerät nach Anspruch 2, das weiterhin Folgendes umfasst:
eine zweite Haftschicht, die zwischen der transparenten Schicht und der Berührungsbildschirmtafel angeordnet ist; und
eine Polarisierungsschicht zwischen der zweiten Haftschicht und der Berührungsbildschirmtafel,
wobei die Öffnung sich durch die Berührungsbildschirmtafel, aber nicht durch die Polarisierungsschicht erstreckt.

6. Elektronisches Gerät nach einem der Ansprüche 3 bis 5, wobei die erste Haftschicht wenigstens zum Teil blickdicht ist, und wobei die zweite Haftschicht im Wesentlichen transparent ist.

7. Elektronisches Gerät nach einem der Ansprüche 1 bis 6, wobei die Berührungsbildschirmtafel eine flexible Schicht umfasst, die einen gebogenen Abschnitt umfasst, der sich entlang einer Seite der ersten Oberfläche krümmt, und wobei die Öffnung wenigstens zum Teil mit dem gebogenen Abschnitt überlappt.

8. Elektronisches Gerät nach einem der Ansprüche 1 bis 7, wobei die transparente Schicht Folgendes umfasst:
eine erste Oberfläche;
eine zweite Oberfläche; und
eine in der ersten Oberfläche der transparenten Schicht ausgebildete Rille und eine in der zweiten Oberfläche der transparenten Schicht ausgebildete Rille.

9. Elektronisches Gerät nach einem der Ansprüche 1 bis 8, wobei die Öffnung in Richtung einer Kante der ersten Haftschicht geöffnet ist.

## Revendications

1. Appareil électronique (401) comprenant :
un boîtier (500) comportant une surface supérieure et une surface inférieure,
une couche transparente (600) disposée sur la surface supérieure, et
un écran (700) visible à travers la couche transparente, ledit écran comprenant :
une plaque tactile (720) couplée à la couche transparente (600) et conçue pour détecter la position d'un contact effectué par l'utilisateur sur la couche transparente, et
une plaque d'affichage (709) disposée sous la plaque tactile et comprenant une matrice (724) de transistors en couches minces (TFT, thin-film transistor) intercalée entre une couche électroluminescente organique (726) supérieure et une couche polymère (722) inférieure ;
l'appareil électronique comprenant en outre :
une carte imprimée souple (FPCB, flexible printed circuit board) (4040) liée à une surface inférieure de la couche polymère par le biais d'une première couche d'adhésif (710) et couplée électriquement à une pluralité de lignes conductrices (740) disposées dans la plaque d'affichage,
une puce de pilotage (4050) disposée sur la carte imprimée souple, couplée électriquement à la pluralité de lignes conductrices et conçue pour fournir des données d'image à l'écran,
un dispositif caméra (800) disposé au moins partiellement dans une ouverture (810) formée au moins dans la carte imprimée souple et la première couche d'adhésif dans une zone active de l'écran comportant des pixels conçus pour afficher des informations sous forme d'image ; et dans lequel appareil
la matrice (724) de transistors en couches minces est exempte de transistors en couches minces dans l'ouverture et, éventuellement à la périphérie de l'ouverture (810),
la couche électroluminescente organique est exempte de matériau électroluminescent organique dans l'ouverture et, éventuellement à la périphérie de l'ouverture,
la pluralité de lignes conductrices entourent la périphérie de l'ouverture de façon à ne pas bloquer optiquement l'ouverture, et
le dispositif caméra comporte un capteur d'image disposé dans au moins une partie de l'ouverture.

2. Appareil électronique selon la revendication 1, dans lequel l'ouverture traverse en outre la plaque d'affichage et au moins une partie de la plaque tactile.

3. Appareil électronique selon la revendication 2, dans lequel l'ouverture traverse en outre une deuxième couche d'adhésif intercalée entre la couche transparente et la plaque tactile.

4. Appareil électronique selon la revendication 2, comprenant en outre :
une deuxième couche d'adhésif intercalée entre la couche transparente et la plaque tactile, et
une couche de polarisation entre la deuxième couche d'adhésif et la plaque tactile ;
ladite ouverture traversant en outre la couche de polarisation.

5. Appareil électronique selon la revendication 2, comprenant en outre :
une deuxième couche d'adhésif intercalée entre la couche transparente et la plaque tactile, et
une couche de polarisation entre la deuxième couche d'adhésif et la plaque tactile,
ladite ouverture traversant la plaque tactile, mais pas la couche de polarisation.

6. Appareil électronique selon l'une quelconque des revendications 3 à 5, dans lequel la première couche d'adhésif est au moins partiellement opaque, et dans lequel la deuxième couche d'adhésif est sensiblement transparente.

7. Appareil électronique selon l'une quelconque des revendications 1 à 6, dans lequel la plaque tactile comprend une couche souple comprenant une partie cintrée qui est courbée le long d'un bord de la première surface, et dans lequel l'ouverture chevauche au moins partiellement la partie cintrée.

8. Appareil électronique selon l'une quelconque des revendications 1 à 7, dans lequel la couche transparente comprend :
une première surface,
une deuxième surface, et
une rainure formée dans la première surface de la couche transparente et une rainure formée dans la deuxième surface de la couche transparente.

9. Appareil électronique selon l'une quelconque des revendications 1 à 8, dans lequel l'ouverture donne vers un bord de la première couche d'adhésif.
